# EUROPEAN PATENT SPECIFICATION

(11) **EP 3 932 927 B1**
(45) Date of publication and mention of the grant of the patent: **27.09.2023**
(21) Application number: 19916929.3
(22) Date of filing: 19.12.2019
(51) Int. Cl.: C09K 11/06, C07F 15/00, H10K 85/30, H10K 101/10

(54) **METAL COMPLEX AND COMPOSITION INCLUDING SAID METAL COMPLEX**
METALLKOMPLEX UND DIESEN METALLKOMPLEX ENTHALTENDE ZUSAMMENSETZUNG
COMPLEXE MÉTALLIQUE ET COMPOSITION COMPRENANT LEDIT COMPLEXE MÉTALLIQUE

(30) Priority: 28.02.2019 JP 2019035794
(43) Date of publication of application: 05.01.2022
(73) Proprietor: SUMITOMO CHEMICAL COMPANY, LIMITED, Chuo-ku Tokyo 104-8260 (JP)
(72) Inventor: YOSHIOKA, Mayu, Tsukuba-shi, Ibaraki 300-3294 (JP); ASADA, Kohei, Tsukuba-shi, Ibaraki 300-3294 (JP)
(74) Representative: J A Kemp LLP
(86) International application number: PCT/JP2019/049784
(87) International publication number: WO 2020/174838

(56) References cited:
- WO-A1-2013/045402
- WO-A1-2013/045402
- WO-A1-2016/006523
- WO-A1-2016/006523
- JP-A- 2010 074 011
- JP-A- 2010 074 011
- JP-A- 2012 222 268
- JP-A- 2012 222 268

## Description

### Technical Field

The present invention relates to a metal complex, a composition comprising the metal complex, and a light emitting device comprising the metal complex or the composition.

### Background Art

As the light emitting material used for a light emitting layer of a light emitting device, for example, metal complexes exhibiting light emission from the triplet excited state are investigated. As the metal complex, for example, iridium complexes represented by the following formulae are known (Patent Documents 1, 2) .

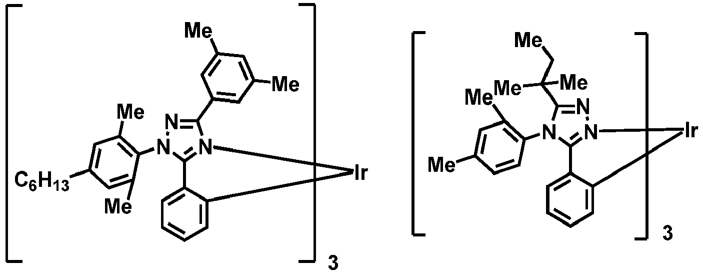

### [Prior Art Document]

### [Patent Document]

[Patent Document 1] International Publication WO2017/170916
[Patent Document 2] International Publication WO2016/006523
[Patent Document 3] Japanese patent application No. JP 2010 074011 A discusses an organic electroluminescent device, display device and a lighting apparatus.
[Patent Document 4] JP 2012 222268 A discusses an organic electroluminescent element material, an organic electroluminescent element, a display device and a lighting device.
[Patent Document 5] WO 2013/045402 A1 discusses phosphorescent light emitting materials, particularly blue-emitting materials involving metallic complexes.

### Summary of the Invention

### Problem to be Solved by the Invention

However, a light emitting device produced using the above-described metal complex is not necessarily sufficient in its external quantum efficiency.

Then, the present invention has an object of providing a metal complex which is useful for production of a light emitting device excellent in external quantum efficiency. Further, the present invention has an object of providing a composition comprising the metal complex, and a light emitting device comprising the metal complex or the composition.

### Means for Solving the Problem

The present invention provides the following [1] to [8].

[1] A metal complex represented by the formula (1-A) : 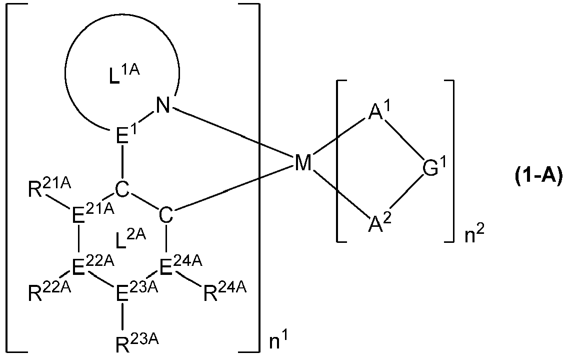 wherein,
   M represents a ruthenium atom, a rhodium atom, a palladium atom, an iridium atom or a platinum atom,
   n¹ represents an integer of 1 or more, and n² represents an integer of 0 or more, n¹+n² is 3 when M is a ruthenium atom, a rhodium atom or an iridium atom, while n¹+n² is 2 when M is a palladium atom or a platinum atom,
   E¹ represents a nitrogen atom or a carbon atom, when a plurality of E¹ are present, they may be the same or different at each occurrence,
   Ring L^{1A} represents a pyridine ring, a diazabenzene ring, an azanaphthalene ring, a diazanaphthalene ring, a triazole ring or a diazole ring, and these rings optionally have a substituent, when a plurality of the substituents are present, they may be combined together to form a ring together with atoms to which they are attached, when a plurality of Ring L^{1A} are present, they may be the same or different,
   E^{21A}, E^{22A}, E^{23A} and E^{24A} each independently represent a nitrogen atom or a carbon atom, at least two of E^{21A}, E^{22A}, E^{23A} and E^{24A} are carbon atoms, when a plurality of E^{21A}, E^{22A}, E^{23A} and E^{24A} are present, they may be the same or different at each occurrence, when E^{21A} is a nitrogen atom, R^{21A} is not present, when E^{22A} is a nitrogen atom, R^{22A} is not present, when E^{23A} is a nitrogen atom, R^{23A} is not present, when E^{24A} is a nitrogen atom, R^{24A} is not present,
   R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or said group represented by the formula (2), and these groups optionally have a substituent, when a plurality of R^{21A}, R^{22A}, R^{23A} and R^{24A} are present, they may be the same or different at each occurrence, R^{21A} and R^{22A}, R^{22A} and R^{23A}, and R^{23A} and R^{24A} each may be combined together to form a ring together with atoms to which they are attached,
   Ring L^{1A} has said group represented by the formula (2) as said substituent, or at least one of R^{21A}, R^{22A}, R^{23A} and R^{24A} is said group represented by the formula (2),
   A¹-G¹-A² represents an anionic bidentate ligand, A¹ and A² each independently represent a carbon atom, an oxygen atom or a nitrogen atom, and these atoms may be ring-constituent atoms, G¹ represents a single bond, or an atomic group constituting a bidentate ligand together with A¹ and A², when a plurality of A¹-G¹-A² are present, they may be the same or different, 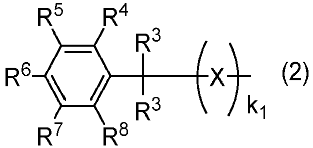 wherein,
      R³ represents an alkyl group or an aryl group, and these groups optionally have a substituent, a plurality of R³ may be the same or different, R³ and R⁴, and R³ and R⁸ each may form a ring together with carbon atoms to which they are attached,
      R⁴, R⁵, R⁶, R⁷ and R⁸ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of R⁴, R⁵, R⁶, R⁷ and R⁸ are present, they may be the same or different at each occurrence, R⁴ and R⁵, R⁵ and R⁶, R⁶ and R⁷, and R⁷ and R⁸ each may be combined together to form a ring together with carbon atoms to which they are attached,
      X represents -C(R⁹)₂-, an arylene group or a divalent hetero ring group, and these groups optionally have a substituent, R⁹ represents an alkyl group or an aryl group, and these groups optionally have a substituent, a plurality of R⁹ may be the same or different, when a plurality of X are present, they may be the same or different,
      k₁ represents an integer of 0 to 3,
      when said metal complex represented by the formula (1-A) has only one type of said group represented by the formula (2), the requirement (i) is satisfied,
         (i) the fact that one of R³ is a phenyl group optionally having a substituent, R⁴ is a hydrogen atom, and the R³ and the R⁴ are combined to form a fluorene ring is not satisfied; and, at least one of R³ is an alkyl group optionally having a substituent.
[2] The metal complex according to [1], wherein said metal complex represented by the formula (1-A) is a metal complex represented by the formula (1-A1), the formula (1-A2), the formula (1-A3), the formula (1-A4), the formula (1-A5), the formula (1-A6), the formula (1-A7), the formula (1-A8), the formula (1-A9) or the formula (1-A10): 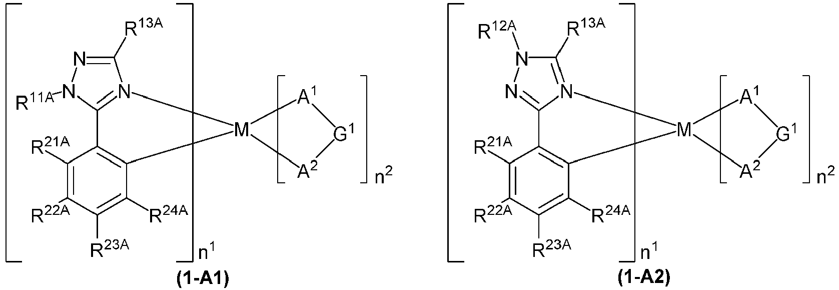 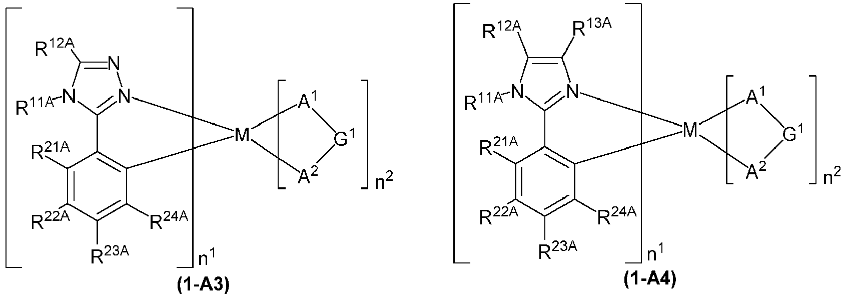 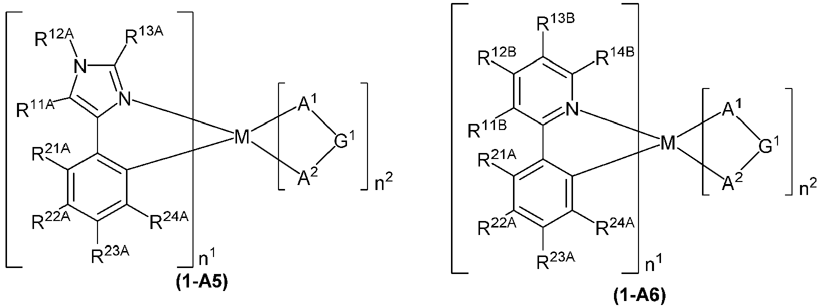 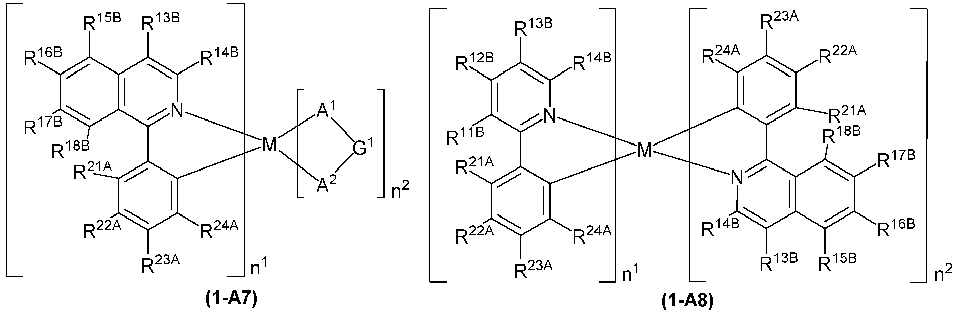 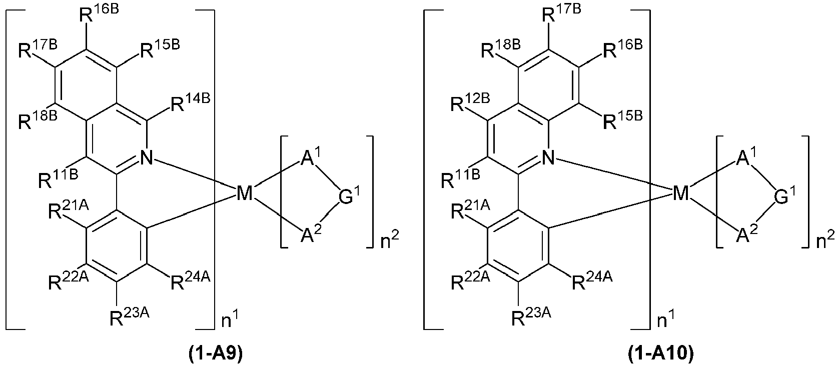 wherein, M, n¹, n², R^{21A}, R^{22A}, R^{23A}, R^{24A} and A¹-G¹-A² represent the same meaning as described above,
   R^{11A}, R^{12A}, R^{13A}, R^{11B}, R^{12B}, R^{13B}, R^{14B}, R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or said group represented by the formula (2), and these groups optionally have a substituent, when a plurality of R^{11A}, R^{12A}, R^{13A}, R^{11B}, R^{12B}, R^{13B}, R^{14B}, R^{15B}, R^{16B}, R^{17B} and R^{18B} are present, they may be the same or different at each occurrence, R^{11A} and R^{12A}, R^{12A} and R^{13A}, R^{11B} and R^{12B}, R^{12B} and R^{13B}, R^{13B} and R^{14B}, R^{13B} and R^{15B}, R^{15B} and R^{16B}, R^{16B} and R^{17B}, R^{17B} and R^{18B}, R^{11B} and R^{18B}, R^{14B} and R^{15B}, and R^{12B} and R^{18B} each may be combined together to form a ring together with atoms to which they are attached,
   the ligand of which number is defined by the suffix n¹ has said group represented by the formula (2), when said metal complex represented by the formula (1-A) has only one type of said group represented by the formula (2), said the requirement (i) is satisfied.
[3] The metal complex according to [1] or [2], wherein in said formula (2), X is an arylene group optionally having a substituent or a divalent hetero ring group optionally having a substituent.
[4] The metal complex according to any one of [1] to [3], wherein in said formula (2), two R³ are alkyl groups optionally having a substituent.
[5] The metal complex according to any one of [1] to [4], wherein in said formula (2), neither R³ and R⁴, nor R³ and R⁸ form a ring together with carbon atoms to which they are attached.
[6] A composition comprising at least one selected from the group consisting of a compound represented by the formula (H-1) and a polymer compound containing a constitutional unit represented by the formula (Y), and the metal complex as described in any one of [1] to [5] : 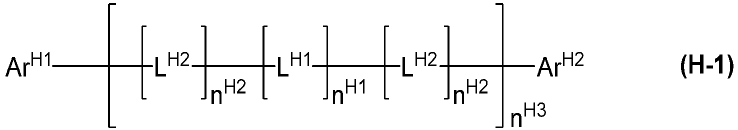 wherein,
   Ar^{H1} and Ar^{H2} each independently represent an aryl group or a monovalent hetero ring group, and these groups optionally have a substituent,
   n^{H1} and n^{H2} each independently represent 0 or 1, when a plurality of n^{H1} are present, they may be the same or different, a plurality of n^{H2} may be the same or different,
   n^{H3} represents an integer of 0 or more,
   L^{H1} represents an arylene group, a divalent hetero ring group, or a group represented by -[C(R^{H11})₂]n^{H11}-, and these groups optionally have a substituent, when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and these groups optionally have a substituent, a plurality of R^{H11} may be the same or different and may be combined together to form a ring together with carbon atoms to which they are attached,
   L^{H2} represents a group represented by -N(-L^{H21}-R^{H21})-, when a plurality of L^{H2} are present, they may be the same or different, L^{H21} represents a single bond, an arylene group or a divalent hetero ring group, and these groups optionally have a substituent, R^{H21} represents a hydrogen atom, an alkyl group, a cycloalkyl group, an aryl group or a monovalent hetero ring group, and these groups optionally have a substituent, 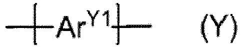 wherein, Ar^{Y1} represents an arylene group, a divalent hetero ring group, or a divalent group in which an arylene group and a divalent hetero ring group are bonded directly, and these groups optionally have a substituent.
[7] A composition comprising at least one material selected from the group consisting of a hole transporting material, a hole injection material, an electron transporting material, an electron injection material, a light emitting material, an antioxidant and a solvent, and the metal complex as described in any one of [1] to [5].
[8] A light emitting device comprising the metal complex as described in any one of [1] to [5], or the composition as described in [6].

### Effect of the Invention

According to the present invention, it is possible to provide a metal complex which is useful for producing a light emitting device excellent in external quantum efficiency. Further, according to the present invention, it is possible to provide a composition comprising the metal complex, and a light emitting device comprising the metal complex or the composition.

### Modes for Carrying Out the Invention

Suitable embodiments of the present invention will be illustrated in detail below.

### <Explanation of common terms>

Terms commonly used in the present specification have the following meanings unless otherwise stated.

Me represents a methyl group, Et represents an ethyl group, Bu represents a butyl group, i-Pr represents an isopropyl group and t-Bu represents a tert-butyl group.

A hydrogen atom may be a heavy hydrogen atom or a light hydrogen atom.

In the formula representing a metal complex, the solid line representing a bond with the central metal means a covalent bond or a coordination bond.

"The polymer compound" means a polymer having molecular weight distribution and having a polystyrene-equivalent number-average molecular weight of 1×10³ to 1×10⁸.

The polymer compound may be any of a block copolymer, a random copolymer, an alternating copolymer and a graft copolymer, and may also be another form.

The end group of the polymer compound is preferably a stable group since if a polymerization active group remains intact there, there is a possibility of a decrease in a light emitting property or luminance life when the polymer compound is used for fabrication of a light emitting device. The end group is preferably a group conjugatively bonded to the main chain and includes, for example, groups bonding to an aryl group or a monovalent hetero ring group via a carbon-carbon bond.

"The constitutional unit" means a unit occurring once or more times in the polymer compound.

"The low molecular weight compound" means a compound having no molecular weight distribution and having a molecular weight of 1×10⁴ or less.

"The alkyl group" may be any of linear and branched. The number of carbon atoms of the linear alkyl group, not including the number of carbon atoms of the substituent, is usually 1 to 50, preferably 3 to 30, and more preferably 4 to 20. The number of carbon atoms of the branched alkyl group, not including the number of carbon atoms of the substituent, is usually 3 to 50, preferably 3 to 30, and more preferably 4 to 20.

The alkyl group optionally has a substituent and examples thereof include a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom and the like (for example, a trifluoromethyl group, a pentafluoroethyl group, a perfluorobutyl group, a perfluorohexyl group, a perfluorooctyl group, a 3-phenylpropyl group, a 3 (4-methylphenyl)propyl group, a 3-(3,5-di-hexylphenyl)propyl group, a 6-ethyloxyhexyl group) .

The number of carbon atoms of "cycloalkyl group", not including the number of carbon atoms of the substituent, is usually 3 to 50, preferably 3 to 30, and more preferably 4 to 20.

The cycloalkyl group optionally has a substituent and examples thereof include a cyclohexyl group, a cyclohexylmethyl group and a cyclohexylethyl group.

"The aryl group" means an atomic group remaining after removing from an aromatic hydrocarbon one hydrogen atom bonding directly to a carbon atom constituting the ring. The number of carbon atoms of the aryl group, not including the number of carbon atoms of the substituent, is usually 6 to 60, preferably 6 to 20, and more preferably 6 to 10.

The aryl group optionally has a substituent and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom or the like.

"The alkoxy group" may be any of linear and branched. The number of carbon atoms of the linear alkoxy group, not including the number of carbon atoms of the substituent, is usually 1 to 40, and preferably 4 to 10. The number of carbon atoms of the branched alkoxy group, not including the number of carbon atoms of the substituent, is usually 3 to 40, and preferably 4 to 10.

The alkoxy group optionally has a substituent and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of the "cycloalkoxy group", not including the number of carbon atoms of the substituent, is usually 3 to 40, and preferably 4 to 10.

The cycloalkoxy group optionally has a substituent and examples thereof include a cyclohexyloxy group.

The number of carbon atoms of the "aryloxy group", not including the number of carbon atoms of the substituent, is usually 6 to 60, and preferably 6 to 48 .

The aryloxy group optionally has a substituent and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom or the like.

"The p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of the p-valent hetero ring groups, "p-valent aromatic hetero ring group" as an atomic group remaining after removing from an aromatic heterocyclic compound p hydrogen atoms among hydrogen atoms bonding directly to carbon atoms or hetero atoms constituting the ring is preferable.

"The aromatic heterocyclic compound " means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to the hetero ring even if the hetero ring itself shows no aromaticity such as phenoxazine, phenothiazine, dibenzoborole, dibenzosilole, benzopyran and the like.

The number of carbon atoms of the monovalent hetero ring group, not including the number of carbon atoms of the substituent, is usually 2 to 60, and preferably 4 to 20.

The monovalent hetero ring group optionally has a substituent and examples thereof include a thienyl group, a pyrrolyl group, a furyl group, a pyridinyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group or the like.

"The halogen atom" denotes a fluorine atom, a chlorine atom, a bromine atom or an iodine atom.

"The amino group" optionally has a substituent, and a substituted amino group is preferred. The substituent which the amino group has is preferably an alkyl group, a cycloalkyl group, an aryl group or a monovalent hetero ring group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"The alkenyl group" may be any of linear and branched. The number of carbon atoms of the linear alkenyl group, not including the number of carbon atoms of the substituent, is usually 2 to 30, and preferably 3 to 20. The number of carbon atoms of the branched alkenyl group, not including the number of carbon atoms of the substituent, is usually 3 to 30, and preferably 4 to 20.

The number of carbon atoms of the "cycloalkenyl group", not including the number of carbon atoms of the substituent, is usually 3 to 30, and preferably 4 to 20.

The alkenyl group and the cycloalkenyl group optionally have a substituent and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"The alkynyl group" may be any of linear and branched. The number of carbon atoms of the alkynyl group, not including the number of carbon atoms of the substituent, is usually 2 to 20, and preferably 3 to 20. The number of carbon atoms of the branched alkynyl group, not including the number of carbon atoms of the substituent, is usually 4 to 30, and preferably 4 to 20.

The number of carbon atoms of the "cycloalkynyl group", not including the number of carbon atoms of the substituent, is usually 4 to 30, and preferably 4 to 20.

The alkynyl group and the cycloalkynyl group optionally have a substituent and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"The arylene group" means an atomic group remaining after removing from an aromatic hydrocarbon two hydrogen atoms bonding directly to carbon atoms constituting the ring. The number of carbon atoms of the arylene group, not including the number of carbon atoms of the substituent, is usually 6 to 60, preferably 6 to 30, and more preferably 6 to 18.

The arylene group optionally has a substituent and examples thereof include a phenylene group, a naphthalenediyl group, an anthracenediyl group, a phenanthrenedilyl group, a dihydrophenanthrenedilyl group, a naphthacenediyl group, a fluorenediyl group, a pyrenediyl group, a perylenediyl group and a chrysenediyl group, and these groups having a substituent, and groups represented by the formula (A-1) to the formula (A-20) are preferable. The arylene group includes groups obtained by bonding a plurality of these groups. 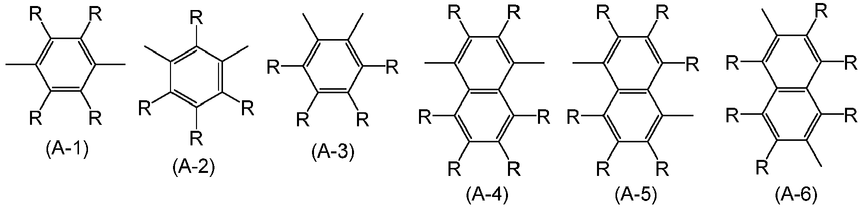 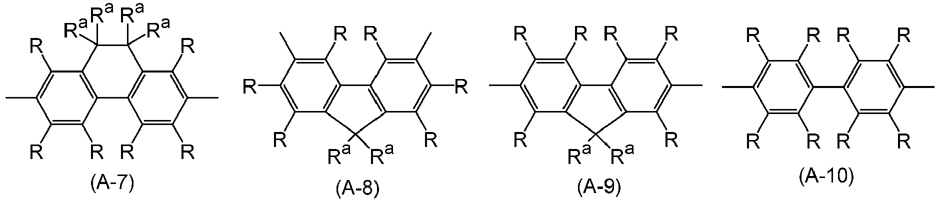 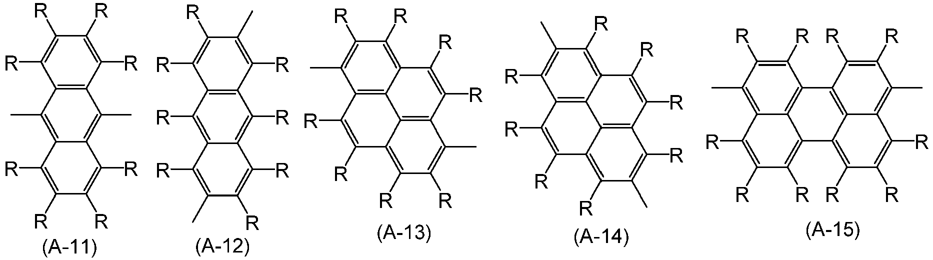 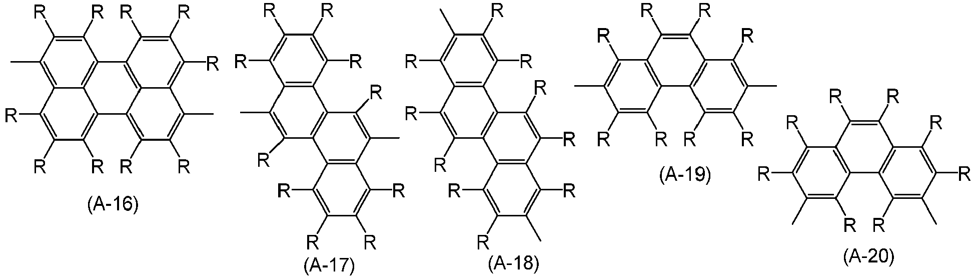 [wherein, R and R^{a} each independently represent a hydrogen atom, an alkyl group, a cycloalkyl group, an aryl group or a monovalent hetero ring group. A plurality of R and R^{a} each may be the same or different, and the plurality of R^{a} may be combined together to form a ring together with atoms to which they are attached.]

The number of carbon atoms of the divalent hetero ring group, not including the number of carbon atoms of the substituent, is usually 2 to 60, preferably 3 to 20, and more preferably 4 to 15.

The divalent hetero ring group optionally has a substituent and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms bonding directly to carbon atoms or hetero atoms constituting the ring, preferably groups represented by the formula (AA-1) to the formula (AA-34). The divalent hetero ring group includes groups obtained by bonding a plurality of these groups. 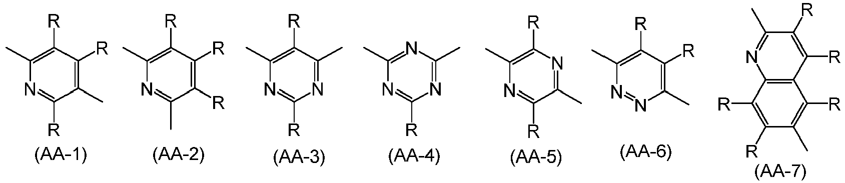 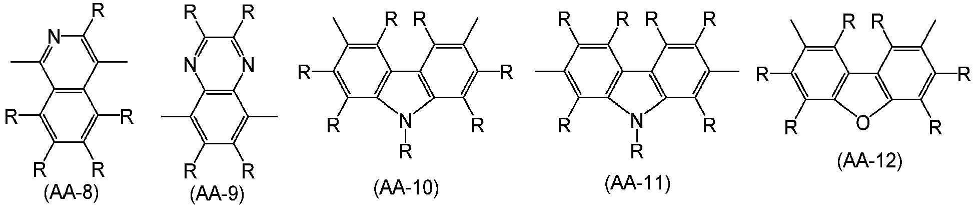 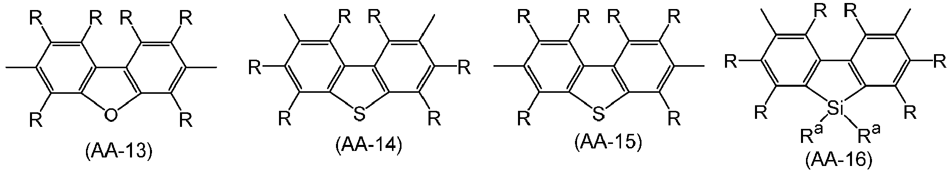 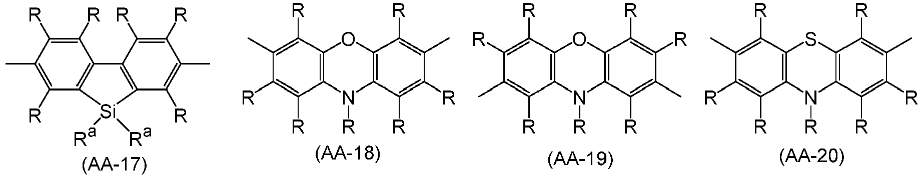 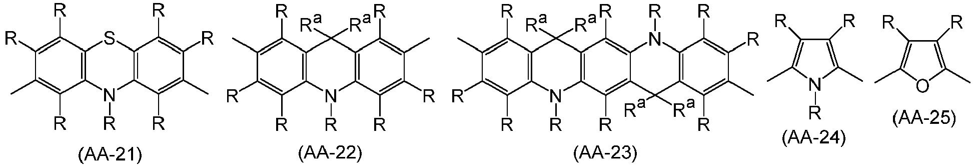 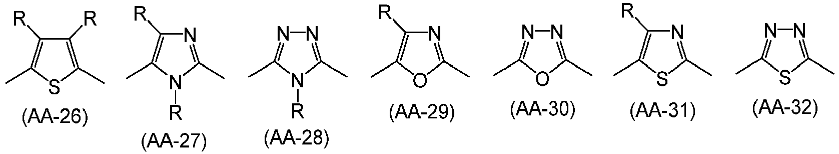 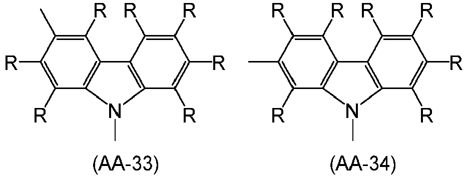 [wherein, R and R^{a} represent the same meaning as described above.]

"The cross-linkable group" refers to a group capable of generating a new bond by being subjected to a heating treatment, an ultraviolet irradiation treatment, a near-ultraviolet irradiation treatment, a visible light irradiation treatment, an infrared irradiation treatment, a radical reaction and the like, and groups represented by any of the formulae (B-1) to (B-17) are preferable. These groups optionally have a substituent.

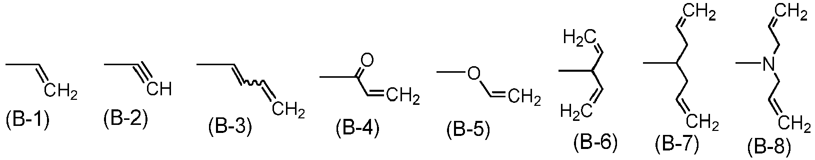

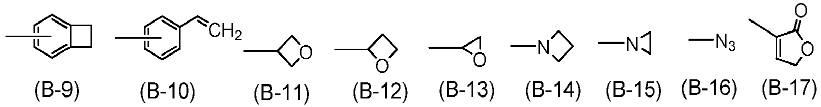

"The substituent" denotes, for example, a halogen atom, a cyano group, an alkyl group, a cycloalkyl group, an aryl group, a monovalent hetero ring group, an alkoxy group, a cycloalkoxy group, an aryloxy group, an amino group, a substituted amino group, an alkenyl group, a cycloalkenyl group, an alkynyl group, a cycloalkynyl group, or the above-described group represented by the formula (2). The substituent may also be a cross-linkable group.

### <Metal complex>

The metal complex of the present invention is represented by the formula (1-A), since the light emitting device of the present invention is more excellent in external quantum efficiency.

Ring L^{1A} is preferably a pyridine ring, a diazabenzene ring, an azanaphthalene ring, a diazanaphthalene ring, a triazole ring or a diazole ring, and more preferably a triazole ring or a diazole ring, since the light emitting device of the present invention is more excellent in external quantum efficiency, and these rings optionally have a substituent.

In the formula (1-A), the anionic bidentate ligand represented by A¹-G¹-A² includes, for example, ligands represented by the following formulae. However, the anionic bidentate ligand represented by A¹-G¹-A² is different from ligands of which number is defined by the suffix n₁.

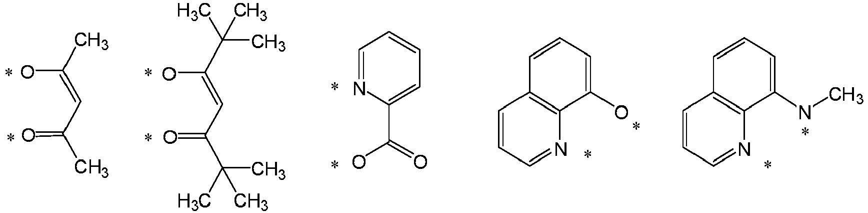

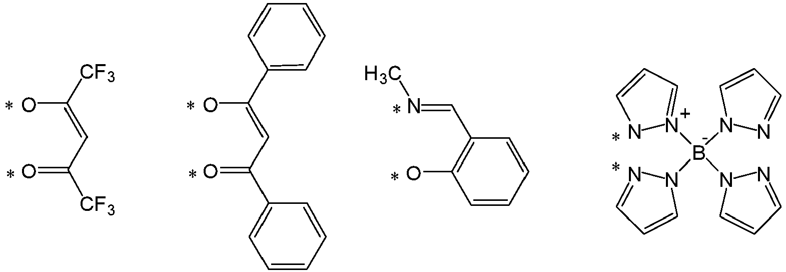

The substituent which Ring L^{1A} optionally has is preferably an alkyl group, a cycloalkyl group, an alkoxy group, a cycloalkoxy group, an aryl group, an aryloxy group, a monovalent hetero ring group, a substituted amino group or a halogen atom, more preferably an alkyl group, an aryl group or a monovalent hetero ring group, and further preferably an aryl group or a monovalent hetero ring group, in addition to a group represented by the formula (2), and these groups optionally further have a substituent.

The aryl group as the substituent which Ring L^{1A} and optionally has is preferably a phenyl group, a naphthyl group, a phenanthrenyl group, a dihydrophenanthrenyl group or a fluorenyl group, more preferably a phenyl group or a fluorenyl group, and further preferably a phenyl group, and these groups optionally have a substituent.

The monovalent hetero ring group as the substituent which Ring L^{1A} optionally has is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiazinyl group, and these groups optionally have a substituent.

In the substituted amino group as the substituent which Ring L^{1A} optionally has, the substituent which the amino group has is preferably an aryl group or a monovalent hetero ring group, and these groups optionally further have a substituent. The examples and preferable ranges of the aryl group as the substituent which the amino group has are the same as the examples and preferable ranges of the aryl group as the substituent which Ring L^{1A} optionally has. The examples and preferable ranges of the monovalent hetero ring group as the substituent which the amino group has are the same as the examples and preferable ranges of the monovalent hetero ring group as the substituent which Ring L^{1A} optionally has.

The substituent which the substituent which Ring L^{1A} optionally has optionally further has preferably an alkyl group, a cycloalkyl group, an aryl group, a monovalent hetero ring group or a substituted amino group, more preferably an alkyl group, a cycloalkyl group or an aryl group, and further preferably an alkyl group, in addition to a group represented by the formula (2), and these groups optionally further have a substituent, but it is preferable that these groups do not further have a substituent.

The aryl group, the monovalent hetero ring group or the substituted amino group as the substituent which Ring L^{1A} optionally has is preferably a group represented by the formula (D-A) to the formula (D-C), and more preferably a group represented by the formula (D-A) or the formula (D-B), since the light emitting device of the present invention is more excellent in external quantum efficiency. 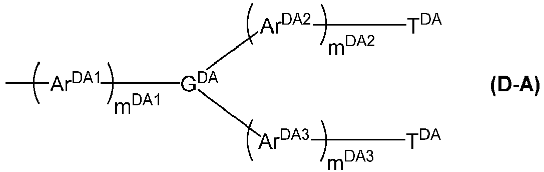 [wherein,
m^{DA1} to m^{DA3} each independently represent an integer of 0 or more.
G^{DA} represents a nitrogen atom, an aromatic hydrocarbon group or a hetero ring group, and these groups optionally have a substituent.
Ar^{DA1} to Ar^{DA3} each independently represent an arylene group or a divalent hetero ring group, and these groups optionally have a substituent. When a plurality of Ar^{DA1} to Ar^{DA3} are present, they may be the same or different at each occurrence.
T^{DA} represents an aryl group or a monovalent hetero ring group, and these groups optionally have a substituent. A plurality of T^{DA} may be the same or different.] 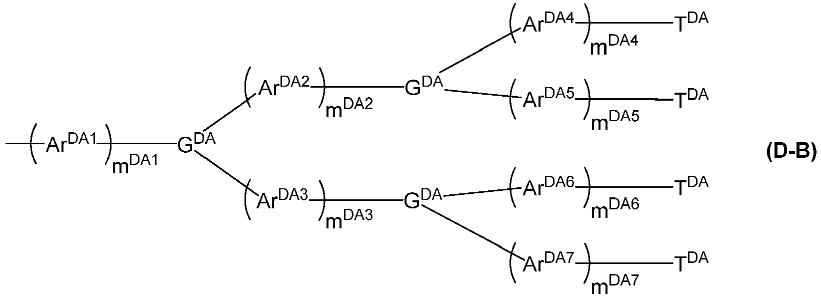
[wherein,
m^{DA1} to m^{DA7} each independently represent an integer of 0 or more.
G^{DA} represents a nitrogen atom, an aromatic hydrocarbon group or a hetero ring group, and these groups optionally have a substituent. A plurality of G^{DA} may be the same or different.
Ar^{DA1} to Ar^{DA7} each independently represent an arylene group or a divalent hetero ring group, and these groups optionally have a substituent. When a plurality of Ar^{DA1} to Ar^{DA7} are present, they may be the same or different at each occurrence.
T^{DA} represents an aryl group or a monovalent hetero ring group, and these groups optionally have a substituent. A plurality of T^{DA} may be the same or different.] 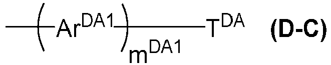
[wherein,
m^{DA1} represents an integer of 0 or more.
Ar^{DA1} represents an arylene group or a divalent hetero ring group, and these groups optionally have a substituent. When a plurality of Ar^{DA1} are present, they may be the same or different.
T^{DA} represents an aryl group or a monovalent hetero ring group, and these groups optionally have a substituent.]

m^{DA1} to m^{DA7} represent usually an integer of 10 or less, preferably an integer of 2 or less, and more preferably 0 or 1. m^{DA2} to m^{DA7} are preferably the same integer.

G^{DA} is preferably an aromatic hydrocarbon group or a hetero ring group, more preferably a group obtained by removing from a benzene ring, a pyridine ring, a pyrimidine ring, a triazine ring or a carbazole ring three hydrogen atoms directly bonding to carbon atoms or nitrogen atoms constituting the ring, and these groups optionally have a substituent.

The substituent which G^{DA} optionally has is preferably an alkyl group, a cycloalkyl group, an alkoxy group, a cycloalkoxy group, an aryl group or a monovalent hetero ring group, and more preferably an alkyl group or a cycloalkyl group, and these groups optionally have a substituent, but it is preferable that these groups do not further have a substituent.

G^{DA} is preferably a group represented by the formula (GDA-11) to the formula (GDA-15), and more preferably a group represented by the formula (GDA-11) to the formula (GDA-14). 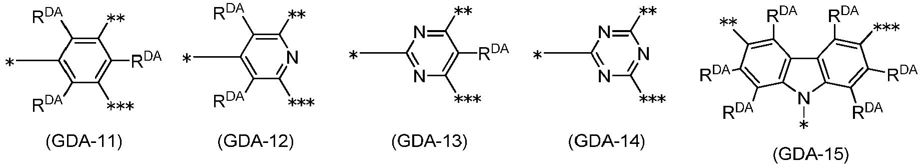 [wherein,
* represents a bond to Ar^{DA1} in the formula (D-A), or a bond to Ar^{DA1}, Ar^{DA2} or Ar^{DA3} in the formula (D-B).
** represents a bond to Ar^{DA2} in the formula (D-A), or a bond to Ar^{DA2}, Ar^{DA4} or Ar^{DA6} in the formula (D-B).
*** represents a bond to Ar^{DA3} in the formula (D-A), or a bond to Ar^{DA3}, Ar^{DA5} or Ar^{DA7} in the formula (D-B) .
R^{DA} represents a hydrogen atom, an alkyl group, a cycloalkyl group, an alkoxy group, a cycloalkoxy group, an aryl group or a monovalent hetero ring group, and these groups optionally further have a substituent. When a plurality of R^{DA} are present, they may be the same or different.]

R^{DA} is preferably a hydrogen atom, an alkyl group, a cycloalkyl group, an alkoxy group or a cycloalkoxy group, more preferably a hydrogen atom, an alkyl group or a cycloalkyl group, and these groups optionally have a substituent, but it is preferable that these groups do not further have a substituent.

Ar^{DA1} to Ar^{DA7} are each preferably a phenylene group, a fluorenediyl group or a carbazolediyl group, more preferably a group represented by the formula (ArDA-1) to the formula (ArDA-5), and further preferably a group represented by the formula (ArDA-1) to the formula (ArDA-3), and these groups optionally have a substituent. 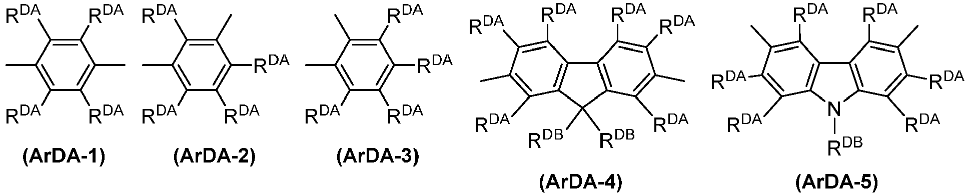 [wherein,
R^{DA} represents the same meaning as described above.
R^{DB} represents a hydrogen atom, an alkyl group, a cycloalkyl group, an aryl group or a monovalent hetero ring group, and these groups optionally have a substituent. When a plurality of R^{DB} are present, they may be the same or different.]

R^{DB} is preferably an alkyl group, a cycloalkyl group, an aryl group or a monovalent hetero ring group, and more preferably an aryl group, and these groups optionally have a substituent.

The examples and preferable ranges of the substituent which Ar^{DA1} to Ar^{DA7} and R^{DB} optionally have are the same as the examples and preferable ranges of the substituent which G^{DA} optionally has.

T^{DA} is preferably a group represented by the formula (TDA-1) to the formula (TDA-3), and more preferably a group represented by the formula (TDA-1). 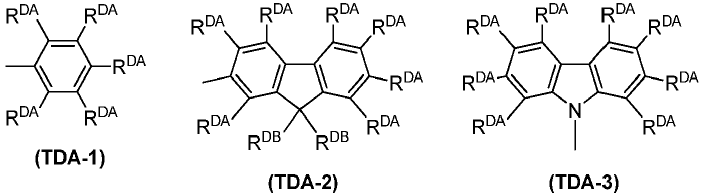 [wherein, R^{DA} and R^{DB} represent the same meaning as described above.]

The group represented by the formula (D-A) is preferably a group represented by the formula (D-A1) to the formula (D-A5). 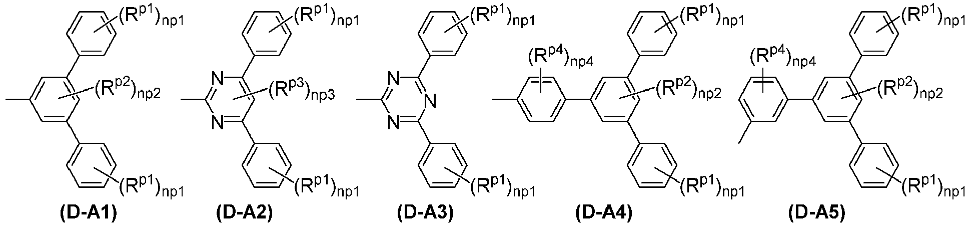 [wherein,
R^{p1} to R^{p4} each independently represent an alkyl group, a cycloalkyl group, an alkoxy group, a cycloalkoxy group or a halogen atom. When a plurality of R^{p1}, R^{p2} and R^{p4} are present, they may be the same or different at each occurrence.

np1 represents an integer of 0 to 5, np2 represents an integer of 0 to 3, np3 represents 0 or 1, and np4 represents an integer of 0 to 4. A plurality of np1 may be the same or different.]

The group represented by the formula (D-B) is preferably a group represented by the formula (D-B1) to the formula (D-B3), and more preferably a group represented by the formula (D-B1). 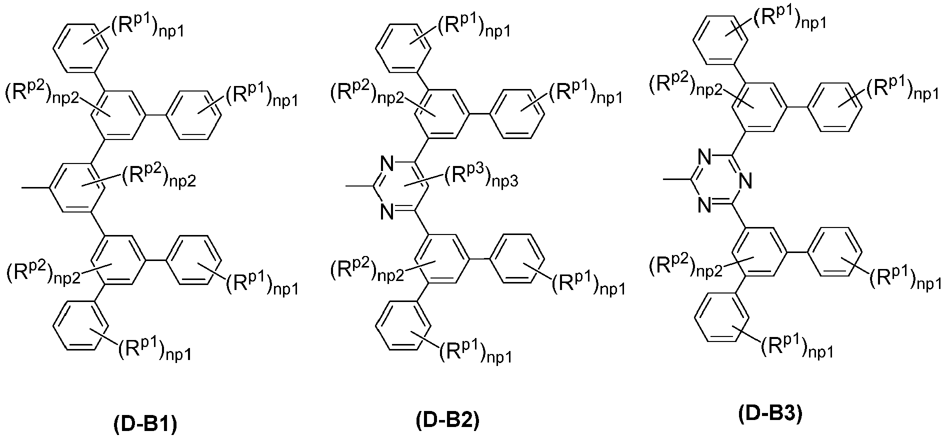 [wherein,
R^{p1} to R^{p3} each independently represent an alkyl group, a cycloalkyl group, an alkoxy group, a cycloalkoxy group or a halogen atom. When a plurality of R^{p1} and R^{p2} are present, they may be the same or different at each occurrence.

np1 represents an integer of 0 to 5, np2 represents an integer of 0 to 3, and np3 represents 0 or 1. When a plurality of np1 and np2 are present, they may be the same or different at each occurrence.

The group represented by the formula (D-C) is preferably a group represented by the formula (D-C1) to the formula (D-C4), and more preferably a group represented by the formula (D-C1). 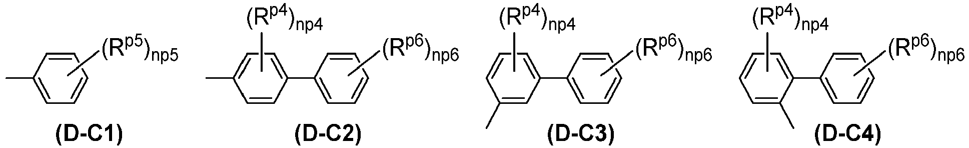 [wherein,
R^{p4} to R^{p6} each independently represent an alkyl group, a cycloalkyl group, an alkoxy group, a cycloalkoxy group or a halogen atom. When a plurality of R^{p4} to R^{p6} are present, they may be the same or different at each occurrence.

np4 represents an integer of 0 to 4, np5 represents an integer of 0 to 5, and np6 represents an integer of 0 to 5.]

np1 is preferably an integer of 0 to 2, and more preferably 0 or 1. np2 is preferably 0 or 1, and more preferably 0. np3 is preferably 0. np4 is preferably an integer of 0 to 2, and more preferably 0. np5 is preferably an integer of 0 to 3, and more preferably 0 or 1. np6 is preferably an integer of 0 to 2, and more preferably 0 or 1.

The alkyl group or the cycloalkyl group represented by R^{p1} to R^{p6} is preferably a methyl group, an ethyl group, an isopropyl group, a tert-butyl group, a hexyl group, a 2-ethylhexyl group, a cyclohexyl group or a tert-octyl group.

The alkoxy group or the cycloalkoxy group represented by R^{p1} to R^{p6} is preferably a methoxy group, a 2-ethylhexyloxy group or a cyclohexyloxy group.

R^{p1} to R^{p6} are each preferably an alkyl group optionally having a substituent or a cycloalkyl group optionally having a substituent, more preferably an alkyl group optionally having a substituent, and further preferably a methyl group, an ethyl group, an isopropyl group, a tert-butyl group, a hexyl group, a 2-ethylhexyl group or a tert-octyl group.

Ring L^{1A} is preferably a pyridine ring, a diazabenzene ring, an azanaphthalene ring, a diazanaphthalene ring, a triazole ring or a diazole ring, and more preferably a triazole ring or a diazole ring, since the light emitting device of the present invention is more excellent in external quantum efficiency, and these rings optionally have a substituent.

When a plurality of the substituents which Ring L^{1A} optionally has are present, it is preferable that they are not combined together to form a ring together with atoms to which they are attached.

It is preferable that Ring L^{2A} is a benzene ring, that is, E^{21A} to E^{24A} are each a carbon atom.

R^{21A} to R^{24A} are each preferably a hydrogen atom, an alkyl group, a cycloalkyl group, an aryl group, a monovalent hetero ring group, a substituted amino group or a group represented by the formula (2), and more preferably a hydrogen atom, an alkyl group, an aryl group or a group represented by the formula (2), since the light emitting device of the present invention is more excellent in external quantum efficiency, and these groups optionally have a substituent.

R^{21A} and R^{24A} are each further preferably a hydrogen atom. R^{22A} is further preferably a hydrogen atom, an aryl group optionally having a substituent or a group represented by the formula (2). R^{23A} is further preferably a hydrogen atom, an alkyl group optionally having a substituent or a group represented by the formula (2).

The examples and preferable ranges of the aryl group, the monovalent hetero ring group and the substituted amino group represented by R^{21A} to R^{24A} are the same as the examples and preferable ranges of the aryl group, the monovalent hetero ring group and the substituted amino group as the substituent which Ring L^{1A} optionally has, respectively.

The examples and preferable ranges of the substituent which R^{21A} to R^{24A} optionally have are the same as the examples and preferable ranges of the substituent which the substituent which Ring L^{1A} optionally has optionally further has.

When Ring L^{2A} has a group represented by the formula (2), it is preferable that R^{22A} or R^{23A} is a group represented by the formula (2).

It is preferable that R^{21A} and R^{22A}, R^{22A} and R^{23A}, and R^{23A} and R^{24A} are each not combined together to form a ring together with atoms to which they are attached.

The metal complex represented by the formula (1-A) is preferably a metal complex represented by the formula (1-A1) to the formula (1-A10), more preferably a metal complex represented by the formula (1-A1) to the formula (1-A6) or the formula (1-A8), further preferably a metal complex represented by the formula (1-A1) to the formula (1-A5), particularly preferably a metal complex represented by the formula (1-A1), the formula (1-A3) or the formula (1-A4), and especially preferably a metal complex represented by the formula (1-A1) or the formula (1-A3).

In the formula (1-A1), the formula (1-A3) and the formula (1-A4), R^{11A} is preferably an alkyl group, a cycloalkyl group, an aryl group, a monovalent hetero ring group or a group represented by the formula (2), more preferably an aryl group or a monovalent hetero ring group, and further preferably an aryl group, and these groups optionally have a substituent.

In the formula (1-A3) and the formula (1-A4), R^{12A} is preferably a hydrogen atom, an alkyl group, a cycloalkyl group, an aryl group, a monovalent hetero ring group, a substituted amino group or a group represented by the formula (2), and more preferably a hydrogen atom, an alkyl group, an aryl group or a group represented by the formula (2), and these groups optionally have a substituent. In the formula (1-A3), R^{12A} is further preferably an alkyl group optionally having a substituent or a group represented by the formula (2). In the formula (1-A4), R^{12A} is further preferably a hydrogen atom.

In the formula (1-A2) and the formula (1-A5), R^{12A} is preferably an alkyl group, a cycloalkyl group, an aryl group, a monovalent hetero ring group or a group represented by the formula (2), and more preferably an aryl group, and these groups optionally have a substituent.

In the formula (1-A5), R^{11A} is preferably a hydrogen atom, an alkyl group, a cycloalkyl group, an aryl group, a monovalent hetero ring group, a substituted amino group or a group represented by the formula (2), and more preferably a hydrogen atom, and these groups optionally have a substituent.

In the formula (1-A1), the formula (1-A2), the formula (1-A4) and the formula (1-A5), R^{13A} is preferably a hydrogen atom, an alkyl group, a cycloalkyl group, an aryl group, a monovalent hetero ring group, a substituted amino group or a group represented by the formula (2), and more preferably a hydrogen atom, an alkyl group, an aryl group or a group represented by the formula (2), and these groups optionally have a substituent. In the formula (1-A1) and the formula (1-A2), R^{13A} is further preferably an aryl group optionally having a substituent. In the formula (1-A4) and the formula (1-A5), R^{13A} is further preferably a hydrogen atom.

The examples and preferable ranges of the aryl group, the monovalent hetero ring group and the substituted amino group represented by R^{11A} to R^{13A} are the same as the examples and preferable ranges of the aryl group, the monovalent hetero ring group and the substituted amino group as the substituent which Ring L^{1A} optionally has, respectively.

The examples and preferable ranges of the substituent which R^{11A} to R^{13A} optionally have are the same as the examples and preferable ranges of the substituent which the substituent which Ring L^{1A} and optionally has optionally further has.

In the formula (1-A1) to the formula (1-A10), when at least one of R^{21A} to R^{24A} is a group represented by the formula (2), it is more preferable that R^{22A} or R^{23A} is a group represented by the formula (2).

It is preferable that R^{11A} and R^{12A}, R^{12A} and R^{13A}, R^{11B} and R^{12B}, R^{12B} and R^{13B}, R^{13B} and R^{14B}, R^{13B} and R^{15B}, R^{15B} and R^{16B}, R^{16B} and R^{17B}, R^{17B} and R^{18B} , R^{11B} and R^{18B}, R^{14B} and R^{15B}, and R^{12B} and R^{18B} are each not combined together to form a ring together with atoms to which they are attached.

R^{11B} to R^{18B} are each preferably a hydrogen atom, an alkyl group, a cycloalkyl group, an aryl group, a monovalent hetero ring group, a substituted amino group or a group represented by the formula (2), and more preferably a hydrogen atom, an alkyl group, an aryl group or a group represented by the formula (2), since the light emitting device of the present invention is more excellent in external quantum efficiency, and these groups optionally have a substituent.

The examples and preferable ranges of the aryl group, the monovalent hetero ring group and the substituted amino group represented by R^{11B} to R^{18B} are the same as the examples and preferable ranges of the aryl group, the monovalent hetero ring group and the substituted amino group as the substituent which Ring L¹ and Ring L² optionally have, respectively.

The examples and preferable ranges of the substituent which R^{11B} to R^{18B} optionally have are the same as the examples and preferable ranges of the substituent which the substituent which Ring L¹ and Ring L² optionally have optionally further has.

The metal complex represented by the formula (1) has a group represented by the formula (2).

The examples and preferable ranges of the aryl group represented by R³ and R⁹ are the same as the examples and preferable ranges of the aryl group as the substituent which Ring L¹ and Ring L² optionally have.

R⁴ to R⁸ are each preferably a hydrogen atom, an alkyl group, a cycloalkyl group, an aryl group, a monovalent hetero ring group or a substituted amino group, more preferably a hydrogen atom, an alkyl group, a cycloalkyl group or an aryl group, and further preferably a hydrogen atom, and these groups optionally have a substituent.

The examples and preferable ranges of the aryl group, the monovalent hetero ring group and the substituted amino group represented by R⁴ to R⁸ are the same as the examples and preferable ranges of the aryl group, the monovalent hetero ring group and the substituted amino group as the substituent which Ring L¹ and Ring L² optionally have, respectively.

The examples and preferable ranges of the substituent which R³ to R⁹ optionally have are the same as the examples and preferable ranges of the substituent which the substituent which Ring L¹ and Ring L² optionally have optionally further has.

In the formula (2), the alkyl group represented by R³ is preferably a group represented by the formula (II-01) to the formula (II-07), and the aryl group represented by R³ is preferably a group represented by the formula (II-08) to the formula (11-11).

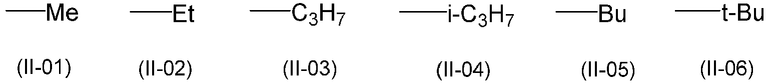

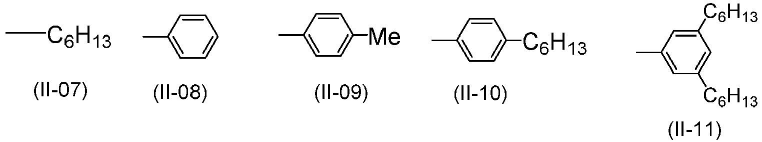

When R³ and R⁴, and R³ and R⁸ each do not form a ring together with carbon atoms to which they are attached, R³ is preferably an alkyl group optionally having a substituent, more preferably an alkyl group having no substituent, further preferably a group represented by the formula (II-01) or the formula (II-02), and particularly preferably a group represented by the formula (II-01).

When R³ and R⁴ form a ring together with carbon atoms to which they are attached, it is preferable that R⁴ is a hydrogen atom; and, R³ forming the ring among a plurality of R³ is an aryl group optionally having a substituent, and more preferably it is a group represented by the formula (II-08). In the above-described case, R³ not forming the ring is preferably a group represented by the formula (II-01) to the formula (II-011), and more preferably a group represented by the formula (II-01) to the formula (II-03), the formula (II-05) or the formula (II-07) to the formula (II-11).

X is preferably an arylene group optionally having a substituent or a divalent hetero ring group optionally having a substituent, since the light emitting device of the present invention is excellent in external quantum efficiency.

The examples and preferable ranges of the arylene group and the divalent hetero ring group represented by X are the same as the examples and preferable ranges of the arylene group and the divalent hetero ring group represented by Ar^{Y1} described later, respectively.

The examples and preferable ranges of the substituent which X optionally has are the same as the examples and preferable ranges of the substituent which the substituent which Ring L^{1A} optionally have optionally further has.

k₁ is preferably 0 to 2, more preferably 0 or 1, and further preferably 0.

The group represented by the formula (2) includes, for example, groups represented by the formula (2-A-1) to the formula (2-A-13), and is preferably a group represented by the formula (2-A-1) to the formula (2-A-4) or the formula (2-A-6) to the formula (2-A-9), and more preferably a group represented by the formula (2-A-1) or the formula (2-A-9).

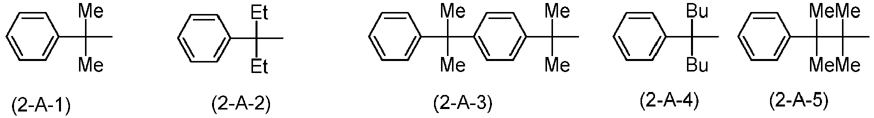

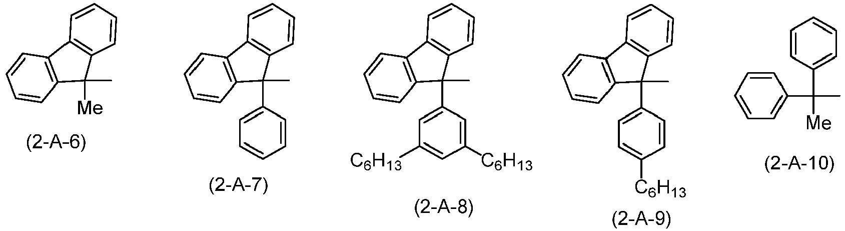

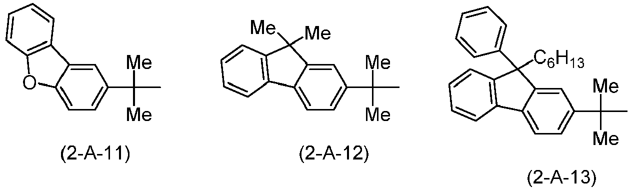

The metal complex represented by the formula (1-A) includes, for example, metal complexes represented below.

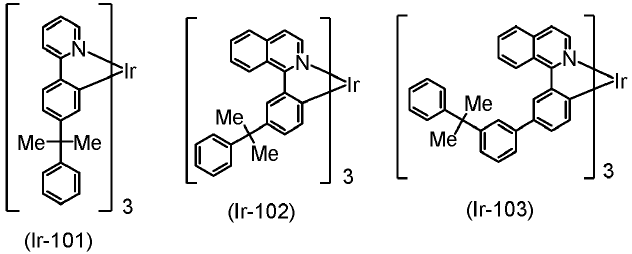

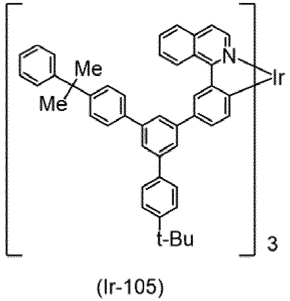

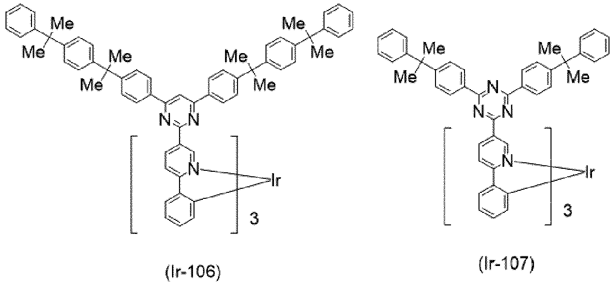

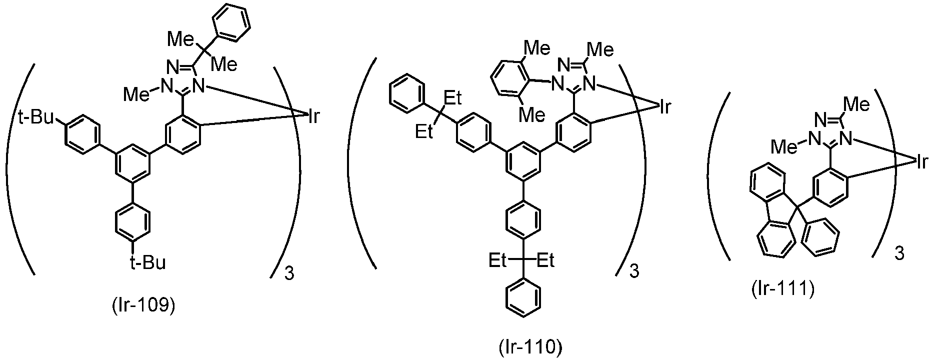

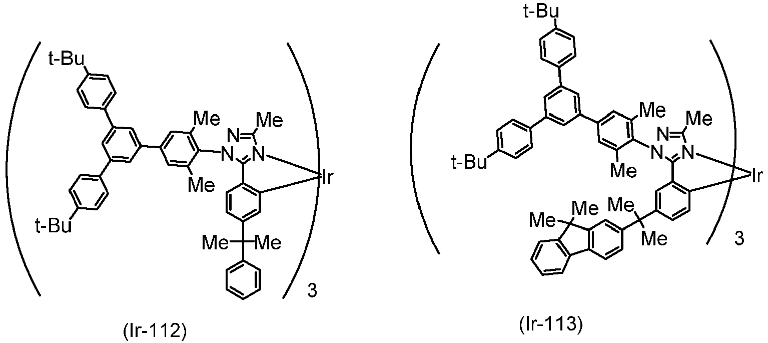

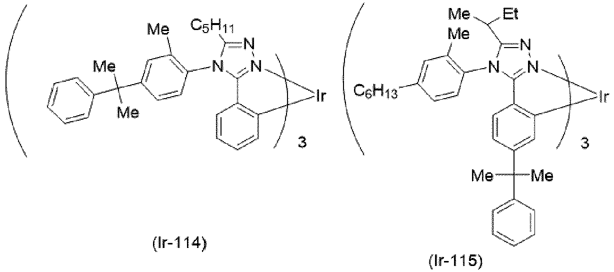

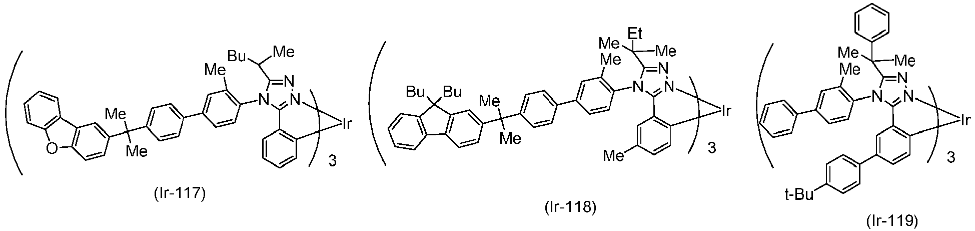

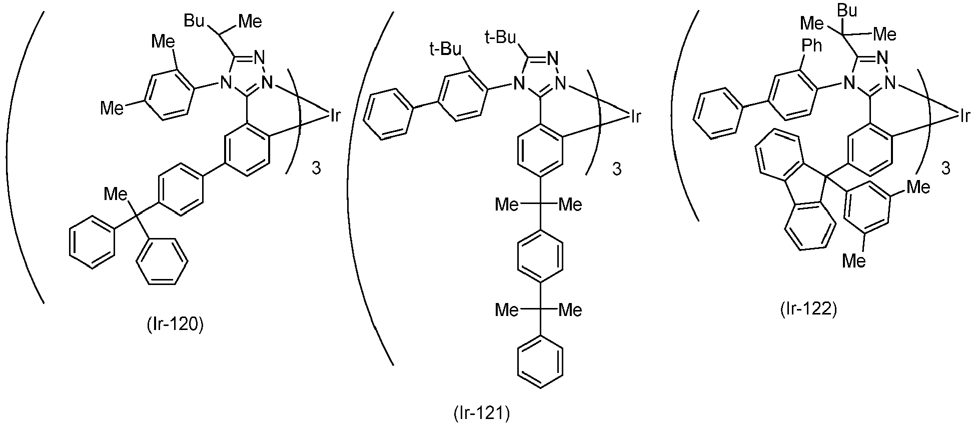

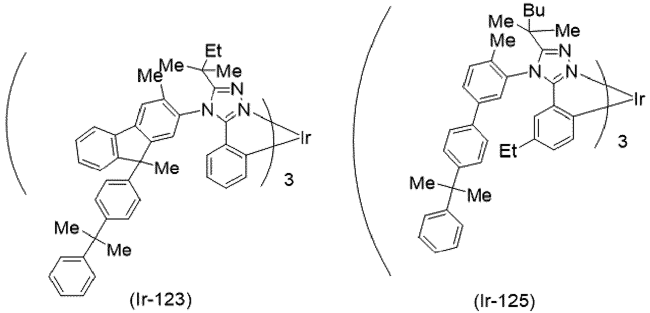

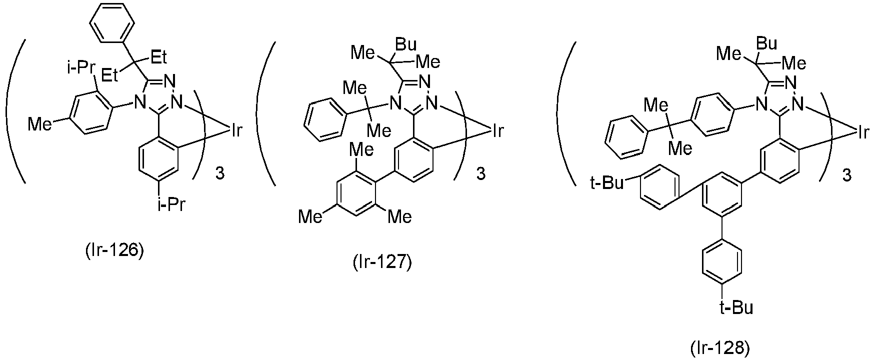

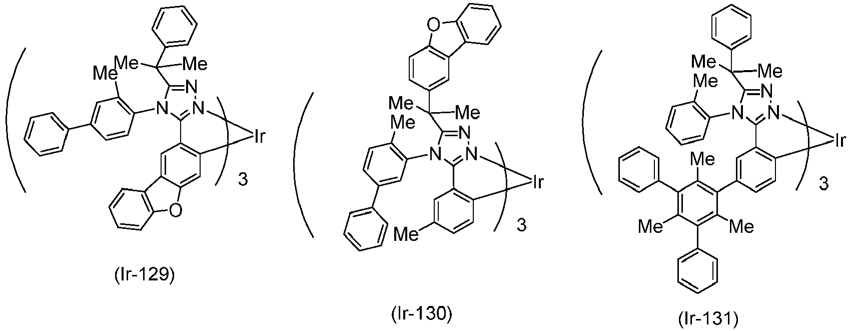

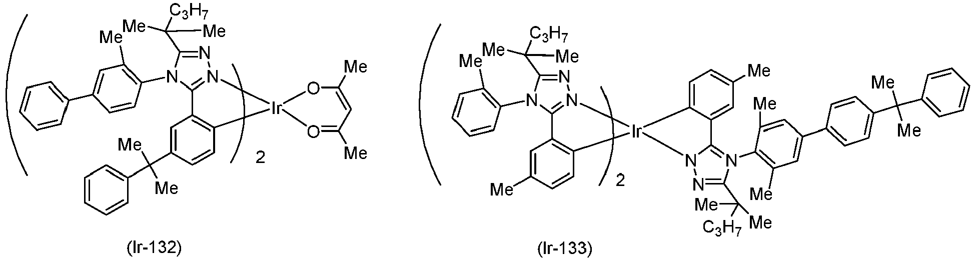

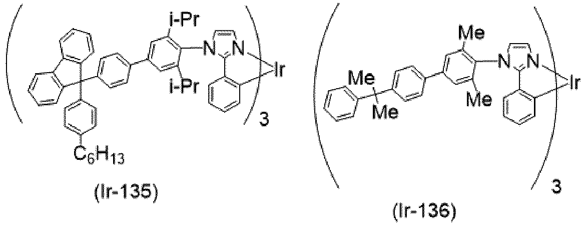

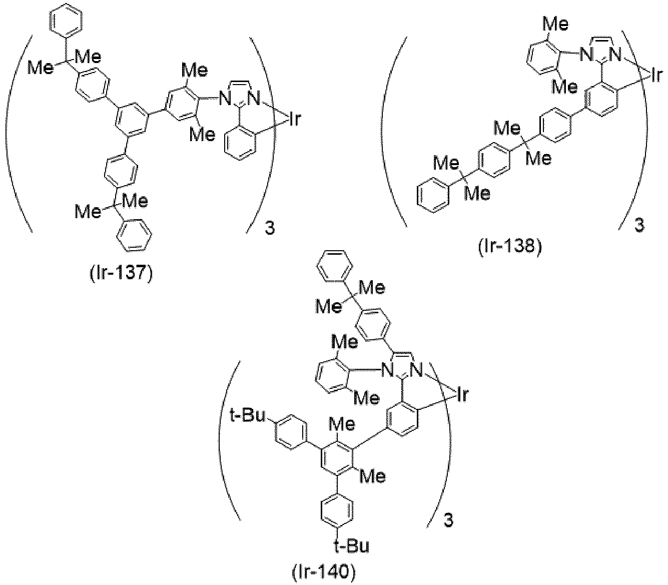

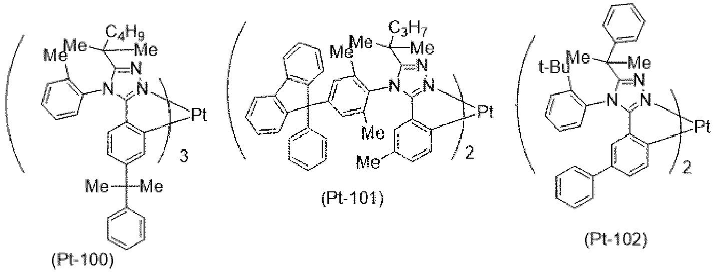

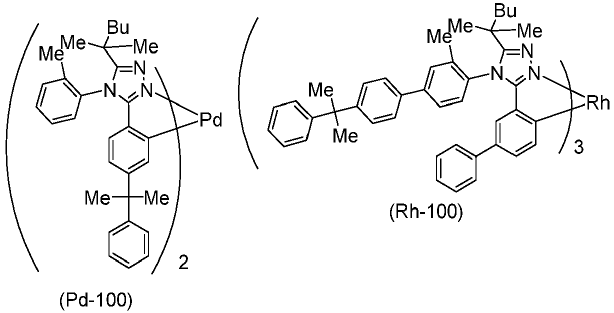

A plurality of geometric isomers can be considered for the metal complex represented by the formula (1), and any geometric isomer may be permissible, however, the proportion of the facial body is preferably 80% by mol or more, more preferably 90% by mol or more, further preferably 99% by mol or more, and particularly preferably 100% by mol, with respect to the whole metal complex of the present invention, since the light emitting device of the present invention is excellent in external quantum efficiency.

### <Production method of metal complex>

### • Production method 1

The metal complex of the present invention can be produced, for example, by a method of reacting a compound acting as a ligand with a metal compound. If necessary, a functional group conversion reaction of a ligand of a metal complex may be carried out.

The compound represented by the formula (1) can be produced, for example, by a method comprising a step A of reacting a compound represented by the formula (M-1) with an iridium compound or its hydrate, and a step B of reacting a metal complex represented by the formula (M-2) with a compound represented by the formula (M-1) or a precursor of a ligand represented by A¹-G¹-A².

This method may be used to produce the metal complexes represented by formula (1-A) of the present invention.

Formula (1) is defined as follows: 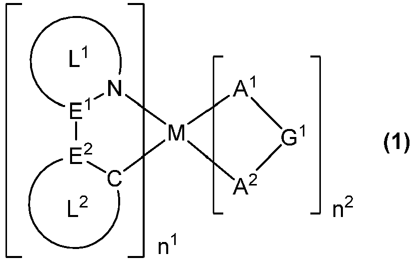 wherein,
M represents a ruthenium atom, a rhodium atom, a palladium atom, an iridium atom or a platinum atom.
n¹ represents an integer of 1 or more, and n² represents an integer of 0 or more. n¹+n² is 3 when M is a ruthenium atom, a rhodium atom or an iridium atom, while n¹+n² is 2 when M is a palladium atom or a platinum atom.
E¹ and E² each independently represent a nitrogen atom or a carbon atom. When a plurality of E¹ and E² are present, they may be the same or different at each occurrence.

Ring L¹ represents an aromatic hetero ring, and this ring optionally has a substituent. When a plurality of the substituents are present, they may be combined together to form a ring together with atoms to which they are attached. When a plurality of Ring L¹ are present, they may be the same or different.

Ring L² represents an aromatic hydrocarbon ring or an aromatic hetero ring, and these rings optionally have a substituent. When a plurality of the substituents are present, they may be the same or different and may be combined together to form a ring together with atoms to which they are attached. When a plurality of Ring L² are present, they may be the same or different.

At least one of Ring L¹ and Ring L² has a group represented by the formula (2) as the above-described substituent. When a plurality of the above-described groups represented by the formula (2) are present, they may be the same or different.

A¹-G¹-A² represents an anionic bidentate ligand. A¹ and A² each independently represent a carbon atom, an oxygen atom or a nitrogen atom, and these atoms may be ring-constituent atoms. G¹ represents a single bond, or an atomic group constituting a bidentate ligand together with A¹ and A². When a plurality of A¹-G¹-A² are present, they may be the same or different.] 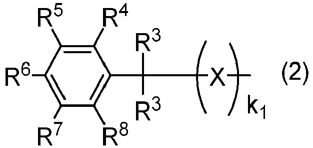 wherein,
R³ represents an alkyl group or an aryl group, and these groups optionally have a substituent. A plurality of R³ may be the same or different. R³ and R⁴, and R³ and R⁸ each may form a ring together with carbon atoms to which they are attached.
R⁴, R⁵, R⁶, R⁷ and R⁸ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent. When a plurality of R⁴, R⁵, R⁶, R⁷ and R⁸ are present, they may be the same or different at each occurrence. R⁴ and R⁵, R⁵ and R⁶, R⁶ and R⁷, and R⁷ and R⁸ each may be combined together to form a ring together with carbon atoms to which they are attached.
X represents -C(R⁹)₂-, an arylene group or a divalent hetero ring group, and these groups optionally have a substituent. R⁹ represents an alkyl group or an aryl group, and these groups optionally have a substituent. A plurality of R⁹ may be the same or different. When a plurality of X are present, they may be the same or different.
k₁ represents an integer of 0 to 3.

When the said metal complex represented by the formula (1) has only one type of the above-described group represented by the formula (2), the requirement (i) or the requirement (ii) is satisfied.
(i) The above-described Ring L¹ is a monocyclic 5-membered aromatic hetero ring; and, at least one of the above-described Ring L² has the above-described group represented by the formula (2) in which one of R³ is a phenyl group optionally having a substituent, R⁴ is a hydrogen atom, and the R³ and the R⁴ are combined to form a fluorene ring.
(ii) The above-described Ring L¹ is a monocyclic 5-membered aromatic hetero ring; and, at least one of the fact that one of R³ is a phenyl group optionally having a substituent, that R⁴ is a hydrogen atom, and that the R³ and the R⁴ are combined to form a fluorene ring is not satisfied; and, at least one of R³ in the above-described formula (2) is an alkyl group optionally having a substituent.

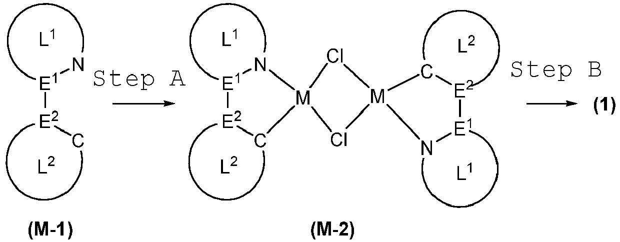

In the step A, the iridium compound includes, for example, iridium chloride, tris(acetylacetonato)iridium(III), chloro(cyclooctadiene)iridium(I) dimer and iridium(III) acetate. The hydrate of the iridium compound includes, for example, iridium chloride•trihydrate.

The step A and the step B are conducted usually in a solvent. The solvent includes alcohol solvents such as methanol, ethanol, propanol, ethylene glycol, glycerin, 2-methoxyethanol, 2-ethoxyethanol and the like; ether solvents such as diethyl ether, tetrahydrofuran (THF), dioxane, cyclopentyl methyl ether, diglyme and the like; halogen-based solvents such as methylene chloride, chloroform and the like; nitrile solvents such as acetonitrile, benzonitrile and the like; hydrocarbon solvents such as hexane, decalin, toluene, xylene, mesitylene and the like; amide solvents such as N,N-dimethylformamide, N,N-dimethylacetamide and the like; acetone, dimethyl sulfoxide, water and the like.

In the step A and the step B, the reaction time is usually 30 minutes to 150 hours, and the reaction temperature is usually between the melting point and the boiling point of a solvent present in the reaction system.

In the step A, the amount of the compound represented by the formula (M-1) is usually 2 to 20 mol, with respect to 1 mol of an iridium compound or its hydrate.

In the step B, the amount of the compound presented by the formula (M-1) or the precursor of the ligand represented by A¹-G¹-A² is usually 1 to 100 mol, with respect to 1 mol of the metal complex represented by the formula (M-2).

In the step B, it is preferable that the reaction is conducted in the presence of a silver compound such as silver trifluoromethanesulfonate and the like. When a silver compound is used, its amount is usually 2 to 20 mol, with respect to 1 mol of the metal complex represented by the formula (M-2).

The compound represented by the formula (M-1) can be synthesized, for example, by a step of coupling-reacting a compound represented by the formula (M-3) and a compound represented by the formula (9), like in the Suzuki reaction, the Kumada reaction, the Stille reaction, the Negishi reaction and the like. 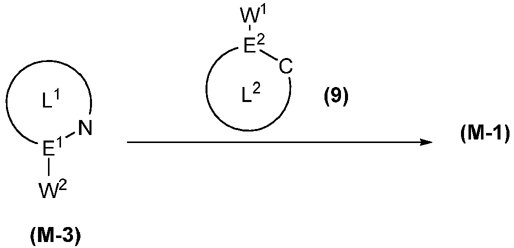 wherein,
E¹, E², Ring L¹ and Ring L² represent the same meaning as described above.

W¹ and W² each independently represent a group represented by -B(OR^{W1})₂, an alkylsulfonyloxy group, a cycloalkylsulfonyloxy group, an arylsulfonyloxy group, a chlorine atom, a bromine atom or an iodine atom, and these groups optionally have a substituent. R^{W1} represents a hydrogen atom, an alkyl group, a cycloalkyl group, an aryl group or an amino group, and these groups optionally have a substituent. A plurality of R^{W1} may be the same or different and may be combined together to form a ring structure together with oxygen atoms to which they are attached.

The group represented by -B(OR^{W1})₂ includes, for example, groups represented by the formula (W-1) to the formula (W-10).

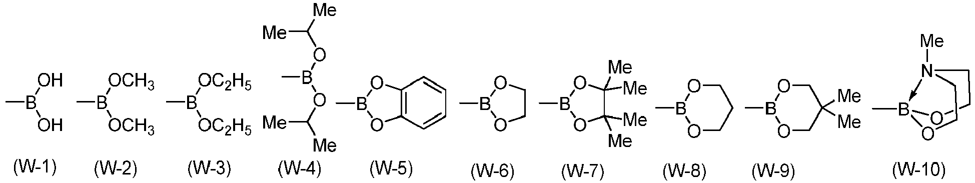

The alkylsulfonyloxy group represented by W¹ and W² includes a methanesulfonyloxy group, an ethanesulfonyloxy group, a trifluoromethanesulfonyloxy group and the like. The arylsulfonyloxy group represented by W¹ and W² includes a p-toluenesulfonyloxy group and the like.

W¹ and W² are each preferably a group represented by -B(OR^{W1})₂, a trifluoromethanesulfonyloxy group, a bromine atom or an iodine atom, and more preferably a group represented by the formula (W-7), since the coupling reaction of a compound represented by the formula (9) with a metal complex represented by the formula (M-3) progresses easily.

The alkylsulfonyloxy group, the cycloalkylsulfonyloxy group and the arylsulfonyloxy group represented by R¹⁶ to R¹⁸ have the same meaning as the alkylsulfonyloxy group, the cycloalkylsulfonyloxy group and the arylsulfonyloxy group represented by W¹ and W², respectively.

These reactions are usually conducted in a solvent. The solvent, the reaction time and the reaction temperature are the same as those explained for the step A and the step B.

In these reactions, the amount of the compound represented by the formula (9) is usually 0.05 to 20 mol, with respect to 1 mol of the compound represented by the formula (M-3).

A compound represented by the formula (11b) or the formula (11c) as a compound represented by the formula (9) can be synthesized, for example, by the following method. 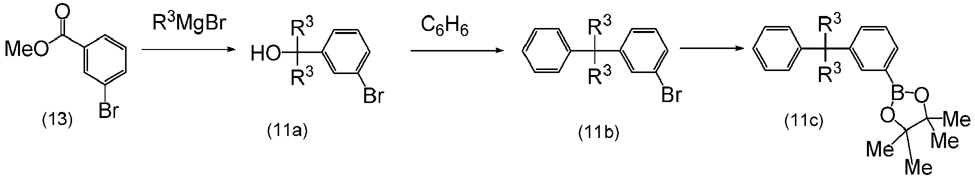 wherein, R³ represents the same meaning as described above.

The compound represented by the formula (11a) can be synthesized, for example, by reacting a compound represented by the formula (13) with a Grignard reagent.

The compound represented by the formula (11b) can be synthesized, for example, by reacting a compound represented by the formula (11a) with benzene.

The compound represented by the formula (11c) can be synthesized, for example, by reacting a compound represented by the formula (11b) with bispinacolatodiboron.

### • Production method 2

The metal complex of the present invention can also be produced, for example, by a method of reacting a precursor of a metal complex with a precursor of a ligand of a metal complex.

The compound represented by the formula (1) can be produced, for example, by coupling-reacting a compound represented by the formula (10) with a metal complex represented by the formula (11). This coupling reaction is the same as that explained for the compound represented by the formula (M-1).

This method may be used to produce the metal complexes represented by formula (1-A) of the present invention. 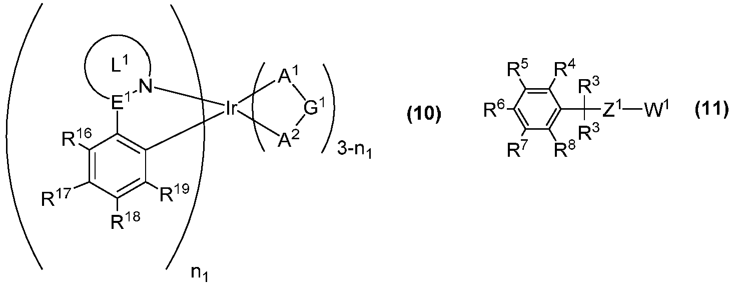 [wherein,
n₁ , A¹, G¹, A², E¹, Ring L¹, R³ to R⁸ and W¹ represent the same meaning as described above.
R¹⁶ to R¹⁸ each independently represent a hydrogen atom, an alkyl group, a cycloalkyl group, an alkoxy group, a cycloalkoxy group, an aryl group, an aryloxy group, a monovalent hetero ring group, a halogen atom, a group represented by -B(OR^{W1})₂ (R^{W1} represents a hydrogen atom, an alkyl group, a cycloalkyl group or an aryl group, and these groups optionally have a substituent. A plurality of R^{W1} may be the same or different and may be combined together to form a ring structure together with oxygen atoms to which they are attached.), an alkylsulfonyloxy group, a cycloalkylsulfonyloxy group or an arylsulfonyloxy group, and these groups optionally have a substituent. At least one of R¹⁶ to R¹⁸ is a group represented by - B(OR^{W1})₂, an alkylsulfonyloxy group, a cycloalkylsulfonyloxy group, an arylsulfonyloxy group, a chlorine atom, a bromine atom or an iodine atom.
R¹⁹ represents a hydrogen atom, an alkyl group, a cycloalkyl group, an alkoxy group, a cycloalkoxy group, an aryl group, an aryloxy group or a monovalent hetero ring group, and these groups optionally have a substituent.
R³ binding to E¹ adjacent to E², and R¹⁶ may be combined to form a ring together with carbon atoms to which E¹ binding to R⁵, and R¹⁶ are bonded. R¹⁶ and R¹⁷ may be combined to form a ring together with carbon atoms to which they are attached, R¹⁷ and R¹⁸ may be combined to form a ring together with carbon atoms to which they are attached, and R¹⁸ and R¹⁹ may be combined to form a ring together with carbon atoms to which they are attached.
Z¹ represents an alkylene group, an arylene group or a divalent hetero ring group, and these groups optionally have a substituent.

A metal complex represented by the formula (10a) or the formula (10c) as an embodiment of the metal complex represented by the formula (10) can be synthesized, for example, from a metal complex represented by the formula (12). 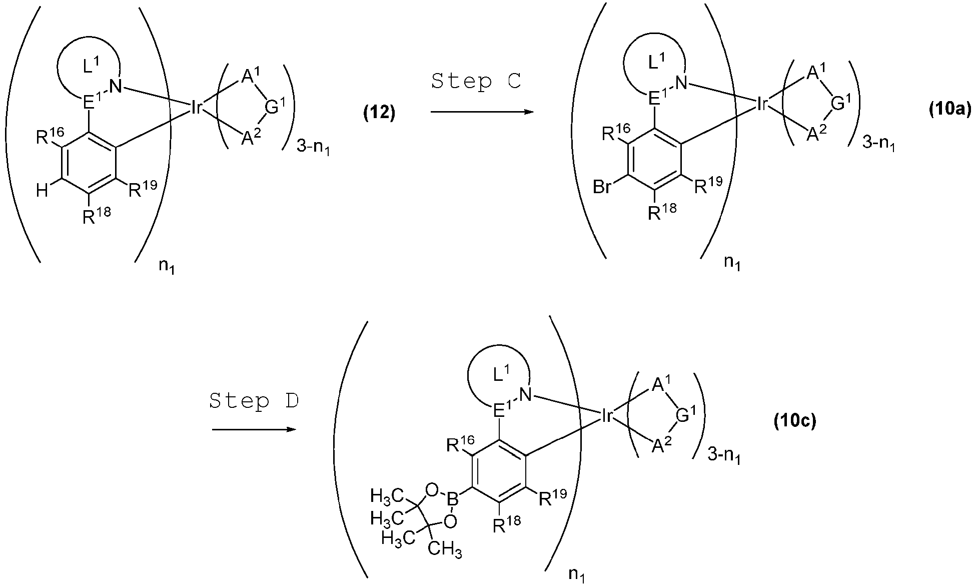 wherein, E¹, Ring L¹, A¹, A², G¹, n₁, R¹⁶, R¹⁸ and R¹⁹ represent the same meaning as described above.

In the step C, the metal complex represented by the formula (10a) can be obtained, for example, by reacting a metal complex represented by the formula (12) with N-bromosuccinimide in an organic solvent.

In the step C, the amount of N-bromosuccinimide is usually 1 to 50 mol with respect to 1 mol of the compound represented by the formula (12).

In the step D, the metal complex represented by the formula (10c) can be obtained, for example, by reacting a compound represented by the formula (10a) with bis(pinacolato)diboron in an organic solvent.

In the step D, the amount of bis(pinacolato)diboron is usually 1 to 50 mol, with respect to 1 mol of the compound represented by the formula (10a).

The step C and the step D are usually conducted in a solvent. The solvent, the reaction time and the reaction temperature are the same as those explained for the step A and the step B.

### • Common explanation for production method 1 and production method 2

In the coupling reaction, catalysts such as palladium catalysts and the like may be used, for promoting the reaction. The palladium catalyst includes palladium acetate, bis(triphenylphosphine)palladium(II) dichloride, tetrakis(triphenylphosphine)palladium(0), [1,1'-bis(diphenylphosphino)ferrocene]dichloropalladium(II), tris(dibenzylideneacetone)dipalladium(0) and the like.

The palladium catalyst may be used together with phosphorus compounds such as triphenylphosphine, tri(o-tolyl)phosphine, tri(tert-butyl)phosphine, tricyclohexylphosphine, 1,1'-bis(diphenylphosphino)ferrocene and the like.

When the palladium catalyst is used in the coupling reaction, its amount is usually effective amount, preferably 0.00001 to 10 mol in terms of a palladium element, for example, with respect to 1 mol of a compound represented by the formula (M-3), the formula (10) or the formula (10a).

In the coupling reaction, a base is used together as required.

The compounds, the catalysts and the solvents used in respective reactions explained in <Production method of metal complex> may each be used singly or in combination of two or more.

### <Composition>

The composition of the present invention comprises the metal complex of the present invention and may further comprise at least one material selected from the group consisting of a hole transporting material, a hole injection material, an electron transporting material, an electron injection material, a light emitting material (different from the metal complex of the present invention), an antioxidant and a solvent.

In the composition of the present invention, the metal complex of the present invention may be contained singly or in combination of two or more.

### [Host material]

If the metal complex of the present invention is used to prepare a composition with a host material having at least one function selected from the group consisting of hole injectability, hole transportability, electron injectability and electron transportability, a light emitting device obtained using the metal complex of the present invention is particularly excellent in external quantum efficiency. In the composition of the present invention, the host material may be contained singly or in combination of two or more.

In a composition comprising the metal complex of the present invention and a host material, the content the metal complex of the present invention is usually 0.05 to 80 parts by weight, preferably 0.1 to 50 parts by weight, and more preferably 0.5 to 40 parts by weight, when the sum of the metal complex of the present invention and the host material is taken as 100 parts by weight.

It is preferable that the lowest excited triplet state (T₁) of the host material has energy level equivalent to or higher than T₁ of the metal complex of the present invention, since a light emitting device obtained using the composition of the present invention is excellent in external quantum efficiency.

The host material is preferably one showing solubility in a solvent which is capable of dissolving the metal complex of the present invention, since a light emitting device obtained using the composition of the present invention can be fabricated by a solution application process.

The host material is classified into low molecular weight compounds and polymer compounds, and the low molecular weight compound being preferred.

### • Low molecular weight host

The low molecular weight compound which is preferred as the host material (hereinafter, referred to as "low molecular weight host") will be explained.

The low molecular weight host is preferably a compound represented by the above-described formula (H-1) .

Ar^{H1} and Ar^{H2} are each preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the formula (TDA-1) or (TDA-3), and especially preferably a group represented by the formula (TDA-3), and these groups optionally have a substituent.

The substituent which Ar^{H1} and Ar^{H2} optionally have is preferably a halogen atom, an alkyl group, a cycloalkyl group, an alkoxy group, a cycloalkoxy group, an aryl group or a monovalent hetero ring group, and these groups optionally further have a substituent.

n^{H1} is preferably 1. n^{H2} is preferably 0.

n^{H3} is an integer of 0 or more and preferably 10 or less, preferably an integer of 1 or more and 3 or less, and more preferably 1.

L^{H1} is preferably an arylene group or a divalent hetero ring group, more preferably a group represented by the formula (A-1) to the formula (A-3), the formula (A-8) to the formula (A-10), the formula (AA-1) to the formula (AA-6), the formula (AA-10) to the formula (AA-21) or the formula (AA-24) to the formula (AA-34), further preferably a group represented by the formula (A-1), the formula (A-2), the formula (AA-2), the formula (AA-4), the formula (AA-14) or the formula (AA-15), and particularly preferably a group represented by the formula (AA-14) or the formula (AA-15).

The substituent which L^{H1} optionally has is preferably a halogen atom, an alkyl group, a cycloalkyl group, an alkoxy group, a cycloalkoxy group, an aryl group or a monovalent hetero ring group, and these groups optionally further have a substituent.

The compound represented by the formula (H-1) is preferably a compound represented by the formula (H-2). 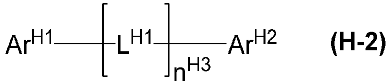 [wherein, Ar^{H1}, Ar^{H2}, n^{H3} and L^{H1} represent the same meaning as described above.]

As the compound represented by the formula (H-1), compounds represented by the formula (H-101) to the formula (H-118) are exemplified.

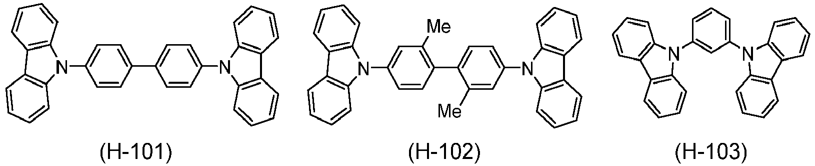

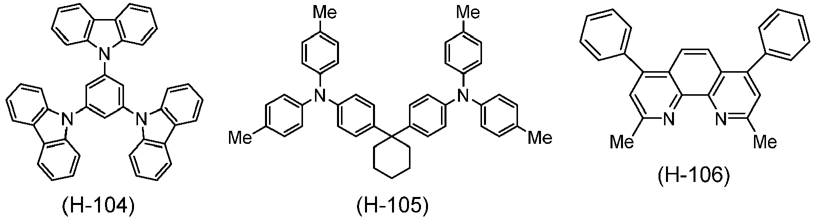

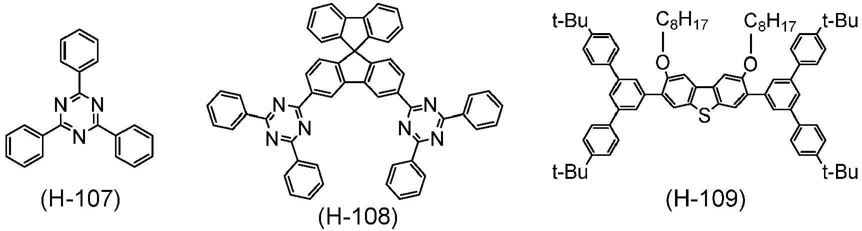

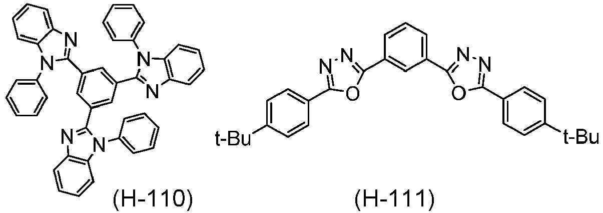

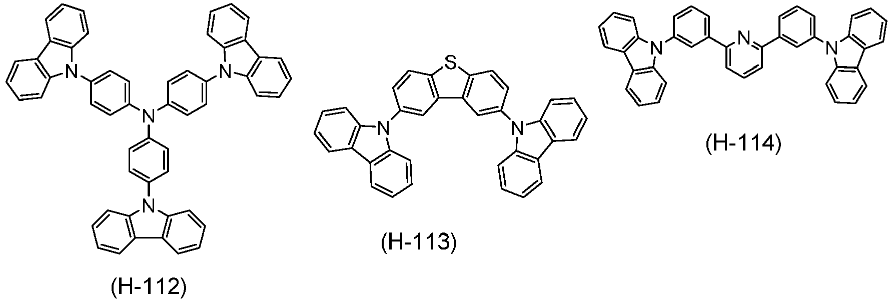

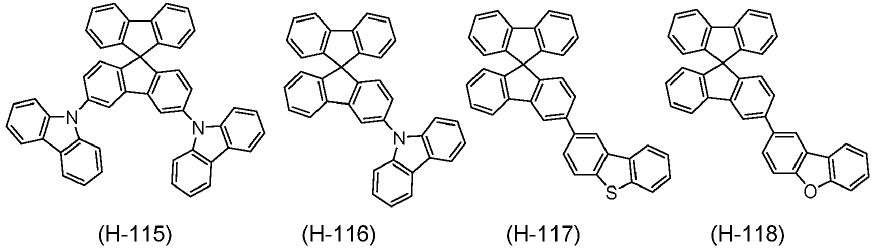

### • Polymer host

The polymer compound which is preferred as the host compound (hereinafter, referred to as "polymer host") will be explained.

The polymer host is, for example, a polymer compound as a hole transporting material described later, or a polymer compound as an electron transporting material described later, and preferably a polymer compound containing a constitutional unit represented by the above-described the formula (Y).

The arylene group represented by Ar^{Y1} is more preferably a group represented by the formula (A-1), the formula (A-2), the formula (A-6) to the formula (A-10), the formula (A-19) or the formula (A-20), and further preferably a group represented by the formula (A-1), the formula (A-2), the formula (A-7), the formula (A-9) or the formula (A-19), and these groups optionally have a substituent.

The divalent hetero ring group represented by Ar^{Y1} is more preferably a group represented by the formula (AA-1) to the formula (AA-4), the formula (AA-10) to the formula (AA-15), the formula (AA-18) to the formula (AA-21), the formula (AA-33) or the formula (AA-34), and further preferably a group represented by the formula (AA-4), the formula (AA-10), the formula (AA-12), the formula (AA-14) or the formula (AA-33), and these groups optionally have a substituent.

In the divalent group represented by Ar^{Y1} in which an arylene group and a divalent hetero ring group are bonded directly, the more preferable ranges and further preferable ranges of the arylene group and the divalent hetero ring group are the same as the more preferable ranges and further preferable ranges of the arylene group and the divalent hetero ring group represented by Ar^{Y1} described above, respectively.

"The divalent group in which an arylene group and a divalent hetero ring group are bonded directly" includes, for example, groups represented by the following formulae, and these groups optionally have a substituent. 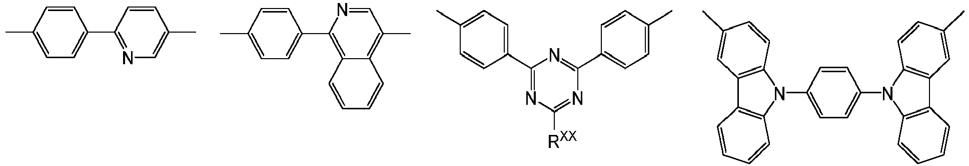 [wherein, R^{XX} represents a hydrogen atom, an alkyl group, a cycloalkyl group, an aryl group or a monovalent hetero ring group, and these groups optionally have a substituent.]

R^{XX} is preferably an alkyl group, a cycloalkyl group or an aryl group, and these groups optionally have a substituent.

The substituent which a group represented by Ar^{Y1} optionally has is preferably an alkyl group, a cycloalkyl group or an aryl group, and these groups optionally further have a substituent.

The constitutional unit represented by the formula (Y) includes, for example, constitutional units represented by the formula (Y-1) to the formula (Y-10). 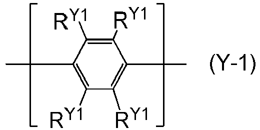 [wherein, R^{Y1} represents a hydrogen atom, an alkyl group, a cycloalkyl group, an alkoxy group, a cycloalkoxy group, an aryl group or a monovalent hetero ring group, and these groups optionally have a substituent. A plurality of R^{Y1} may be the same or different, and adjacent R^{Y1} may be combined together to form a ring together with carbon atoms to which they are attached.]

R^{Y1} is preferably a hydrogen atom, an alkyl group, a cycloalkyl group or an aryl group, and these groups optionally have a substituent.

The constitutional unit represented by the formula (Y-1) is preferably a constitutional unit represented by the formula (Y-1'). 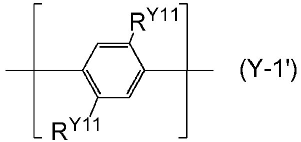 [wherein, R^{Y11} represents an alkyl group, a cycloalkyl group, an alkoxy group, a cycloalkoxy group, an aryl group or a monovalent hetero ring group, and these groups optionally have a substituent. A plurality of R^{Y11} may be the same or different.]

R^{Y11} is preferably an alkyl group, a cycloalkyl group or an aryl group, and these groups optionally have a substituent. 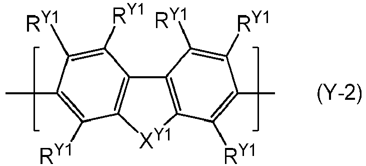 [wherein,
R^{Y1} represent the same meaning as described above.
X^{Y1} represents a group represented by -C(R^{Y2})₂-, - C(R^{Y2})=C(R^{Y2})- or C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent hetero ring group, and these groups optionally have a substituent. A plurality of R^{Y2} may be the same or different, and R^{Y2} may be combined together to form a ring together with carbon atoms to which they are attached.]

R^{Y2} is preferably an alkyl group, a cycloalkyl group, an aryl group or a monovalent hetero ring group, and these groups optionally have a substituent.

In X^{Y1}, the combination of two groups R^{Y2} in the group represented by -C(R^{Y2})₂- is preferably a combination in which both represent an alkyl group or a cycloalkyl group, both represent an aryl group, both represent a monovalent hetero ring group, or one represents an alkyl group or a cycloalkyl group and the other represents an aryl group or a monovalent hetero ring group, more preferably a combination in which one represents an alkyl group or a cycloalkyl group and the other represents an aryl group, and these groups optionally have a substituent. Two groups R^{Y2} may be combined together to form a ring together with atoms to which they are attached, and when R^{Y2} forms a ring, the group represented by -C(R^{Y2})₂- is preferably a group represented by the formula (Y-A1) to the formula (Y-A4), and these groups optionally have a substituent.

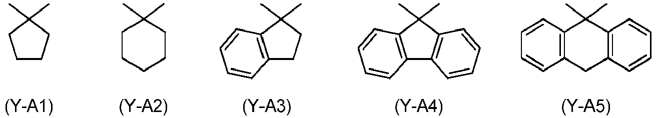

In X^{Y1}, the combination of two groups R^{Y2} in the group represented by -C(R^{Y2})=C(R^{Y2})- is preferably a combination in which both represent an alkyl group or a cycloalkyl group, or one represents an alkyl group or a cycloalkyl group and the other represents an aryl group, and these groups optionally have a substituent.

In X^{Y1}, four groups R^{Y2} in the group represented by -C(R^{Y2})₂-C(R^{Y2})₂- represent preferably an alkyl group or a cycloalkyl group optionally having a substituent. A plurality of R^{Y2} may be combined together to form a ring together with atoms to which they are attached, and when R^{Y2} forms a ring, the group represented by - C(R^{Y2})₂-C(R^{Y2})₂- is preferably a group represented by the formula (Y-B1) to the formula (Y-B5), and these groups optionally have a substituent. 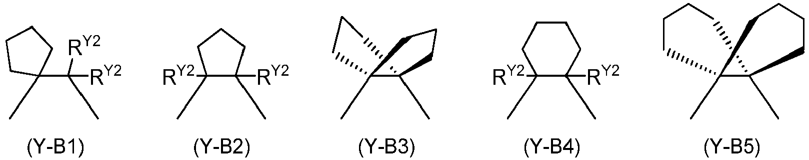 [wherein, R^{Y2} represents the same meaning as described above.]

The constitutional unit represented by the formula (Y-2) is preferably a constitutional unit represented by the formula (Y-2'). 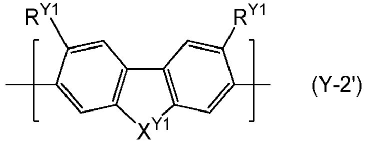 [wherein, R^{Y1} and X^{Y1} represent the same meaning as described above.] 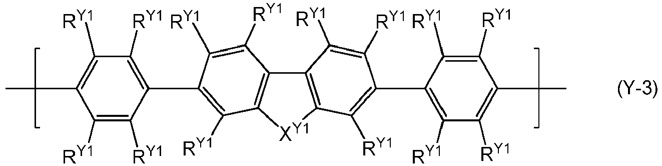 [wherein, R^{Y1} and X^{Y1} represent the same meaning as described above.]

The constitutional unit represented by the formula (Y-3) is preferably a constitutional unit represented by the formula (Y-3'). 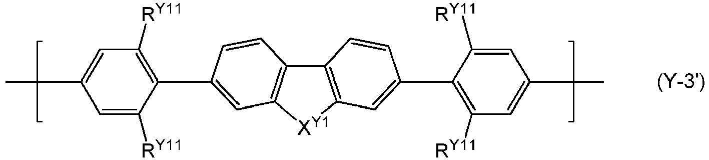 [wherein, R^{Y11} and X^{Y1} represent the same meaning as described above.] 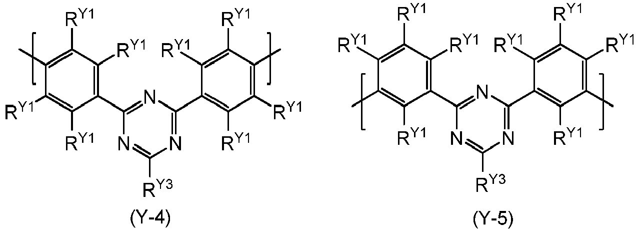 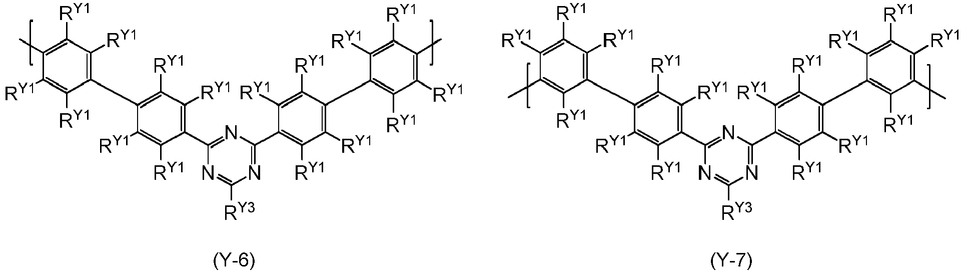 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent hetero ring group, and these groups optionally have a substituent.]

R^{Y3} is preferably an alkyl group, a cycloalkyl group, an alkoxy group, a cycloalkoxy group, an aryl group or a monovalent hetero ring group, and these groups optionally have a substituent.

The constitutional unit represented by the formula (Y-4) is preferably a constitutional unit represented by the formula (Y-4'), and the constitutional unit represented by the formula (Y-6) is preferably a constitutional unit represented by the formula (Y-6'). 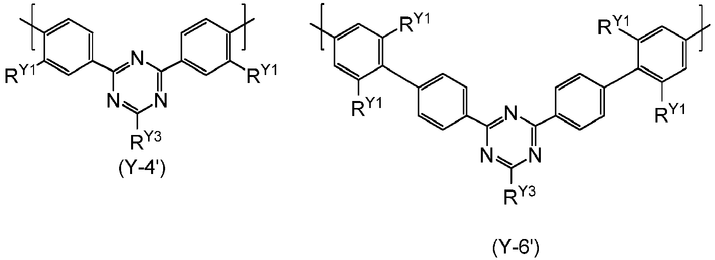 [wherein, R^{Y1} and R^{Y3} represent the same meaning as described above.] 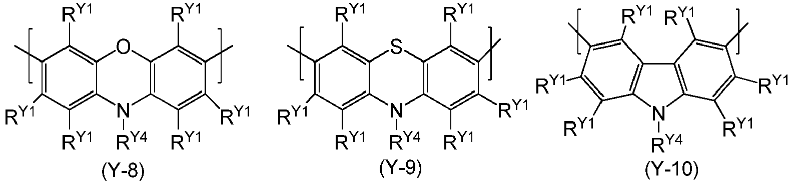 [wherein,
R^{Y1} represents the same meaning as described above.
R^{Y4} represents a hydrogen atom, an alkyl group, a cycloalkyl group, an alkoxy group, a cycloalkoxy group, an aryl group or a monovalent hetero ring group, and these groups optionally have a substituent.]

R^{Y4} is preferably an alkyl group, a cycloalkyl group, an alkoxy group, a cycloalkoxy group, an aryl group or a monovalent hetero ring group, and these groups optionally have a substituent.

The constitutional unit represented by the formula (Y) includes, for example, constitutional units composed of an arylene group represented by the formula (Y-101) to the formula (Y-121), constitutional units composed of a divalent hetero ring group represented by the formula (Y-201) to the formula (Y-206), and constitutional units composed of a divalent group in which an arylene group and a divalent hetero ring group are bonded directly represented by the formula (Y-301) to the formula (Y-304).

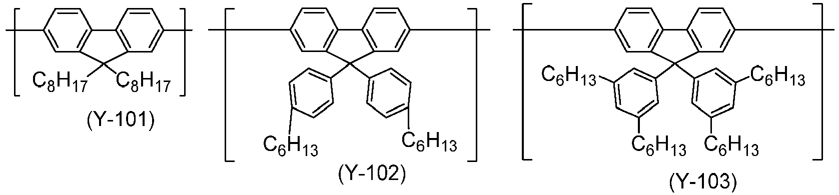

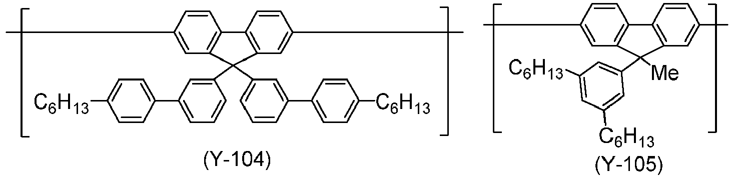

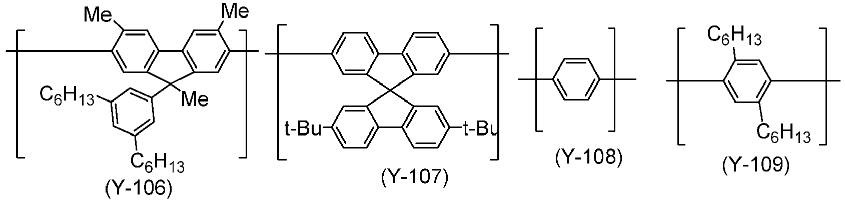

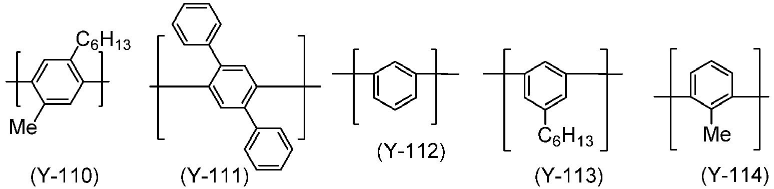

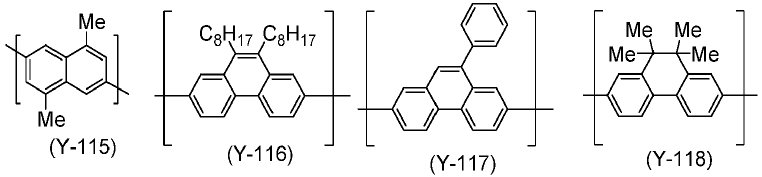

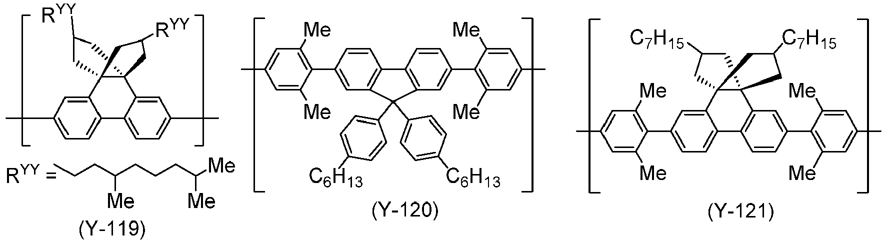

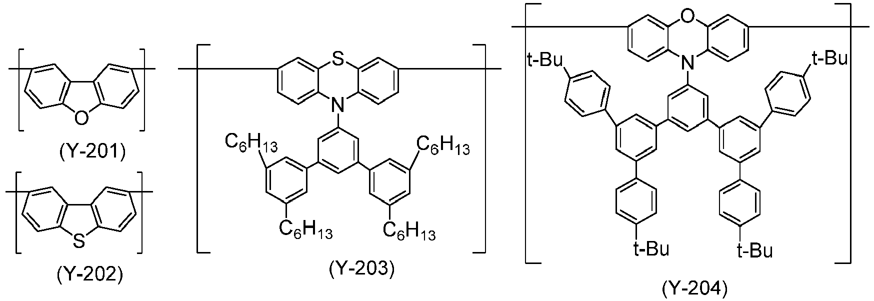

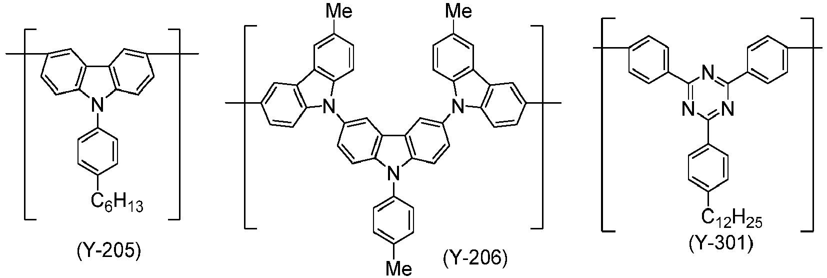

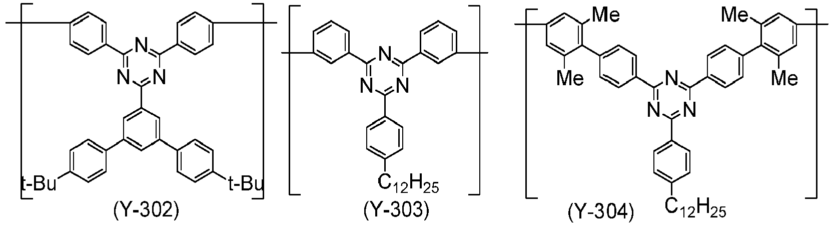

The amount of the constitutional unit represented by the formula (Y) in which Ar^{Y1} is an arylene group is preferably 0.5 to 80% by mol, and more preferably 30 to 60% by mol, with respect to the total amount of constitutional units contained in the polymer compound, since the external quantum efficiency of a light emitting device using a composition composed of a polymer host and the metal complex of the present invention is excellent.

The amount of the constitutional unit represented by the formula (Y) in which Ar^{Y1} is a divalent hetero ring group, or a divalent group in which an arylene group and a divalent hetero ring group are bonded directly is preferably 0.5 to 30% by mol, and more preferably 3 to 20% by mol, with respect to the total amount of constitutional units contained in the polymer compound, since the charge transportability of a light emitting device using a composition composed of a polymer host and the metal complex of the present invention is excellent.

The constitutional unit represented by the formula (Y) may be contained only singly or in combination of two or more in the polymer host.

It is preferable that the polymer host further contains a constitutional unit represented by the formula (X), since hole transportability is excellent. 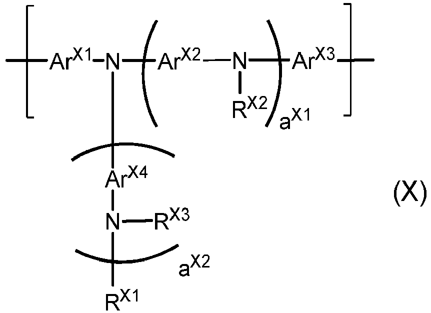 [wherein,
a^{X1} and a^{X2} each independently represent an integer of 0 or more.
Ar^{X1} and Ar^{X3} each independently represent an arylene group or a divalent hetero ring group, and these groups optionally have a substituent.
Ar^{X2} and Ar^{X4} each independently represent an arylene group, a divalent hetero ring group, or a divalent group in which one type of an arylene group and a divalent hetero ring group are bonded directly, and these groups optionally have a substituent. When a plurality of Ar^{X2} and Ar^{X4} are present, they may be the same or different at each occurrence.
R^{X1} to R^{X3} each independently represent a hydrogen atom, an alkyl group, a cycloalkyl group, an aryl group or a monovalent hetero ring group, and these groups optionally have a substituent. When a plurality of R^{X2} and R^{X3} are present, they may be the same or different at each occurrence.]
a^{X1} is preferably 2 or less, and more preferably 1, since a light emitting device using a composition composed of a polymer host and the metal complex of the present invention is excellent in external quantum efficiency.
a^{X2} is preferably 2 or less, and more preferably 0, since a light emitting device using a composition composed of a polymer host and the metal complex of the present invention is excellent in external quantum efficiency.

R^{X1} to R^{X3} are each preferably an alkyl group, a cycloalkyl group, an aryl group or a monovalent hetero ring group, and more preferably an aryl group, and these groups optionally have a substituent.

The arylene group represented by Ar^{X1} and Ar^{X3} is more preferably a group represented by the formula (A-1) or the formula (A-9), and further preferably a group represented by the formula (A-1), and these groups optionally have a substituent.

The divalent hetero ring group represented by Ar^{X1} and Ar^{X3} is more preferably a group represented by the formula (AA-1), the formula (AA-2) or the formula (AA-7) to the formula (AA-26), and these groups optionally have a substituent.

Ar^{X1} and Ar^{X3} are each preferably an arylene group optionally having a substituent.

The arylene group represented by Ar^{X2} and Ar^{X4} is more preferably a group represented by the formula (A-1), the formula (A-6), the formula (A-7), the formula (A-9) to the formula (A-11) or the formula (A-19), and these groups optionally have a substituent.

The more preferable ranges of the divalent hetero ring group represented by Ar^{X2} and Ar^{X4} are the same as the more preferable ranges of the divalent hetero ring group represented by Ar^{X1} and Ar^{X3}.

The more preferable ranges and further preferable ranges of the arylene group and the divalent hetero ring group in the divalent group in which an arylene group and a divalent hetero ring group are bonded directly represented by Ar^{X2} and Ar^{X4} are the same as the more preferable ranges and further preferable ranges of the arylene group and the divalent hetero ring group represented by Ar^{X1} and Ar^{X3}, respectively.

The divalent group in which an arylene group and a divalent hetero ring group are bonded directly represented by Ar^{X2} and Ar^{X4} includes those that are the same as the divalent group in which an arylene group and a divalent hetero ring group are bonded directly represented by Ar^{Y1} in the the formula (Y).

Ar^{X2} and Ar^{X4} are each preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups optionally further have a substituent.

The constitutional unit represented by the formula (X) includes, for example, constitutional units represented by the formulae (X1-1) to (X1-11).

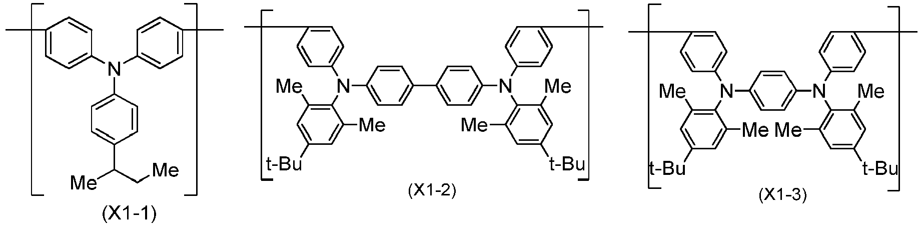

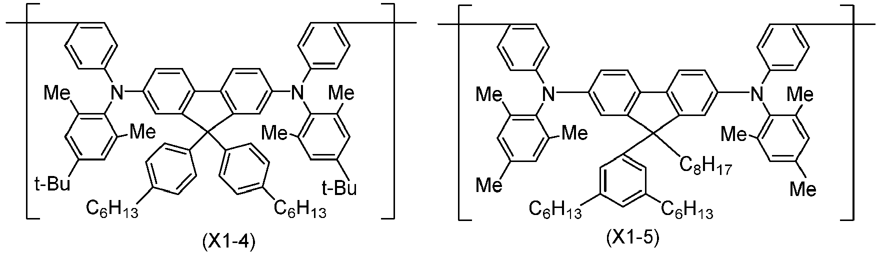

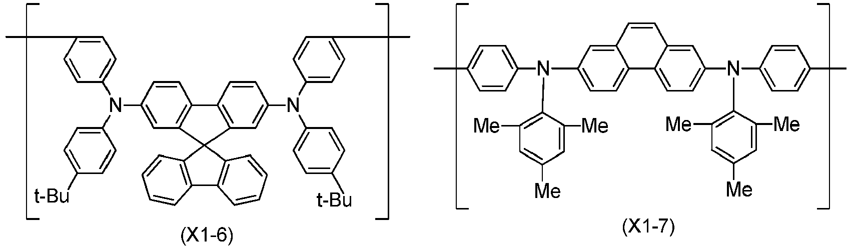

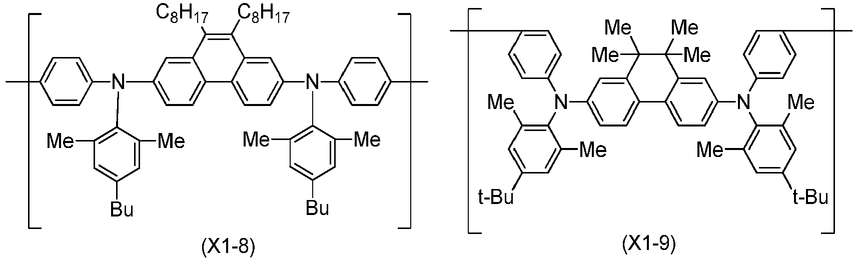

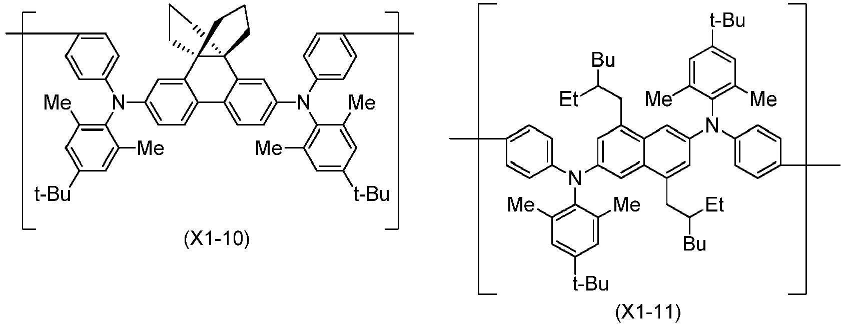

In the polymer host, the constitutional unit represented by the formula (X) may be contained only singly or in combination of two or more.

The polymer host includes, for example, polymer compounds (P-1) to (P-6) in Table 1. "Other" constitutional unit denotes a constitutional unit other than the constitutional unit represented by the formula (Y) and the constitutional unit represented by the formula (X).

**[Table 1]**

| polymer compound | constitutional unit and its molar ratio | | | | |
|---|---|---|---|---|---|
| | formula (Y) | | | formula (X) | other |
| | (Y-1)-(Y-3) | (Y-4)-(Y-7) | (Y-8)-(Y-10) | (X-1) - (X-7) | |
| | P | q | r | s | t |
| (P-1) | 0.1-99.9 | 0.1-99.9 | 0 | 0 | 0-30 |
| (P-2) | 0.1-99.9 | 0 | 0.1-99.9 | 0 | 0-30 |
| (P-3) | 0.1-99.8 | 0.1-99.8 | 0 | 0.1-99.8 | 0-30 |
| (P-4) | 0.1-99.8 | 0.1-99.8 | 0.1-99.8 | 0 | 0-30 |
| (P-5) | 0.1-99.8 | 0 | 0.1-99.8 | 0.1-99.8 | 0-30 |
| (P-6) | 0.1-99.7 | 0.1-99.7 | 0.1-99.7 | 0.1-99.7 | 0-30 |

[in the table, p, q, r, s and t represent the molar ratio of each constitutional unit. p+q+r+s+t = 100 and 100 ≥ p+q+r+s ≥ 70.]

The polymer host may be any of a block copolymer, a random copolymer, an alternating copolymer and a graft copolymer, and may also be another form, and is preferably a copolymer obtained by copolymerizing multiple types of raw material monomers.

The polymer host can be produced using known polymerization methods described in Chemical Review (Chem. Rev.), vol. 109, pp. 897 to 1091 (2009) and the like. As the known polymerization method, methods of polymerizing by a coupling reaction using a transition metal catalyst such as the Suzuki reaction, the Yamamoto reaction, the Buchwald reaction, the Stille reaction, the Negishi reaction, the Kumada reaction and the like are exemplified.

A composition comprising the metal complex of the present invention and a solvent (hereinafter, referred to as "ink") is suitable for fabrication of a light emitting device using a printing method such as an inkjet printing method, a nozzle printing method and the like.

The viscosity of the ink may be adjusted according to the type of the printing method, and when applied to printing methods in which a solution passes through a discharge device such as an inkjet printing method and the like, the viscosity is preferably 1 to 20 mPa·s at 25°C since clogging and flight deflection during discharge scarcely occur.

The solvent contained in the ink includes, for example, chlorine-based solvents such as 1,2-dichloroethane, 1,1,2-trichloroethane, chlorobenzene, o-dichlorobenzene and the like; ether solvents such as THF, dioxane, anisole, 4-methylanisole and the like; aromatic hydrocarbon solvents such as toluene, xylene, mesitylene, ethylbenzene, n-hexylbenzene, cyclohexylbenzene and the like; aliphatic hydrocarbon solvents such as cyclohexane, methylcyclohexane, n-pentane, n-hexane, n-heptane, n-octane, n-nonane, n-decane, n-dodecane, bicyclohexyl and the like; ketone solvents such as acetone, methyl ethyl ketone, cyclohexanone, acetophenone and the like; ester solvents such as ethyl acetate, butyl acetate, ethyl cellosolve acetate, methyl benzoate, phenyl acetate and the like; polyhydric alcohol solvents such as ethylene glycol, glycerin, 1,2-hexanediol and the like; alcohol solvents such as isopropyl alcohol, cyclohexanol and the like; sulfoxide solvents such as dimethyl sulfoxide and the like; and amide solvents such as N-methyl-2-pyrrolidone, N,N-dimethylformamide and the like. The solvent may be used singly or in combination of two or more.

In the ink, the compounding amount of the solvent is usually 1000 to 100000 parts by weight, and preferably 2000 to 20000 parts by weight, with respect to 100 parts by weight of the metal complex of the present invention.

### [Hole transporting material]

The hole transporting material is classified into low molecular weight compounds and polymer compounds, and polymer compounds are preferable, and polymer compounds having a cross-linkable group are more preferable.

The polymer compound includes, for example, polyvinylcarbazole and derivatives thereof; and polyarylnene having an aromatic amine structure in the side chain or main chain and derivatives thereof. The polymer compound may be a compound to which an electron accepting site is bonded. The electron accepting site includes, for example, fullerene, tetrafluorotetracyanoquinodimethane, tetracyanoethylene, trinitrofluorenone and the like, preferably fullerene.

The compounding amount of a hole transporting material is usually 1 to 400 parts by weight, with respect to 100 parts by weight of the metal complex of the present invention.

The hole transporting material may be used singly or in combination of two or more.

### [Electron transporting material]

The electron transporting material is classified into low molecular weight compounds and polymer compounds. The electron transporting material may have a cross-linkable group.

The low molecular weight compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

The compounding amount of an electron transporting material is usually 1 to 400 parts by weight, with respect to 100 parts by weight of the metal complex of the present invention.

The electron transporting material may be used singly or in combination of two or more.

### [Hole injection material and electron injection material]

The hole injection material and the electron injection material are each classified into low molecular weight compounds and polymer compounds. The hole injection material and the electron injection material may have a cross-linkable group.

The low molecular weight compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes electrically conductive polymers such as, for example, polyaniline, polythiophene, polypyrrole, polyphenylenevinylene, polythienylenevinylene, polyquinoline and polyquinoxaline, and derivatives thereof; a polymer containing an aromatic amine structure in the main chain or side chain, and the like.

The compounding amount of a hole injection material and an electron injection material is each usually 1 to 400 parts by weight, with respect to 100 parts by weight of the metal complex of the present invention.

The electron injection material and the hole injection material each may be used singly or in combination of two or more.

### [Ion doping]

When the hole injection material or the electron injection material contains an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with an appropriate amount of ions.

The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more.

### [Light emitting material]

The light emitting material (different from the metal complex of the present invention) is classified into low molecular weight compounds and polymer compounds. The light emitting material may have a cross-linkable group.

The low molecular weight compound includes, for example, naphthalene and derivatives thereof, anthracene and derivatives thereof, perylene and derivatives thereof, and triplet light emitting complexes having iridium, platinum or europium as the central metal.

The polymer compound includes polymer compounds containing, for example, a phenylene group, a naphthalenediyl group, a fluorenediyl group, a phenanthrenedilyl group, a dihydrophenanthrenedilyl group, a group represented by the formula (X), a carbazolediyl group, a phenoxazinediyl group, a phenothiazinediyl group, an anthracenediyl group, a pyrenediyl group and the like.

The light emitting material preferably contains a triplet light emitting complex and a polymer compound.

The triplet light emitting complex includes, for example, metal complexes shown below.

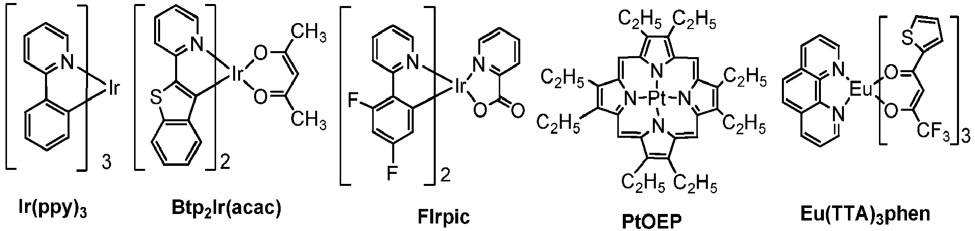

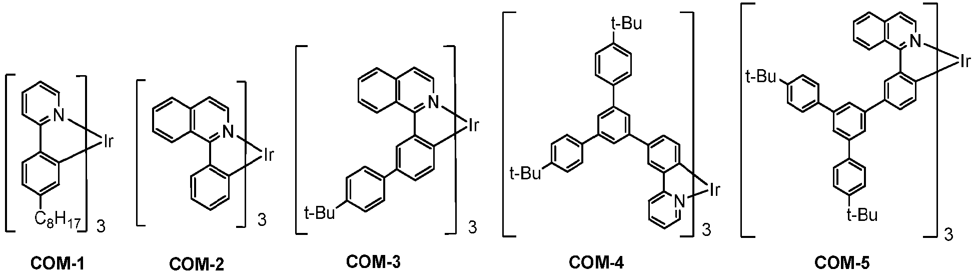

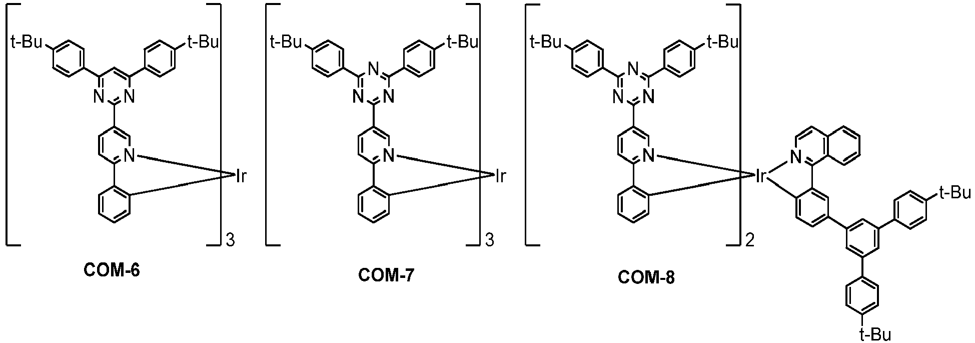

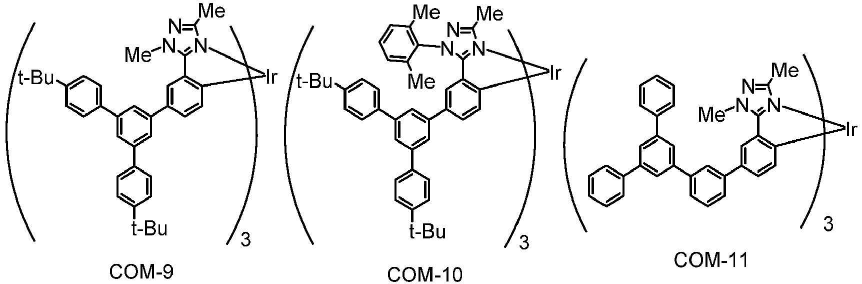

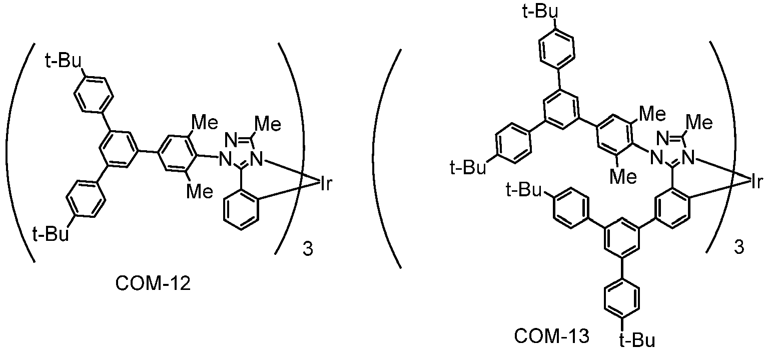

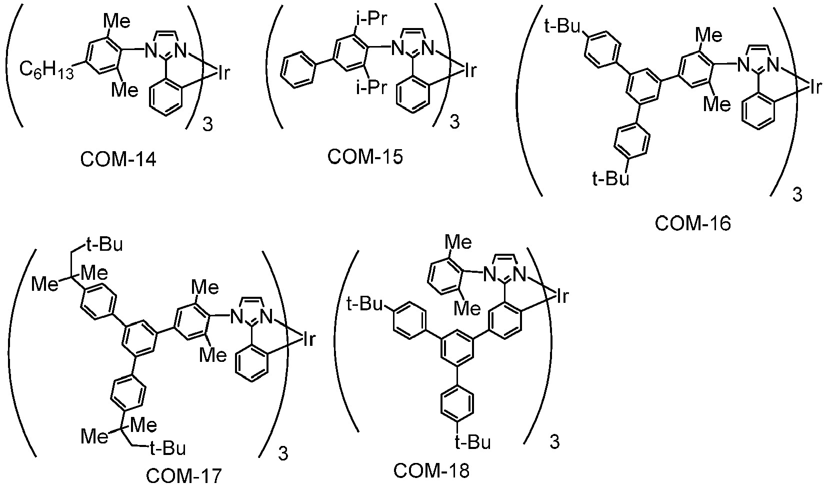

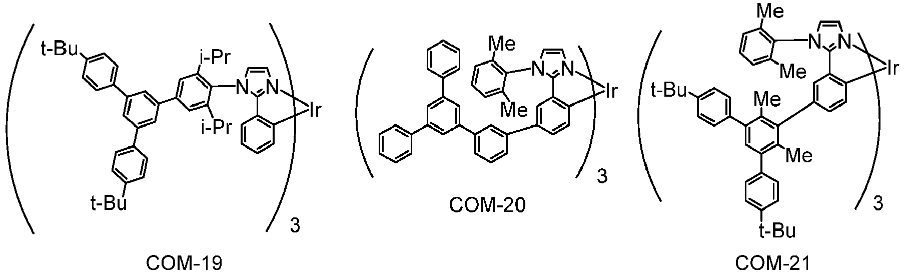

The content of a light emitting material is usually 0.1 to 400 parts by weight, with respect to 100 parts by weight of the metal complex of the present invention.

### [Antioxidant]

The antioxidant may be a compound which is soluble in a solvent which is the same as the solvent for the metal complex of the present invention and does not inhibit light emission and charge transportation, and includes, for example, phenol type antioxidants and phosphorus-based antioxidants.

The compounding amount of the antioxidant is usually 0.001 to 10 parts by weight, with respect to 100 parts by weight of the metal complex of the present invention.

The antioxidant may be used singly or in combination of two or more.

### <Film>

The film contains the metal complex of the present invention, and is suitable as a light emitting layer in a light emitting device.

The film can be fabricated by, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method or a nozzle coat method, using an ink.

The thickness of the film is usually 1 nm to 10 µm.

### <Light emitting device>

The light emitting device of the present invention comprises the metal complex of the present invention or the composition of the present invention.

The constitution of the light emitting device of the present invention has, for example, electrodes consisting of an anode and a cathode, and a layer containing the metal complex of the present invention or the composition of the present invention disposed between the electrodes.

Further, the light emitting device has a light emitting layer between an anode and a cathode. The light emitting device may have layers other than the light emitting layer (including, for example, a hole transporting layer, a hole injection layer, an electron transporting layer and an electron injection layer).

In the light emitting device of the present invention, the metal complex of the present invention or the composition of the present invention may be used singly or in combination of two or more.

### [Layer constitution]

The layer containing the metal complex of the present invention or the composition of the present invention is usually one or more of a light emitting layer, a hole transporting layer, a hole injection layer, an electron transporting layer and an electron injection layer, and preferably is a light emitting layer. These layers contain a light emitting material, a hole transporting material, a hole injection material, an electron transporting material and an electron injection material, respectively. These layers can be formed by dissolving a light emitting material, a hole transporting material, a hole injection material, an electron transporting material and an electron injection material in the solvent described above to prepare inks, respectively, and using the same method as for fabrication of the film described above.

The materials of a hole transporting layer, an electron transporting layer, a light emitting layer, a hole injection layer and an electron injection layer include the hole transporting material, the electron transporting material, the light emitting material, the hole injection material and the electron injection material and the like described above, respectively, in addition to the metal complex of the present invention.

When the material of a hole transporting layer, the material of an electron transporting layer and the material of a light emitting layer are soluble in a solvent used in forming layers adjacent to the hole transporting layer, the electron transporting layer and the light emitting layer, respectively, in fabricating a light emitting device, it is preferable that the material has a cross-linkable group for avoiding the material from being dissolved in the solvent. After forming each layer using the material having a cross-linkable group, the cross-linkable group can be crosslinked to insolubilize the layer.

The method for forming each layer such as a light emitting layer, a hole transporting layer, an electron transporting layer, a hole injection layer, an electron injection layer and the like in a light emitting device of the present invention includes, for example, a vacuum vapor deposition method from a powder and a method by film formation from a solution or melted state when a low molecular weight compound is used, and includes, for example, a method by film formation from a solution or melted state when a polymer compound is used.

The order, number and thickness of layers to be laminated are adjusted in consideration of external quantum efficiency and luminance life.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; argentine-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of one of them and one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode each may take a laminated structure composed of two or more layers.

### [Application]

The light emitting device of the present invention may be suitable for, for example, applications of display and illumination.

### EXAMPLES

The present invention will be illustrated further in detail by examples below.

In examples, the polystyrene-equivalent number-average molecular weight (Mn) and the polystyrene-equivalent weight-average molecular weight (Mw) of a polymer compound were determined by size exclusion chromatography (SEC) using tetrahydrofuran as a mobile phase. The measurement conditions of SEC are as follows.

### <Measurement condition 1 (Measurement of precursor of compound ETL-1)>

The polymer compound to be measured was dissolved at a concentration of about 0.05% by weight in tetrahydrofuran, and 10 µL of the solution was injected into SEC. The mobile phase was flowed at a flow rate of 1.0 ml/min. As the column, PLgel MIXED-B (manufactured by Polymer Laboratories, Ltd.) was used. As the detector, a UV-VIS detector (manufactured by Tosoh Corp., trade name: UV-8320GPC) was used.

### <Measurement condition 2 (Measurement of compound HTL-1)>

The polymer compound to be measured was dissolved at a concentration of about 0.05% by weight in tetrahydrofuran, and 10 µL of the solution was injected into SEC. The mobile phase was flowed at a flow rate of 0.6 ml/min. As the column, each one column of TSKguardcolumn SuperAW-H, TSKgel Super AWM-H and TSKgel SuperAW3000 (all are manufactured by Tosoh Corp.) were connected in series and used. As the detector, a UV-VIS detector (manufactured by Tosoh Corp., trade name: UV-8320GPC) was used.

LC-MS was measured by the following method.

The measurement sample was dissolved in chloroform or tetrahydrofuran to a concentration of about 2 mg/mL, and about 1 µL of the solution was injected into LC-MS (manufactured by Agilent, trade name: 1290 Infinity LC and 6230 TOF LC/MS). As the mobile phase of LC-MS, acetonitrile and tetrahydrofuran were flowed at a flow rate of 1.0 ml/min while changing the ratio thereof.

As the column, SUMIPAX ODS Z-CLUE (manufactured by Sumika Chemical Analysis Service, Ltd., internal diameter: 4.6 mm, length: 250 mm, particle size: 3 um) was used.

TLC-MS was measured by the following method.

The measurement sample was dissolved in any solvent of toluene, tetrahydrofuran or chloroform at an arbitrary concentration, and the solution was applied on a TLC plate for DART (manufactured by Techno Applications, trade name: YSK5-100), and it was measured using TLC-MS (manufactured by JEOL Ltd., trade name: JMS-T100TD (The AccuTOF TLC)). The temperature of a helium gas in measurement was adjusted in the range of 200 to 400°C.

NMR was measured by the following method.

Five to ten milligrams (5 to 10 mg) of measurement sample was dissolved in about 0.5 mL of heavy chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol or heavy methylene chloride, and NMR was measured using an NMR apparatus (manufactured by Agilent, trade name: INOVA300, or manufactured by JEOL RESONANCE, trade name: JNM-ECZ400S/L1).

As the index of the purity of a compound, the value of high performance liquid chromatography (HPLC) area percentage was used. This value is a value at UV = 254 nm by HPLC (manufactured by Shimadzu Corp., trade name: LC-20A), unless otherwise specified. In this procedure, the compound to be measured was dissolved in tetrahydrofuran or chloroform so as to be a concentration of 0.01 to 0.2% by weight, and 1 to 10 µL of the solution was injected into HPLC depending on the concentration. As the mobile phase of HPCL, acetonitrile and tetrahydrofuran were flowed at a flow rate of 1.0 mL/min while changing the ratio of acetonitrile/tetrahydrofuran from 100/0 to 0/100 (volume ratio). As the column, SUMIPAX ODS Z-CLUE (manufactured by Sumika Chemical Analysis Service, Ltd., internal diameter: 4.6 mm, length: 250 mm, particle diameter: 3 µm) or an ODS column having the equivalent performance was used. As the detector, a photo diode array detector (manufactured by Shimadzu Corp., trade name: SPD-M20A) was used.

### <Example 1> Synthesis of compound S1

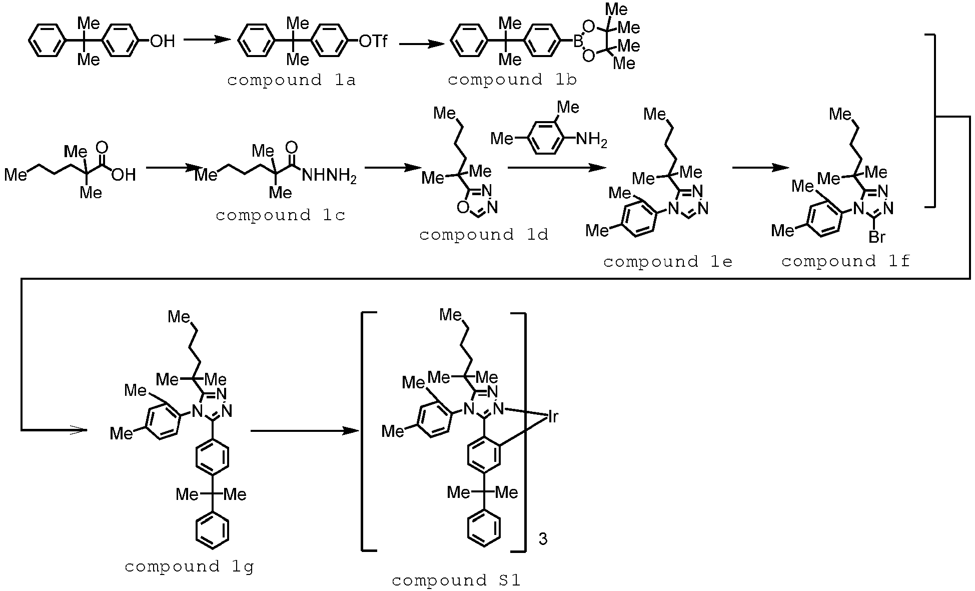

A nitrogen gas atmosphere was prepared in a reaction vessel, then, cumylphenol (50.0 g), pyridine (55.9 g), dichloromethane (250 mL) and N,N-dimethyl-4-aminopyridine (6.3 g) were added, and the mixture was stirred. Thereafter, the reaction vessel was cooled using an ice bath, and trifluoromethanesulfonic anhydride was dropped slowly over a period of 1.5 hours. After dropping, it was stirred at room temperature (25°C) for 3 hours. Thereafter, ion exchanged water (200 mL) was added and the mixture was stirred at room temperature. The liquid was separated, and the organic phase was washed with ion exchanged water (200 mL), and the organic phase after washing was dried over sodium sulfate, then, filtrated, and the filtrate was concentrated under reduced pressure. To this was added toluene (100 mL), and the mixture was filtrated through a filter paved with silica gel (30 g), and the filtrated product was washed with toluene (300 mL). The filtrate was concentrated under reduced pressure. The filtration through silica gel and concentration were repeated twice, and the filtrate was dried under reduced pressure at 50°C, to obtain a compound 1a (82.0 g, white solid). The HPLC area percentage value of the compound 1a was 99.5% or more.

¹H-NMR (400 MHz, CDCl₃) δ(ppm) = 7.12-7.30 (m, 9H), 1.68 (s, 6H).

An argon gas atmosphere was prepared in a reaction vessel, then, the compound 1a (80.0 g), potassium acetate (45.6 g), bispinacolatodiboron (70.8 g) and dimethoxyethane (456 mL) were added, and the mixture was stirred. Thereafter, palladium acetate (0.8 g) and tricyclohexylphosphine (2.0 g) were added, and the mixture was heated by an oil bath at 85°C and stirred for 4 hours. Thereafter, it was cooled down to room temperature, filtrated through a filter paved with Celite, and the filtrated product was washed with toluene (1.5 L). The washed filtrate was concentrated to about 1 L, and to this was added activated carbon (10 g) and the mixture was stirred, then, filtrated through a filter paved with silica gel (25 g) and Celite, and the filtrated product was washed with toluene (500 mL). The washed filtrate was concentrated, to the resultant solid were added hexane and acetone, and the mixture was suspended with stirring, then, filtrated. The resultant solid was recrystallized with a mixed solvent of toluene and acetonitrile. Further, the resultant solid was dissolved in toluene (1 L), activated carbon (10 g) was added and the mixture was stirred, then, filtrated through a filter paved with silica gel (25 g) and Celite, and the filtrated product was washed with toluene (500 mL). The resultant solid was recrystallized with a mixed solvent of toluene and acetonitrile, and dried under reduced pressure at 50°C, to obtain a compound 1b (46.0 g, white solid). The HPLC area percentage value of the compound 1b was 99.5% or more.

¹H-NMR (400 MHz, CDCl₃) δ(ppm) = 7.71 (d, 2H), 7.13-7.26 (m, 7H), 1.67 (s, 6H), 1.32 (s, 12H).

An argon gas atmosphere was prepared in a reaction vessel, then, 2,2-dimethylhexanoic acid (35.0 g) and tetrahydrofuran (525 mL) were added, and the mixture was stirred. To this was added carbonyl diimidazole (51.2 g), and the mixture was stirred for 1 hour. Thereafter, the reaction vessel was cooled using an ice bath, hydrazine mono-hydrate (36.5 g) was gradually added, and the mixture was stirred for 3 hours. Thereafter, ion exchanged water (200 mL) and toluene (100 mL) were added and the mixture was stirred, then, tetrahydrofuran (about 500 mL) was distilled off by concentration under reduced pressure. To the resultant solution was added dichloromethane (300 mL), the liquid was separated, and the resultant organic phase was washed with ion exchanged water (150 mL) four times. The washed organic phase was dried over magnesium sulfate, then, filtrated, and the resultant filtrate was concentrated under reduced pressure. Since carbonyl diimidazole as the auxiliary material remained, additional washing operations were performed (adding dichloromethane (100 mL) to the resultant solid, washing with ion exchanged water (100 mL) five times), and the resultant filtrate was concentrated, and dried under reduced pressure at 45°C, to obtain a compound 1c (30.0 g, white solid). The GC area percentage value of the compound 1c was 94.4%. The above operation was repeated, to secure a necessary amount of the compound 1c.

¹H-NMR (CDCl₃, 400MHz) δ(ppm) = 6.99 (br, 1H), 3.88 (d, 2H), 1.52-1.48 (m, 2H), 1.33-1.13 (m, 10H),0.88 (t, 3H) .
TLC-MS (DART positive): m/z = 159[M+H]⁺

An argon gas atmosphere was prepared in a reaction vessel, then, the compound 1c (32.6 g), p-toluenesulfonic acid mono-hydrate (1.0 g) and triethyl orthoformate (43.7 g) were added, and the mixture was stirred, and heated by an oil bath at 75°C and stirred for 2 hours. The reaction liquid was cooled down to room temperature, then, ion exchanged water (100 mL) and dichloromethane (100 mL) were added and the mixture was stirred, then, and the liquid was separated. The resultant organic phase was washed with ion exchanged water (100 mL) once, with a sodium carbonate aqueous solution (100 mL) three times, and with ion exchanged water (100 mL) once, in this order, and the resultant organic phase was dried over magnesium sulfate, then, filtrated, and the resultant filtrate was concentrated under reduced pressure. To the resultant oily compound were added hexane (150 mL) and silica gel (50 g), and the mixture was stirred, filtrated through a filter added with silica gel (50 g), and silica gal was washed with hexane and ethyl acetate, and the resultant solution was concentrated under reduced pressure, and dried under reduced pressure at 45°C, to obtain a compound 1d (31.5 g, colorless transparent oil). The GC area percentage value of the compound 1d was 96.1%.

¹H-NMR (CDCl₃, 400MHz) δ(ppm) = 8.36 (s, 1H), 1.73-1.68 (m, 2H), 1.42 (s, 6H), 1.33-1.21 (m, 2H), 1.19-1.11 (m, 2H), 0.87 (t, 3H).
TLC-MS (DART positive): m/z = 159[M+H]⁺

An argon gas atmosphere was prepared in a reaction vessel, then, 2,4-dimethylaniline (14.5 g) and compound 1d (30.2 g) were added and the mixture was stirred, to this was added p-toluenesulfonic acid mono-hydrate (4.6 g), and the mixture was heated by an oil bath at 180°C and stirred for 8 hours. It was cooled down to room temperature, then, dichloromethane (400 mL) and a sodium carbonate aqueous solution (200 mL) were added and the mixture was stirred, and the liquid was separated. The resultant organic phase was washed with a sodium carbonate aqueous solution (100 mL) three times, and with ion exchanged water (100 mL) twice, and the resultant organic phase was dried over magnesium sulfate, then, filtrated, and the resultant filtrate was concentrated under reduced pressure. The coarse product was isolated and purified by silica gel column chromatography (a mixed solvent of hexane and ethyl acetate). The resultant oily compound was concentrated under reduced pressure, and dried under reduced pressure at 45°C, to obtain a compound 1e (8.6 g, colorless transparent oil). The GC area percentage value of the compound 1e was 99.5% or more.

¹H-NMR (400 MHz, CDCl₃) δ(ppm) = 7.92 (s, 1H), 7.13 (s, 1H), 7.08 (s, 2H), 2.39 (s, 3H)1.99 (s, 3H), 1.83-1.06 (m, 12H), 0.84 (t, 3H).

An argon gas atmosphere was prepared in a reaction vessel, then, the compound 1e (8.0 g) and tetrahydrofuran (80 mL) were added and the mixture was stirred. The reaction vessel was cooled using a dry ice acetone bath, a n-butyllithium hexane solution (1.55 M, 29.8 mL) was dropped into this and the mixture was stirred for 2 hours. Then, bromine (2.4 g) was dissolved in hexane and dropped and the mixture was stirred for 2 hours, and allowed to warm up to 0°C. To this was added a sodium sulfite aqueous solution (200 mL), and the mixture was stirred, then, chloroform was added, and the mixture was stirred. The reaction liquid was separated, and the organic phase was washed with a sodium sulfite aqueous solution and ion exchanged water. The washed organic phase was dried over magnesium sulfate, then, filtrated, and the filtrate was concentrated under reduced pressure. The coarse product was isolated and purified by silica gel column chromatography (a mixed solvent of hexane and ethyl acetate). The resultant oily compound was concentrated under reduced pressure, and dried under reduced pressure at 45°C, to obtain a compound 1f (7.4 g, oily). The GC area percentage value of the compound 1f was 99.5%.

¹H-NMR (400 MHz, CDCl₃) δ(ppm) = 7.16 (s, 1H), 7.12 (d, 1H), 6.98 (d, 1H), 2.40 (s, 3H)1.97 (s, 3H), 1.75-1.08 (m, 12H), 0.84 (t, 3H).

An argon gas atmosphere was prepared in a reaction vessel, then, the compound 1f (5.1 g), the compound 1b (7.1 g) and toluene (85 mL) were added and the mixture was stirred. To this were added palladium acetate (99 mg) and 2-dicyclohexylphosphino-2',6'-dimethoxybiphenyl (362 mg), and the mixture was heated by an oil bath at 70°C. To this was added a 20% by weight tetraethylammonium hydroxide aqueous solution (43 mL), and the mixture was heated by an oil bath at 87°C. After cooling down to room temperature, the reaction liquid was separated, and the organic phase was washed with ion exchanged water (50 mL) three times. The washed organic phase was dried over magnesium sulfate, activated carbon (1 g) was added and the mixture was stirred, then, filtrated through a filter paved with Celite, and the filtrate was concentrated under reduced pressure. The resultant coarse product was isolated and purified by silica gel column chromatography (a mixed solvent of hexane and ethyl acetate).

An argon gas atmosphere was prepared in a reaction vessel, then, the resultant solid (7.4 g), phenylboric acid (0.2 g) and toluene (96 mL) were added and the mixture was stirred. To this was added 2-dicyclohexylphosphino-2',4',6'-triisopropyl-1,1'-biphenyl[(2-2'-amino-1,1'-biphenyl)]palladium(II) methanesulfonate (67 mg), and the mixture was heated by an oil bath at 70°C. To this was added a 20% by weight tetrabutylammonium hydroxide aqueous solution (50 mL), and the mixture was heated by an oil bath at 90°C. After cooling down to room temperature, the liquid was separated, and the resultant organic phase was washed with ion exchanged water (30 mL) three times. The washed organic phase was dried over magnesium sulfate, activated carbon (2 g) was added and the mixture was stirred, then, filtrated through a filter paved with Celite, and the resultant filtrate was concentrated under reduced pressure. The resultant coarse product was isolated and purified by silica gel column chromatography (a mixed solvent of hexane and ethyl acetate). To the resultant solid was added hexane, and the mixture was suspended with stirring, then, filtrated, and the resultant solid was recrystallized with heptane, and dried under reduced pressure at 50°C, to obtain a compound 1g (5.9 g, white solid). The LC area percentage value of the compound 1g was 99.5%.

¹H-NMR (400 MHz, CDCl₃) δ(ppm) = 7.28-7.04 (m, 12H), 2.39 (s, 3H), 1.93-1.09 (m, 21H), 0.85 (t, 3H).

An argon gas atmosphere was prepared in a reaction vessel, then, trisacetylacetonatoiridium (1.5 g), the compound 1g (5.7 g) and pentadecane (17 mL) were added, and the mixture was stirred under reflux with heating for 63 hours. Thereafter, to this was added toluene, and the mixture was filtrated through a filter paved with silica gel, then, a yellow solution containing a compound S1 was extracted using a mixed solvent of toluene and ethyl acetate. This yellow solution was concentrated under reduced pressure to obtain a solid, then, the resultant solid was suspended with stirring with a mixed solvent of acetonitrile and ethanol, and filtrated. The resultant filtrate was isolated and purified by silica gel column chromatography (a mixed solvent of toluene and ethyl acetate). The solid obtained by suspending with stirring and the solid obtained by isolation and purification described above were mixed, and the mixture was suspended with stirring with a mixed solvent of acetonitrile and ethanol, and filtrated. The resultant solid was recrystallized with a mixed solvent of toluene and ethanol, and a mixed solvent of toluene and acetonitrile, and dried under reduced pressure at 50°C, to obtain a compound S1 (1.3 g, yellow solid). The LC area percentage value of the compound S1 was 99.5% or more.

¹H-NMR (400 MHz, CD₂Cl₂) δ(ppm) = 7.23-6.79 (m, 27H), 6.02-5.68 (m, 6H), 2.42-2.33 (m, 9H), 2.14-1.84 (m, 9H), 1.71-1.07 (m, 54H), 0.89-0.65 (m, 9H).
LC-MS (APCI positive): m/z = 1586[M+H]⁺

### <Example 2> Synthesis of compound S2

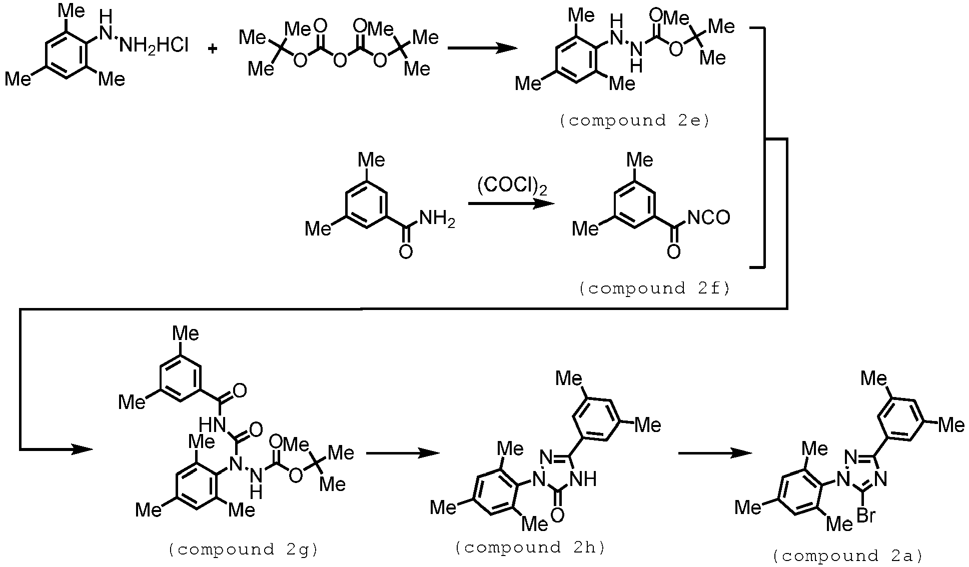

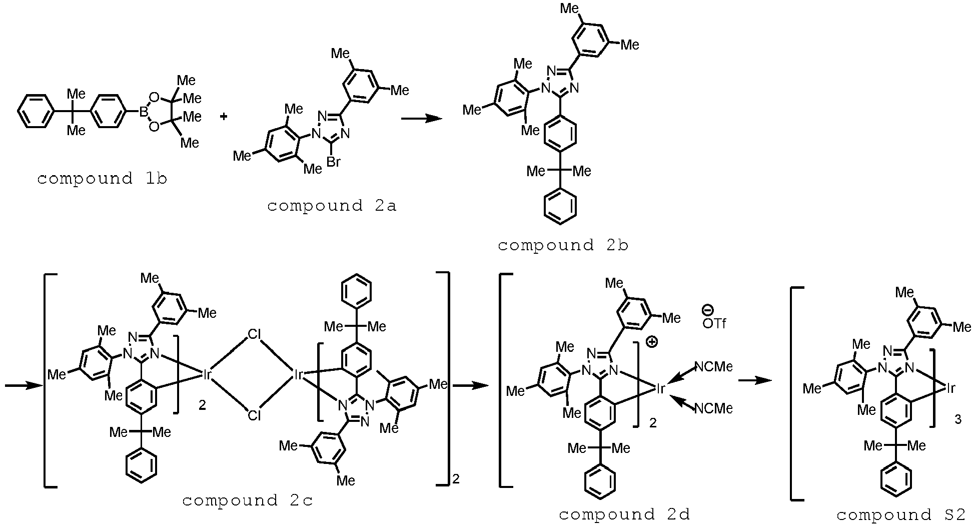

A nitrogen gas atmosphere was prepared in a reaction vessel, then, 2,4,6-trimethylphenylhydrazine (40.0 g) and tetrahydrofuran (450 mL) were added, and the mixture was stirred, and the reaction vessel was cooled by an ice bath. A sodium hydroxide aqueous solution (sodium hydroxide (36.0 g), ion exchanged water (400 mL)) was dropped into this. Then, a tetrahydrofuran solution of di-tert-butyl dicarbonate (di-tert-butyl dicarbonate (48.6 g), tetrahydrofuran (99 mL)) was dropped over a period of 30 minutes. The resultant solution was stirred at room temperature for 1 hour, methyl tert-butyl ether (541 mL) was added, and the mixture was stirred for 30 minutes. The reaction liquid was separated, and the organic phase was washed with ion exchanged water (400 mL) twice, dried over magnesium sulfate, then, filtrated. The filtrate was concentrated under reduced pressure, and dried under reduced pressure at 45°C, to obtain a compound 2e (53.4 g). The HPLC area percentage value of the compound 2e was 99.5% or more.
TLC-MS (DART positive): m/z = 251[M+H]⁺

A nitrogen gas atmosphere was prepared in a reaction vessel, then, 3,5-dimethylbenzamide (15.5 g) and 1-chlorobutane (225 mL) were added, and the mixture was stirred. The reaction vessel was heated by an oil bath at 40°C, and oxalyl chloride (13.2 g) was dropped into this over a period of 30 minutes, and the mixture was stirred for 23 hours. The reaction liquid was heated at 80°C, and concentrated at normal pressure. The reaction liquid was cooled down to room temperature, then, 1-chlorobutane (67 mL) was added, and the mixture was stirred, the compound 2e (20.0 g) dissolved in 1-chlorobutane (45 mL) was dropped into this over a period of 1 hour, and the mixture was stirred for 2 hours. Then, ethanol (253 mL) was dropped into this over a period of 30 minutes, and the reaction vessel was cooled by an ice bath and the mixture was stirred for 2 hours, and filtrated. The resultant solid was recrystallized with ethanol, and dried under reduced pressure at 45°C, to obtain a compound 2g (23.2 g). The above-described operation was repeated, to obtain a necessary amount of the compound 2g. The HPLC area percentage value of the compound 2g was 99.3%.
TLC-MS (DART positive): m/z = 426[M+H]⁺

A nitrogen gas atmosphere was prepared in a reaction vessel, then, the compound 2g (42.7 g) and 1-chlorobutane (480 mL) were added and the mixture was stirred. The reaction vessel was cooled by a water bath, and trifluoroacetic acid (57.2 g) was dropped into this over a period of 10 minutes. It was gradually heated until an oil bath reached 60°C, and the resultant solution was stirred for 7 hours. The reaction liquid was cooled down to room temperature, then, this reaction liquid was dropped into ion exchanged water (480 mL) over a period of 20 minutes. To this was added methyl tert-butyl ether (1730 mL), and the mixture was stirred for 1 hour. The reaction liquid was separated, and the organic phase was washed with a sodium carbonate aqueous solution (sodium carbonate (26.6 g), ion exchanged water (427 mL)), and the washed organic phase was washed with ion exchanged water (270 mL) twice. The washed organic phase was concentrated under reduced pressure, and the resultant solid was recrystallized using ethanol, and dried under reduced pressure at 50°C, to obtain a compound 2h (23.9 g). The HPLC area percentage value of the compound 2h was 99.5%.

¹H-NMR (400 MHz, DMSO) δ(ppm) = 7.43 (s, 2H), 7.09 (s, 1H), 6.97 (s, 2H), 2.34 (s, 9H), 2.03 (s, 6H).

A nitrogen gas atmosphere was prepared in a reaction vessel, then, the compound 2h (15.0 g) and mesitylene (140 mL) were added and the mixture was stirred, and phosphorus oxybromide (28.0 g) dissolved in mesitylene (35 mL) was dropped into this. The reaction vessel was heated by an oil bath at 150°C, and the resultant solution was stirred with heating for 5 hours. The reaction vessel was cooled in a water bath, then, a potassium carbonate aqueous solution (potassium carbonate (24 g), ion exchanged water (150 mL)) was dropped into the reaction liquid over a period of 30 minutes, then, toluene (172 mL) was added, and the mixture was stirred. The reaction liquid was separated, and the organic phase was washed with ion exchanged water (150 mL) twice, dried over magnesium sulfate, then, filtrated through a filter pave with silica gel (7.5 g) and Celite. The filtrate was concentrated under reduced pressure, and dried under reduced pressure at 65°C. To the resultant solid was added methanol, and the mixture was suspended with stirring, then, filtrated. The resultant solid was dissolved in toluene, activated carbon (1 g) was added, and the mixture was filtrated through a filter paved with silica gel and Celite. The filtrate was concentrated under reduced pressure, and dried under reduced pressure at 45°C. Then, it was recrystallized with a mixed solvent of toluene and methanol, and dried under reduced pressure at 45°C, to obtain a compound 2a (6.9 g). The above-described operation was repeated, to obtain a necessary amount of the compound 2a. The HPLC area percentage value of the compound 2a was 99.5% or more.

¹H-NMR (400 MHz, CD₂Cl₂) δ(ppm) = 7.71 (s, 2H), 7.06 (s, 1H), 7.01 (s, 2H), 2.34 (s, 6H), 1.98 (s, 6H).
LC-MS (APCI, positive): m/z = 370[M+H]⁺

An argon gas atmosphere was prepared in a reaction vessel, then, the compound 1b (23.9 g), the compound 2a (25.0 g) and toluene (392 mL) were added, and the mixture was stirred. To this was added dichlorobis(tris(o-methoxyphenyl)phosphine)palladium(1.8 g), and the mixture was heated by an oil bath at 90°C. To this was added a 20% by weight tetraethylammonium hydroxide aqueous solution (99 mL), and the mixture was stirred with heating for 4 hours. The reaction liquid was cooled down to room temperature, then, the liquid was separated, the organic phase was washed with ion exchanged water, and the washed organic phase was dried over magnesium sulfate, activated carbon (5 g) was added, and the mixture was stirred, then, filtrated through a filter paved with silica gel (30 g) and Celite, and the filtrated product was washed with toluene (300 mL), and the resultant filtrate was concentrated under reduced pressure. The resultant solid was filtrated with a mixed solvent of ethyl acetate and toluene with heating, and the resultant solid was recrystallized with a mixed solvent of ethyl acetate and acetonitrile. The resultant solid was isolated and purified by silica gel column chromatography (a mixed solvent of toluene and hexane). The resultant solid was dried under reduced pressure at 50°C, to obtain a compound 2b (17.7 g, white solid). The LC area percentage value of the compound 2b was 99.5% or more.

¹H-NMR (400 MHz, CDCl₃) δ(ppm) = 7.88 (s, 6H), 7.49 (d, 2H), 7.25 (t, 2H), 7.15-7.18 (m, 5H),7.05 (s, 1H), 6.97 (s, 2H), 2.38 (s, 6H), 2.35 (s, 3H), 1.97 (s, 6H), 1.64 (s, 6H).
LC-MS (APCI positive): m/z = 485[M+H]⁺

An argon gas atmosphere was prepared in a reaction vessel, then, the compound 2b (10.8 g), iridium chloride (2.7 g), ion exchanged water (22 mL) and diethylene glycol dimethyl ether (68 mL) were added, and the mixture was heated by an oil bath at 140°C and stirred for 32 hours. The reaction liquid was cooled down to room temperature, toluene and ion exchanged water were added, and the mixture was stirred, and the liquid was separated. The resultant organic phase was washed with ion exchanged water (100 mL) five times, and the washed organic phase was dried over magnesium sulfate, filtrated, and concentrated under reduced pressure. To the resultant solid was added toluene (160 mL), and the mixture was suspended with stirring, and filtrated. The filtrate was concentrated, then, isolated and purified by silica gel column chromatography (a mixed solvent of toluene and ethanol). The solid obtained by suspending with stirring and the solid obtained by isolation and purification were put together, and dried under reduced pressure at 50°C, to obtain a compound 2c (8.0 g, orange solid).

An argon gas atmosphere was prepared in a reaction vessel, then, the compound 2c (6.3 g) and acetonitrile (158 mL) were added, and the mixture was stirred, silver trifluoromethanesulfonate (2.0 g) was added, and the mixture was heated by an oil bath at 85°C and stirred for 8 hours. The reaction liquid was cooled down to room temperature, filtrated through a filter paved with Celite and filtrated with acetonitrile (250 mL), and the filtrate was concentrated under reduced pressure. The resultant coarse product was isolated and purified by alumina gel column chromatography (acetonitrile). The resultant solid was dried under reduced pressure at 50°C, to obtain a compound 2d (5.9 g, brown solid). The LC area percentage value of the compound 2d was 89.9%.

An argon gas atmosphere was prepared in a reaction vessel, then, the compound 2d (2.5 g), the compound 2c (6.1 g), 2,6-lutidine (1.0 g) and diethylene glycol dimethyl ether (5.0 g) were added, and the mixture was heated by an oil bath at 175°C and stirred for 96 hours. The reaction liquid was cooled down to room temperature, toluene and ion exchanged water were added and the mixture was stirred, and the liquid was separated. The organic phase was dried over magnesium sulfate, activated carbon (1 g) was added, and the mixture was stirred, then, filtrated through a filter paved with silica gel (5 g) and Celite, and the filtrate was concentrated under reduced pressure. The resultant coarse product was isolated and purified by silica gel column chromatography (toluene). Then, it was purified by recycle GPC. The resultant solid was recrystallized with a mixed solvent of toluene and hexane, and thereafter, recrystallized with a mixed solvent of toluene and acetonitrile, and the resultant solid was dried under reduced pressure at 50°C, to obtain a compound S2 (490 mg, yellow solid). The LC area percentage value of the compound S2 was 99.5% or more.

¹H-NMR (400 MHz, CD₂Cl₂) δ(ppm) = 7.95 (6H, s), 7.09-7.23 (3H, m), 6.95-7.01 (12H, m), 6.93 (3H, s), 6.88 (3H, s), 6.84 (3H, s), 6.65 (3H, s), 6.09 (3H, d), 5.94 (3H, d), 2.32 (2H, s), 2.28 (7H, s), 2.00 (18H, s), 1.82 (9H, s), 1.34 (9H, s), 1.26 (9H, s), 1.14 (9H, s).
LC-MS (APCI positive): m/z = 1646[M+H]⁺

### <Example 3> Synthesis of compound S3

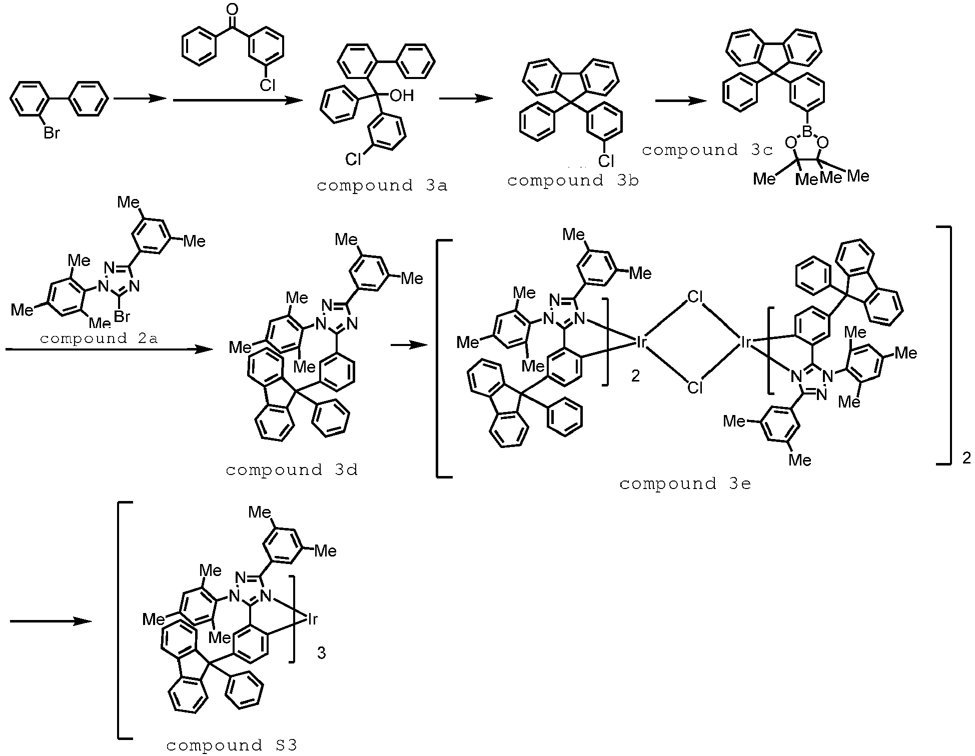

An argon gas atmosphere was prepared in a reaction vessel, then, 2-bromobiphenyl (46.0 g) and tetrahydrofuran (588 mL) were added, and the mixture was stirred, and the reaction vessel was cooled by a dry ice acetone bath. A n-butyllithium hexane solution (1.55 M) (118 mL) was dropped into this, and the mixture was stirred for 4 hours, then, 3-chlorobenzophenone (39.2 g) dissolved in tetrahydrofuran (118 mL) was dropped, and the mixture was stirred for 2 hours. Then, to the reaction liquid was added methanol (157 mL), and the mixture was stirred, then, heated up to room temperature. To this were added saturated saline (196 mL) and toluene (196 mL), and the liquid was separated. The organic phase was washed with saturated saline (392 mL), and the washed organic phase was dried over magnesium sulfate, filtrated, and the filtrate was concentrated under reduced pressure. The resultant coarse product was isolated and purified by silica gel column chromatography (a mixed solvent of hexane and ethyl acetate). The above-described operation was repeated, and the product was dried under reduced pressure at 45°C, to obtain a compound 3a (105 g). The LC area percentage value of the compound 3a was 98.0% or more.

¹H-NMR (400 MHz, CDCl₃) δ(ppm) = 7.33-7.13 (14H, m), 7.02 (1H, d),6.82 (2H, d),6.74 (1H, d),3.00 (1H, s) .

An argon gas atmosphere was prepared in a reaction vessel, then, the compound 3a (103.0 g) and toluene (1.5 L) were added, and the mixture was stirred, and the reaction vessel was cooled by an ice bath, sulfuric acid (57 mL) was dropped into this over a period of 1 hour, and the mixture was stirred for 2 hours. Then, ion exchanged water (515 mL) was added, and the mixture was stirred, filtrated through a filter paved with Celite, and the filtrated product was washed with toluene (103 mL). The filtrate was separated, and the organic phase was washed with a 5% by weight sodium hydrogen carbonate aqueous solution three times, and with ion exchanged water twice. The washed organic phase was dried over magnesium sulfate, filtrated, and the filtrate was concentrated under reduced pressure. The resultant solid was recrystallized with a mixed solvent of toluene and acetonitrile, and dried under reduced pressure at 50°C, to obtain a compound 3b (68.6 g). The LC area percentage value of the compound 3b was 99.5% or more.
TLC-MS (DART positive): m/z = 353[M+H]⁺

An argon gas atmosphere was prepared in a reaction vessel, then, the compound 3b (66.6 g), potassium acetate (37.0 g), bispinacolatodiboron (57.5 g) and dimethoxyethane (445 mL) were added, and the mixture was stirred. To this were added palladium acetate (636 mg) and 2-dicyclohexylphosphino-2',4',6'-triisopropylbiphenyl (2.7 g), and the mixture was heated by an oil bath at 85°C for 6 hours. The reaction liquid was cooled down to room temperature, then, toluene (1L) was added, and the mixture was filtrated through a filter paved with Celite, and the filtrated product was washed with toluene (500 mL). The filtrate was concentrated under reduced pressure, to the resultant solid were added toluene (900 mL) and activated carbon (8.5 g), and the mixture was stirred, then, filtrated through a filter paved with silica gel (20 g) and Celite. The filtrate was concentrated to about 100 mL of toluene, and filtrated. The resultant solid was recrystallized several times with toluene and acetonitrile or heptane and toluene. The resultant solid was dried under reduced pressure at 50°C, to obtain a compound 3c (45.0 g). The LC area percentage value of the compound 3c was 99.5% or more.

¹H-NMR (400 MHz, CDCl₃) δ(ppm) = 7.76-7.73 (3H, m), 7.66 (1H, d), 7.42-7.14 (13H, m), 1.28 (12H, s).

An argon gas atmosphere was prepared in a reaction vessel, then, the compound 3c (27.6 g), the compound 2a (20.0 g) and toluene (313 mL) were added, and the mixture was stirred. To this was added dichlorobis(tris(o-methoxyphenyl)phosphine)palladium(1.4 g), and the mixture was heated by an oil bath at 90°C. To this was added a 20% by weight tetraethylammonium hydroxide aqueous solution (159 mL), and the mixture was stirred with heating for 12 hours. The reaction liquid was cooled down to room temperature, then, toluene and ion exchanged water were added, the liquid was separated, and the organic phase was washed with ion exchanged water, the washed organic phase was dried over magnesium sulfate, activated carbon (5 g) was added, and the mixture was stirred. The resultant solution was filtrated through a filter paved with silica gel (30 g) and Celite, and the filtrated product was washed with toluene (300 mL). The resultant filtrate was concentrated under reduced pressure, toluene (1L) was added the resultant solid, and the mixture was heated, and filtrated with heating. The filtrate was concentrated under reduced pressure, and the resultant solid was recrystallized with a mixed solvent of toluene and heptane. The resultant solid was isolated and purified by silica gel column chromatography (toluene), and the resultant solid was recrystallized with a mixed solvent of toluene and heptane. The resultant solid was dried under reduced pressure at 50°C, to obtain a compound 3d (19.1 g). The LC area percentage value of the compound 3d was 99.5% or more.

¹H-NMR (400 MHz, CDCl₃) δ(ppm) = 7.96 (1H, d), 7.84 (1H, s), 7.70 (2H, d), 6.33 (2H, t), 7.22-7.16 (8H, s), 7.22-7.16 (7H, s), 6.78 (1H, s), 2.37 (6H, s), 2.33 (3H, s), 1.74 (6H, s).

An argon gas atmosphere was prepared in a reaction vessel, then, the compound 3d (4.8 g), iridium chloride (1.3 g), ion exchanged water (11 mL) and diethylene glycol dimethyl ether (43 mL) were added, and the mixture was heated by an oil bath at 140°C and stirred for 41 hours. The reaction liquid was cooled down to room temperature, and the deposited solid was filtrated. The resultant solid was washed with ion exchanged water and hexane. To the washed solid were added dichloromethane (20 mL) and heptane (80 mL), and the mixture was suspended with stirring, and filtrated. The resultant solid was dried under reduced pressure at 50°C, to obtain a compound 3e (4.6 g, orange solid).

An argon gas atmosphere was prepared in a reaction vessel, then, the compound 3e (4.0 g), the compound 3d (2.1 g), silver trifluoromethanesulfonate (1.1 g), 2,6-lutidine (1.6 mL) and diphenyl ether (12 mL) were added, and the mixture was heated by an oil bath at 165°C and stirred for 26 hours. The reaction liquid was cooled down to room temperature, toluene (400 mL) was added, and the liquid was filtrated, and the filtrated product was washed with toluene (100 mL). The resultant filtrate was filtrated through a filter paved with silica gel (48 g), and the filtrated product was washed with toluene (600 mL). The resultant filtrate was concentrated under reduced pressure, and hexane (40 mL) was added the resultant solid, and the mixture was suspended with stirring, then, filtrated. The resultant solid was recrystallized with a mixed solvent of toluene and heptane, then, recrystallized with a mixed solvent of toluene and acetonitrile, and isolated and purified by silica gel column chromatography (a mixed solvent of toluene and ethyl acetate). The resultant solid was recrystallized with a mixed solvent of toluene and heptane, then, recrystallized with a mixed solvent of toluene and acetonitrile. The resultant solid was dried under reduced pressure at 50°C, to obtain a compound S3 (1.3 g, yellow solid). The LC area percentage value of the compound S3 was 99.5% or more.

¹H-NMR (400 MHz, CD₂Cl₂) δ(ppm) = 7.82 (6H, s), 7.59 (6H, dd), 7.23 (6H, t), 7.12-6.98 (18H, m), 6.84 (6H, d), 6.74 (6H, d), 6.55 (3H, d), 6.42 (3H, s), 6.17 (3H, d), 6.18-6.04 (6H, m), 2.24 (9H, s), 2.08 (18H, s), 1.59 (9H, s), 1.23 (9H, s).
LC-MS (APCI positive): m/z = 2012[M+H]⁺

### <Example 4> Synthesis of compound S4

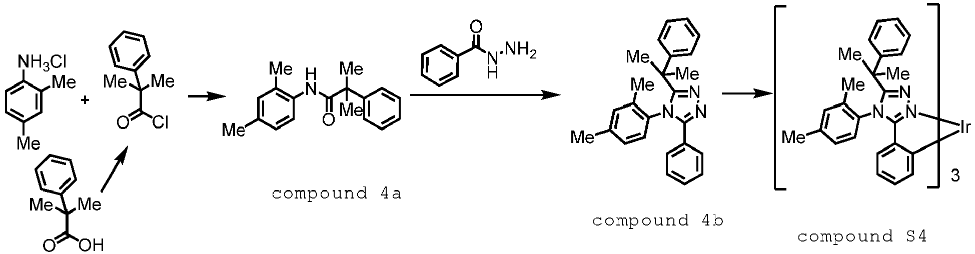

An argon gas atmosphere was prepared in a reaction vessel, then, 2-methyl-2-phenylpropionic acid (22.5 g), chloroform (112 mL) and dimethylformamide (0.1 mL) were added, and the mixture was stirred, and thionyl chloride (11 mL) was dropped therein. After completion of dropping, the reaction vessel was heated by an oil bath at 45°C and stirred for 3 hours, to prepare an acid chloride.

An argon gas atmosphere was prepared in a reaction vessel, then, 2,4-dimethylaniline hydrochloride (19.6 g) and chloroform (333 mL) were added, and the mixture was stirred, and the reaction vessel was cooled in a water bath. Triethylamine (35 mL) was dropped therein. Thereafter, the acid chloride prepared previously was dropped. Thereafter, to this was added a saturated sodium carbonate aqueous solution (274 mL), and the mixture was stirred at room temperature. The reaction liquid was separated, and the organic phase was washed with a saturated sodium carbonate aqueous solution, ion exchanged water and 1 mol/L hydrochloric acid water in series. The resultant organic phase was dried over magnesium sulfate, then, to this was added activated carbon (3.9 g) and the mixture was stirred, and filtrated through a filter paved with Celite. The resultant filtrate was concentrated, then, heptane was added and the mixture was stirred for 1 hour, and the resultant solid was filtrated, and dried under reduced pressure at 50°C, to obtain a compound 4a (28.4 g, white solid). The GC area percentage value of the compound 4a was 99.5% or more.
TLC-MS (DART positive): m/z = 268[M+H]⁺

An argon gas atmosphere was prepared in a reaction vessel, then, the compound 4a (20.0 g), monochlorobenzene (200 mL) and 2-fluoropyridine (7 mL) were added and the mixture was stirred, and the reaction vessel was cooled in a water bath. To this was added trifluoromethanesulfonic anhydride (12 mL), and the mixture was stirred at room temperature for 1 hour. To this was added benzhydrazide (11.2 g), and the mixture was heated by an oil bath at 85°C and stirred for 3 hours. The reaction liquid was cooled down to room temperature, then, to this was added a sodium hydrogen carbonate aqueous solution (300 mL), and the organic phase was extracted, and the organic phase was washed with ion exchanged water. The washed organic phase was concentrated under reduced pressure, to obtain a solid. To this solid was added hexane (30 mL), and the mixture was suspended with stirring, then, filtrated. The resultant solid was recrystallized several times using a mixed solvent of heptane and 2-propanol, or a mixed solvent of heptane and ethyl acetate, and dried under reduced pressure at 50°C, to obtain a compound 4b (16.2 g) as a white solid. The HPLC area percentage value of the compound 4b was 99.5% or more.

¹H-NMR (400 MHz, CDCl₃) δ(ppm) = 7.31-7.28 (2H, m), 7.24-7.16 (m, 6H), 7.08-7.03 (m, 2H), 6.80 (s, 1H), 6.64 (d, 1H), 6.00 (d, 1H), 2.26 (s, 3H), 1.85 (s, 3H), 1.49 (s, 3H), 1.45 (s, 3H).

An argon gas atmosphere was prepared in a reaction vessel, then, trisacetylacetonatoiridium (2.7 g), the compound 4b (8.0 g) and pentadecane (19 mL) were added, and the mixture was stirred under reflux with heating for 55 hours. It was cooled down to room temperature, then, to this was added toluene, and the mixture was filtrated through a filter paved with silica gel, then, a yellow solution containing a compound S4 was extracted using a mixed solvent of toluene and ethyl acetate. The resultant solution was concentrated under reduced pressure, to obtain a solid, then, this solid was dissolved in toluene, activated carbon (1 g) was added, and the mixture was stirred, then, filtrated through a filter paved with Celite, and the filtrated product was washed with toluene (150 mL). The resultant filtrate was concentrated, to this was added 2-propanol and the liquid was suspended with stirring, and filtrated. The resultant solid was isolated and purified by silica gel column chromatography (a mixed solvent of toluene and ethyl acetate). The resultant solid was recrystallized using a mixed solvent of toluene, ethanol and methanol, and dried under reduced pressure at 50°C, to obtain a compound S4 (1.2 g). The HPLC area percentage value of the compound S4 was 99.5% or more.

¹H-NMR (400 MHz, CD₂Cl₂) δ(ppm) = 7.13-6.22 (32H, m), 6.06-5.94 (m, 4H), 2.33 (s, 9H), 1.88-1.47 (m, 27H) .
LC-MS (APCI positive): m/z = 1292[M+H]⁺

### <Comparative Example 1>Synthesis of compounds S5 and S6

A compound S5 was synthesized according to a method described in International Publication WO2017/170916.

A compound S6 was synthesized according to a method described in International Publication WO2016/006523.

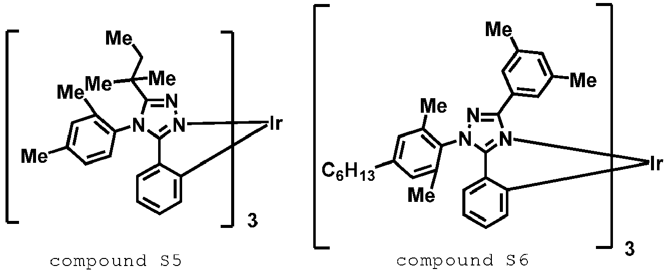

### <Compound HM-1>

A compound HM-1 was purchased from Luminescence Technology.

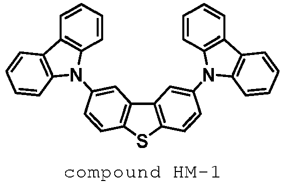

### <Synthesis Example HTL-1> Synthesis of compound HTL-1

A compound HTL-1 was synthesized by a method described in JP-A No. 2017-108134. The compound HTL-1 is a copolymer constituted of a constitutional unit derived from the compound CM1, a constitutional unit derived from the compound CM2, a constitutional unit derived from the compound CM3 and a constitutional unit derived from the compound CM4 at a molar ratio of 50:5:5:40, according to the theoretical values calculated from the amounts of the charged raw materials. The compound HTL-1 had an Mn of 5.7×10⁴ and an Mw of 1.9×10⁵.

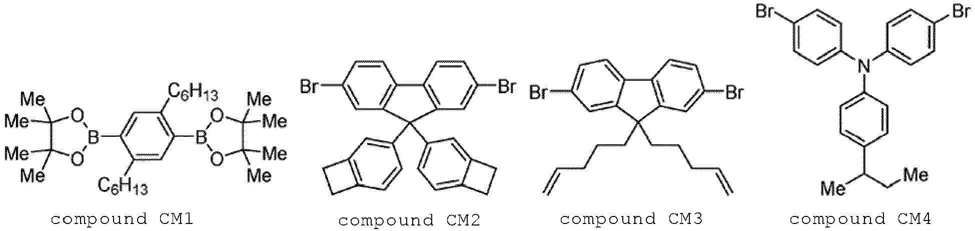

### <Synthesis Example ETL-1> Synthesis of compound ETL-1

A compound ETL-1 was synthesized by synthesizing a precursor (ester body) by a method described in International Publication WO2015/159932, and reacting this precursor with cesium hydroxide mono-hydrate. The polymer compound of the above-described precursor had an Mn of 5.8×10⁴ and an Mw of 1.2×10⁵. The compound ETL-1 is a polymer represented by the following formula. The elemental analysis values of the compound ETL-1 were C: 47.8% by weight; H: 5.2% by weight; Cs: 24.4% by weight (theoretical values: C: 49.6% by weight; H: 4.3% by weight; Cs: 26.8% by weight; O: 19.3% by weight). 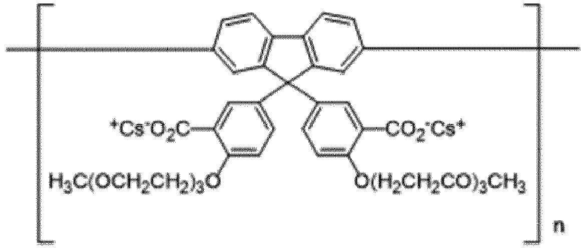 (wherein, n represents the number of the repeating unit.)

### <Comparative Example CD1> Fabrication and evaluation of light emitting device CD1

### (Formation of anode and hole injection layer)

An ITO film was attached with a thickness of 45 nm to a glass substrate by a sputtering method, to form an anode. A hole injection material ND-3202 (manufactured by Nissan Chemical Corporation) was spin-coated on the node, to form a film with a thickness of 35 nm. Under an air atmosphere, the film was heated on a hot plate at 50°C for 3 minutes, and further heated at 230°C for 15 minutes, to form a hole injection layer.

### (Formation of hole transporting layer)

The compound HTL-1 was dissolved at a concentration of 0.7% by weight in xylene. The resultant xylene solution was spin-coated on the hole injection layer, to form a film with a thickness of 20 nm, and the film was heated on a hot plate at 230°C for 60 minutes under a nitrogen gas atmosphere, to form a hole transporting layer. By this heating, the compound HTL-1 became a crosslinked body.

### (Formation of light emitting layer)

The compound HM-1 and the compound S5 (compound HM-1/compound S5 = 75% by weight/25% by weight) were dissolved at a concentration of 2% by weight in toluene. The resultant toluene solution was spin-coated on the hole transporting layer, to form a film with a thickness of 75 nm, and the film was heated at 130°C for 10 minutes under a nitrogen gas atmosphere, to form a light emitting layer.

### (Formation of electron transporting layer)

The compound ETL-1 was dissolved at a concentration of 0.25% by weight in 2,2,3,3,4,4,5,5-octafluoro-1-pentanol. The resultant 2,2,3,3,4,4,5,5-octafluoro-1-pentanol solution was spin-coated on the light emitting layer, to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor-deposition method, and the internal pressure thereof was reduced to 1.0×10⁻⁴ Pa or less, then, as the cathode, sodium fluoride was vapor-deposited with a thickness of about 4 nm on the electron transporting layer, then, aluminum was vapor-deposited with a thickness of about 80 nm on the sodium fluoride layer. After vapor deposition, sealing was performed using a glass substrate, to fabricate a light emitting device CD1.

### (Evaluation of light emitting device)

Voltage was applied to the light emitting device CD1, to observe EL light emission. The external quantum efficiency [%] at 3000 cd/m² was measured. The driving voltage at 3000 cd/m² was 10.8 [V], and the CIE chromaticity coordinate (x, y) was (0.20, 0.41).

### <Comparative Example CD2> Fabrication and evaluation of light emitting device CD2

A light emitting device CD2 was fabricated in the same manner as in Comparative Example CD1, except that the compound S6 was used instead of the compound S5 in Comparative Example CD1.

Voltage was applied to the light emitting device CD2, to observe EL light emission. The external quantum efficiency [%] at 3000 cd/m² was measured. The driving voltage at 3000 cd/m² was 11.8 [V], and the CIE chromaticity coordinate (x, y) was (0.19, 0.32).

### <Example D1> Fabrication and evaluation of light emitting device D1

A light emitting device D1 was fabricated in the same manner as in Comparative Example CD1, except that the the compound S2 was used instead of the compound S5 in Comparative Example CD1.

Voltage was applied to the light emitting device D1, to observe EL light emission. The external quantum efficiency [%] at 3000 cd/m² was measured. The driving voltage at 3000 cd/m² was 9.6 [V], and the CIE chromaticity coordinate (x, y) was (0.17, 0.32).

### <Example D2> Fabrication and evaluation of light emitting device D2

A light emitting device D2 was fabricated in the same manner as in Comparative Example CD1, except that the compound S3 was used instead of the compound S5 in Comparative Example CD1.

Voltage was applied to the light emitting device D2, to observe EL light emission. The external quantum efficiency [%] at 3000 cd/m² was measured. The driving voltage at 3000 cd/m² was 9.3 [V], and the CIE chromaticity coordinate (x, y) was (0.17, 0.35).

### <Example D3> Fabrication and evaluation of light emitting device D3

A light emitting device D3 was fabricated in the same manner as in Comparative Example CD1, except that the the compound S1 was used instead of the compound S5 in Comparative Example CD1.

Voltage was applied to the light emitting device D3, to observe EL light emission. The external quantum efficiency [%] at 3000 cd/m² was measured. The driving voltage at 3000 cd/m² was 9.1 [V], and the CIE chromaticity coordinate (x, y) was (0.19, 0.38).

### <Example D4> Fabrication and evaluation of light emitting device D4

A light emitting device D4 was fabricated in the same manner as in Comparative Example CD1, except that the the compound S4 was used instead of the compound S5 in Comparative Example CD1.

Voltage was applied to the light emitting device D4, to observe EL light emission. The external quantum efficiency [%] at 3000 cd/m² was measured. The driving voltage at 3000 cd/m² was 9.4 [V], and the CIE chromaticity coordinate (x, y) was (0.19, 0.38).

The results of Examples D1 to D4 and Comparative Examples CD1 to CD2 are shown in Table 2. The relative values of the external quantum efficiency of the light emitting devices D1 to D4 and CD2, when the external quantum efficiency of the light emitting device CD1 is taken as 1.0, are shown.

**[Table 2]**

| | hole transporting layer | light emitting layer | | external quantum efficiency (relative value) |
|---|---|---|---|---|
| | constitution material | constitution material | composition ratio (% by weight) | |
| Comparative Example CD1 | compound HTL-1 | compound HM-1/compound S5 | 75/25 | 1.0 |
| Comparative Example CD2 | compound HTL-1 | compound HM-1/compound S6 | 75/25 | 1.0 |
| Example D1 | compound HTL-1 | compound HM-1/compound S2 | 75/25 | 1.5 |
| Example D2 | compound HTL-1 | compound HM-1/compound S3 | 75/25 | 1.8 |
| Example D3 | compound HTL-1 | compound HM-1/compound S1 | 75/25 | 1.8 |
| Example D4 | compound HTL-1 | compound HM-1/compound S4 | 75/25 | 1.6 |

## Claims

1. A metal complex represented by the formula (1-A) : 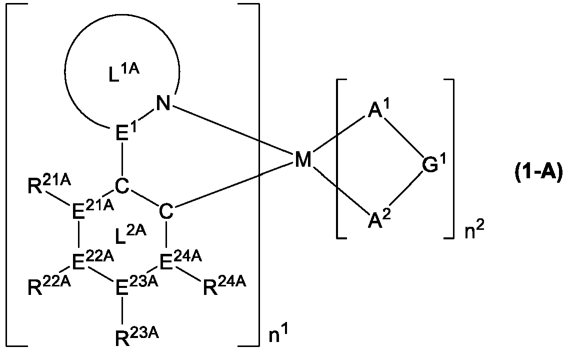 wherein,
M represents a ruthenium atom, a rhodium atom, a palladium atom, an iridium atom or a platinum atom,
n¹ represents an integer of 1 or more, and n² represents an integer of 0 or more, n¹+n² is 3 when M is a ruthenium atom, a rhodium atom or an iridium atom, while n¹+n² is 2 when M is a palladium atom or a platinum atom,
E¹ represents a nitrogen atom or a carbon atom, when a plurality of E¹ are present, they may be the same or different at each occurrence,
Ring L^{1A} represents a pyridine ring, a diazabenzene ring, an azanaphthalene ring, a diazanaphthalene ring, a triazole ring or a diazole ring, and these rings optionally have a substituent, when a plurality of the substituents are present, they may be combined together to form a ring together with atoms to which they are attached, when a plurality of Ring L^{1A} are present, they may be the same or different,
E^{21A}, E^{22A}, E^{23A} and E^{24A} each independently represent a nitrogen atom or a carbon atom, at least two of E^{21A}, E^{22A}, E^{23A} and E^{24A} are carbon atoms, when a plurality of E^{21A}, E^{22A}, E^{23A} and E^{24A} are present, they may be the same or different at each occurrence, when E^{21A} is a nitrogen atom, R^{21A} is not present, when E^{22A} is a nitrogen atom, R^{22A} is not present, when E^{23A} is a nitrogen atom, R^{23A} is not present, when E^{24A} is a nitrogen atom, R^{24A} is not present,
R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or said group represented by the formula (2), and these groups optionally have a substituent, when a plurality of R^{21A}, R^{22A}, R^{23A} and R^{24A} are present, they may be the same or different at each occurrence, R^{21A} and R^{22A}, R^{22A} and R^{23A}, and R^{23A} and R^{24A} each may be combined together to form a ring together with atoms to which they are attached,
Ring L^{1A} has said group represented by the formula (2) as said substituent, or at least one of R^{21A}, R^{22A}, R^{23A} and R^{24A} is said group represented by the formula (2),
A¹-G¹-A² represents an anionic bidentate ligand, A¹ and A² each independently represent a carbon atom, an oxygen atom or a nitrogen atom, and these atoms may be ring-constituent atoms, G¹ represents a single bond, or an atomic group constituting a bidentate ligand together with A¹ and A², when a plurality of A¹-G¹-A² are present, they may be the same or different, 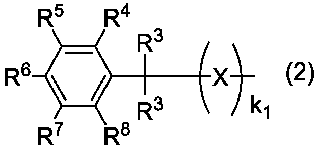 wherein,
R³ represents an alkyl group or an aryl group, and these groups optionally have a substituent, a plurality of R³ may be the same or different, R³ and R⁴, and R³ and R⁸ each may form a ring together with carbon atoms to which they are attached,
R⁴, R⁵, R⁶, R⁷ and R⁸ each independently represent a hydrogen atom, an alkyl group, a cycloalkyl group, an alkoxy group, a cycloalkoxy group, an aryl group, an aryloxy group, a monovalent hetero ring group, a substituted amino group or a halogen atom, and these groups optionally have a substituent, when a plurality of R⁴, R⁵, R⁶, R⁷ and R⁸ are present, they may be the same or different at each occurrence, R⁴ and R⁵, R⁵ and R⁶, R⁶ and R⁷, and R⁷ and R⁸ each may be combined together to form a ring together with carbon atoms to which they are attached,
X represents -C(R⁹)₂-, an arylene group or a divalent hetero ring group, and these groups optionally have a substituent, R⁹ represents an alkyl group or an aryl group, and these groups optionally have a substituent, a plurality of R⁹ may be the same or different, when a plurality of X are present, they may be the same or different,
k₁ represents an integer of 0 to 3,
when said metal complex represented by the formula (1-A) has only one type of said group represented by the formula (2), the requirement (i) is satisfied,
(i) the fact that one of R³ is a phenyl group optionally having a substituent, R⁴ is a hydrogen atom, and the R³ and the R⁴ are combined to form a fluorene ring is not satisfied; and, at least one of R³ is an alkyl group optionally having a substituent.

2. The metal complex according to Claim 1, wherein said metal complex represented by the formula (1-A) is a metal complex represented by the formula (1-A1), the formula (1-A2), the formula (1-A3), the formula (1-A4), the formula (1-A5), the formula (1-A6), the formula (1-A7), the formula (1-A8), the formula (1-A9) or the formula (1-A10) : 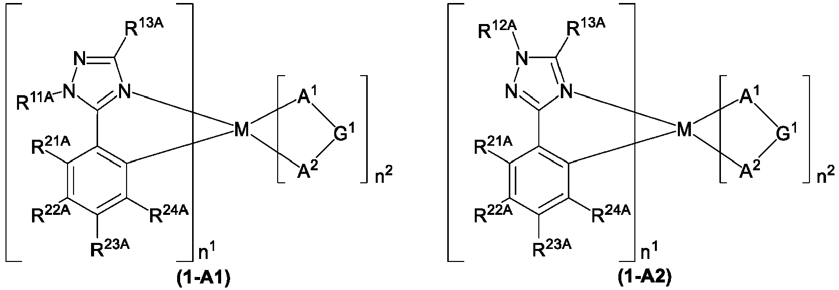 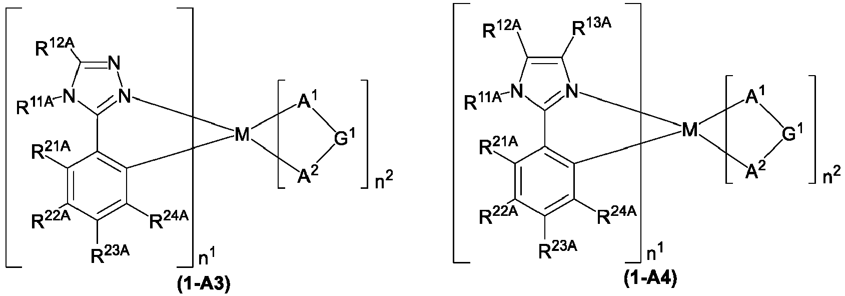 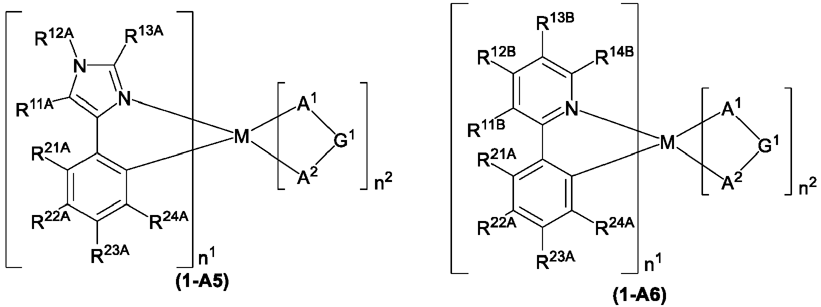 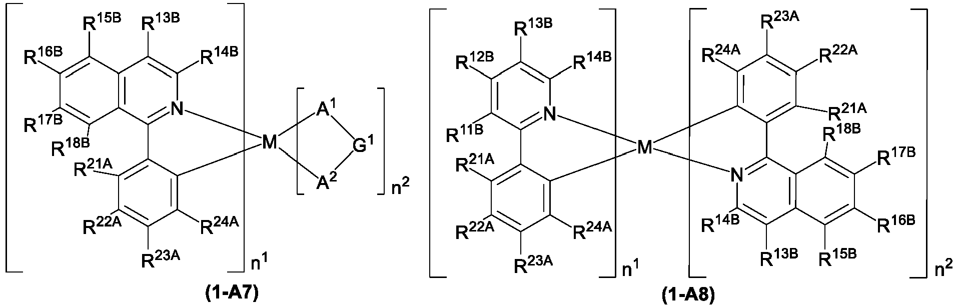 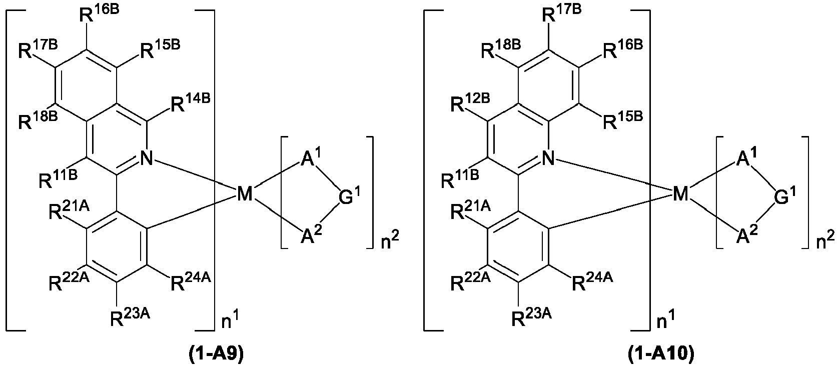 wherein, M, n¹, n², R^{21A}, R^{22A}, R^{23A}, R^{24A} and A¹-G¹-A² represent the same meaning as described above,
R^{11A}, R^{12A}, R^{13A}, R^{11B}, R^{12B}, R^{13B}, R^{14B}, R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group, a monovalent hetero ring group, a substituted amino group, a halogen atom or said group represented by the formula (2), and these groups optionally have a substituent, when a plurality of R^{11A}, R^{12A}, R^{13A}, R^{11B}, R^{12B}, R^{13B}, R^{14B}, R^{15B}, R^{16B}, R^{17B} and R^{18B} are present, they may be the same or different at each occurrence, R^{11A} and R^{12A}, R^{12A} and R^{13A}, R^{11B} and R^{12B}, R^{12B} and R^{13B}, R^{13B} and R^{14B}, R^{13B} and R^{15B}, R^{15B} and R^{16B}, R^{16B} and R^{17B}, R^{17B} and R^{18B}, R^{11B} and R^{18B}, R^{14B} and R^{15B}, and R^{12B} and R^{18B} each may be combined together to form a ring together with atoms to which they are attached,
the ligand of which number is defined by the suffix n¹ has said group represented by the formula (2), when said metal complex represented by the formula (1-A) has only one type of said group represented by the formula (2), said the requirement (i) is satisfied.

3. The metal complex according to Claim 1 or 2, wherein in said formula (2), X is an arylene group optionally having a substituent or a divalent hetero ring group optionally having a substituent.

4. The metal complex according to any one of Claims 1 to 3, wherein in said formula (2), two R³ are alkyl groups optionally having a substituent.

5. The metal complex according to any one of Claims 1 to 4, wherein in said formula (2), neither R³ and R⁴, nor R³ and R⁸ form a ring together with carbon atoms to which they are attached.

6. A composition comprising at least one selected from the group consisting of a compound represented by the formula (H-1) and a polymer compound containing a constitutional unit represented by the formula (Y), and the metal complex as described in any one of Claims 1 to 5: 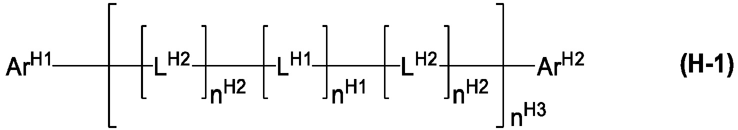 wherein,
Ar^{H1} and Ar^{H2} each independently represent an aryl group or a monovalent hetero ring group, and these groups optionally have a substituent,
n^{H1} and n^{H2} each independently represent 0 or 1, when a plurality of n^{H1} are present, they may be the same or different, a plurality of n^{H2} may be the same or different,
n^{H3} represents an integer of 0 or more,
L^{H1} represents an arylene group, a divalent hetero ring group, or a group represented by -[C(R^{H11})₂]n^{H11}-, and these groups optionally have a substituent, when a plurality of L^{H1} are present, they may be the same or different, n^{H11} represents an integer of 1 or more and 10 or less, R^{H11} represents a hydrogen atom, an alkyl group, a cycloalkyl group, an alkoxy group, a cycloalkoxy group, an aryl group or a monovalent hetero ring group, and these groups optionally have a substituent, a plurality of R^{H11} may be the same or different and may be combined together to form a ring together with carbon atoms to which they are attached,
L^{H2} represents a group represented by -N(-L^{H21}-R^{H21})-, when a plurality of L^{H2} are present, they may be the same or different, L^{H21} represents a single bond, an arylene group or a divalent hetero ring group, and these groups optionally have a substituent, R^{H21} represents a hydrogen atom, an alkyl group, a cycloalkyl group, an aryl group or a monovalent hetero ring group, and these groups optionally have a substituent, 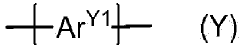 wherein, Ar^{Y1} represents an arylene group, a divalent hetero ring group, or a divalent group in which an arylene group and a divalent hetero ring group are bonded directly, and these groups optionally have a substituent.

7. A composition comprising at least one material selected from the group consisting of a hole transporting material, a hole injection material, an electron transporting material, an electron injection material, a light emitting material, an antioxidant and a solvent, and the metal complex as described in any one of Claims 1 to 5.

8. A light emitting device comprising the metal complex as described in any one of Claims 1 to 5, or the composition as described in Claim 6.

## Patentansprüche

1. Metallkomplex, dargestellt durch die Formel (1-A): 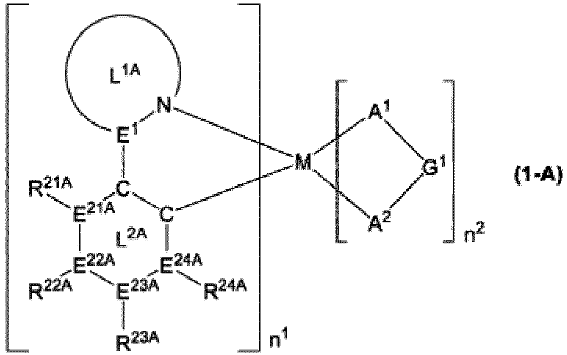 wobei
M ein Rutheniumatom, ein Rhodiumatom, ein Palladiumatom, ein Iridiumatom oder ein Platinatom darstellt,
n¹ eine ganze Zahl von 1 oder mehr darstellt und n² eine ganze Zahl von 0 oder mehr darstellt, n¹ + n² 3 ist, wenn M ein Rutheniumatom, ein Rhodiumatom oder ein Iridiumatom ist, während n¹ + n² 2 ist, wenn M ein Palladiumatom oder ein Platinatom ist,
E¹ ein Stickstoffatom oder ein Kohlenstoffatom darstellt, wobei, wenn eine Vielzahl von E¹ vorhanden ist, diese bei jedem Auftreten gleich oder verschieden sein können,
Ring L^{1A} einen Pyridinring, einen Diazabenzenring, einen Azanaphthalinring, einen Diazanaphthalinring, einen Triazolring oder einen Diazolring darstellt und diese Ringe optional einen Substituenten aufweisen, wenn eine Vielzahl der Substituenten vorhanden ist, können sie zusammen mit den Atomen, an die sie gebunden sind, zu einem Ring kombiniert werden, wenn eine Vielzahl von Ring L^{1A} vorhanden ist, können sie gleich oder verschieden sein,
E^{21A}, E^{22A}, E^{23A} und E^{24A} jeweils unabhängig voneinander ein Stickstoffatom oder ein Kohlenstoffatom darstellen, mindestens zwei von E^{21A}, E^{22A}, E^{23A} und E^{24A} Kohlenstoffatome sind, wenn eine Vielzahl von E^{21A}, E^{22A}, E^{23A} und E^{24A} vorhanden ist, können sie bei jedem Auftreten gleich oder verschieden sein, wenn E^{21A} ein Stickstoffatom ist, R^{21A} nicht vorhanden ist, wenn E^{22A} ein Stickstoffatom ist, R^{22A} nicht vorhanden ist, wenn E^{23A} ein Stickstoffatom ist, R^{23A} nicht vorhanden ist, wenn E^{24A} ein Stickstoffatom ist, R^{24A} nicht vorhanden ist,
R^{21A}, R^{22A}, R^{23A} und R^{24A} jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe, ein Halogenatom oder die Gruppe der Formel (2) darstellen, und diese Gruppen optional einen Substituenten aufweisen, wenn eine Vielzahl von R^{21A}, R^{22A}, R^{23A} und R^{24A} vorhanden ist, sie bei jedem Auftreten gleich oder verschieden sein können, R^{21A} und R^{22A}, R^{22A} und R^{23A} und R^{23A} und R^{24A} jeweils miteinander kombiniert werden können, um zusammen mit Atomen, an die sie gebunden sind, einen Ring zu bilden,
Ring L^{1A} die durch die Formel (2) dargestellte Gruppe als Substituent aufweist, oder mindestens einer der Reste R^{21A}, R^{22A}, R^{23A} und R^{24A} die durch die Formel (2) dargestellte Gruppe ist,
A¹-G¹-A² einen anionischen zweizähnigen Liganden darstellt, A¹ und A² jeweils unabhängig voneinander ein Kohlenstoffatom, ein Sauerstoffatom oder ein Stickstoffatom darstellen und diese Atome Ringkonstituenten sein können, G¹ eine Einfachbindung oder eine Atomgruppe darstellt, die zusammen mit A¹ und A² einen zweizähnigen Liganden bildet, wenn mehrere A¹-G¹-A² vorhanden sind, sie gleich oder verschieden sein können, 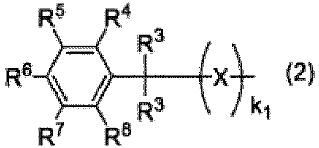 wobei
R³ eine Alkylgruppe oder eine Arylgruppe darstellt und diese Gruppen optional einen Substituenten aufweisen, eine Vielzahl von R³ gleich oder verschieden sein kann, R³ und R⁴ und R³ und R⁸ jeweils zusammen mit Kohlenstoffatomen, an die sie gebunden sind, einen Ring bilden können,
R⁴, R⁵, R⁶, R⁷ und R⁸ jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe oder ein Halogenatom darstellen, und diese Gruppen optional einen Substituenten aufweisen, wenn eine Vielzahl von R⁴, R⁵, R⁶, R⁷ und R⁸ vorhanden ist, sie bei jedem Auftreten gleich oder verschieden sein können, R⁴ und R⁵, R⁵ und R⁶, R⁶ und R⁷ und R⁷ und R⁸ jeweils zusammen mit Kohlenstoffatomen, an die sie gebunden sind, zu einem Ring kombiniert werden können,
X -C(R⁹)₂-, eine Arylengruppe oder eine zweiwertige Heteroringgruppe darstellt und diese Gruppen optional einen Substituenten aufweisen, R⁹ eine Alkylgruppe oder eine Arylgruppe darstellt und diese Gruppen optional einen Substituenten aufweisen, eine Vielzahl von R⁹ gleich oder verschieden sein kann, wenn eine Vielzahl von X vorhanden ist, sie gleich oder verschieden sein können,
k₁ eine ganze Zahl von 0 bis 3 darstellt,
wenn der durch die Formel (1-A) dargestellte Metallkomplex nur einen Typ der durch die Formel (2) dargestellten Gruppe aufweist, die Bedingung (i) erfüllt ist,
(i) die Tatsache, dass einer der Reste R³ eine Phenylgruppe ist, die optional einen Substituenten aufweist, R⁴ ein Wasserstoffatom ist und R³ und R⁴ zu einem Fluorenring verbunden sind, nicht erfüllt ist; und mindestens einer der Reste R³ eine Alkylgruppe ist, die optional einen Substituenten aufweist.

2. Metallkomplex nach Anspruch 1, wobei der durch die Formel (1-A) dargestellte Metallkomplex ein Metallkomplex ist, der durch die Formel (1-A1), die Formel (1-A2), die Formel (1-A3), die Formel (1-A4), die Formel (1-A5), die Formel (1-A6), die Formel (1-A7), die Formel (1-A8), die Formel (1-A9) oder die Formel (1-A10) dargestellt wird: 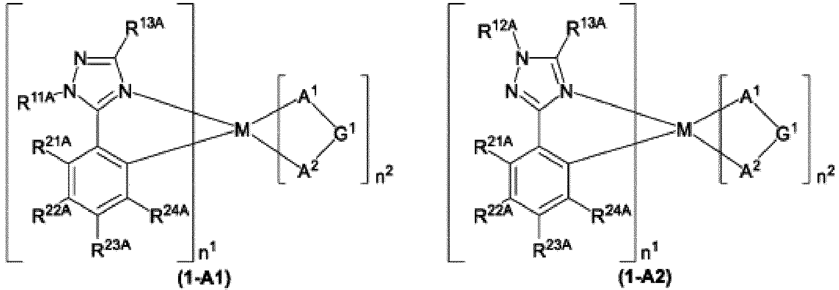 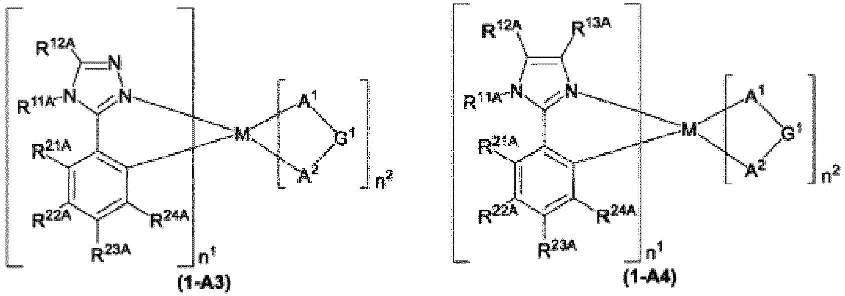 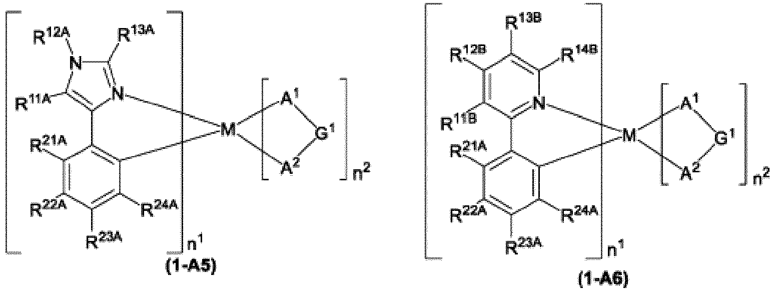 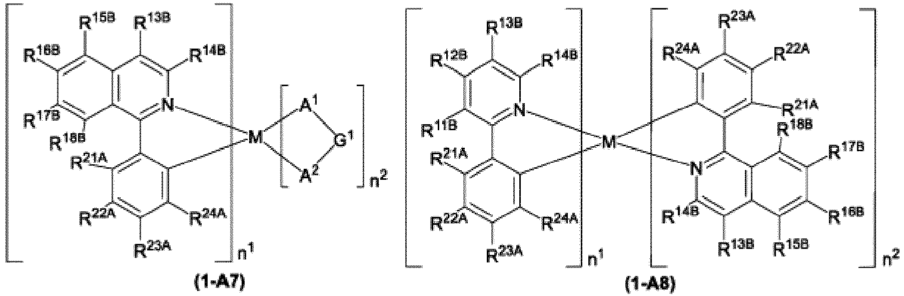 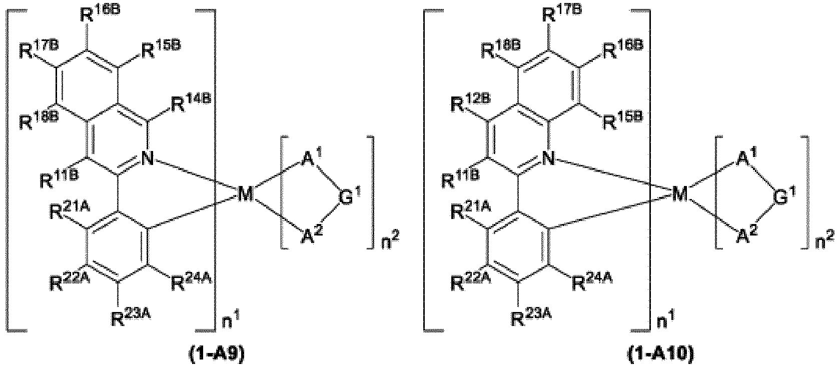
wobei M, n¹, n², R^{21A}, R^{22A}, R^{23A}, R^{24A} und A¹-G¹-A² die gleiche Bedeutung wie oben beschrieben haben,
R^{11A}, R^{12A}, R^{13A}, R^{11B}, R^{12B}, R^{13B}, R^{14B}, R^{15B}, R^{16B}, R^{17B} und R^{18B} jeweils unabhängig voneinander ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige Heteroringgruppe, eine substituierte Aminogruppe, ein Halogenatom oder die Gruppe der Formel (2) darstellen, und diese Gruppen optional einen Substituenten aufweisen, wenn eine Vielzahl von R^{11A}, R^{12A}, R^{13A}, R^{11B}, R^{12B}, R^{13B}, R^{14B}, R^{15B}, R^{16B}, R^{17B} und R^{18B} vorhanden ist, sie bei jedem Auftreten gleich oder verschieden sein können, R^{11A} und R^{12A}, R^{12A} und R^{13A}, R^{11B} und R^{12B}, R^{12B} und R^{13B}, R^{13B} und R^{14B}, R^{13B} und R^{15B}, R^{15B} und R^{16B}, R^{16B} und R^{17B}, R^{17B} und R^{18B}, R^{11B} und R^{18B}, R^{14B} und R^{15B} und R^{12B} und R^{18B} jeweils zusammen mit den Atomen, an die sie gebunden sind, zu einem Ring kombiniert werden können,
der Ligand, dessen Zahl durch das Suffix n¹ definiert ist, die durch die Formel (2) dargestellte Gruppe aufweist, wenn der durch die Formel (1-A) dargestellte Metallkomplex nur einen Typ der durch die Formel (2) dargestellten Gruppe aufweist, die Bedingung (i) erfüllt ist.

3. Metallkomplex nach Anspruch 1 oder 2, wobei in der Formel (2) X eine Arylengruppe, die optional einen Substituenten aufweist, oder eine zweiwertige Heteroringgruppe, die optional einen Substituenten aufweist, ist.

4. Metallkomplex nach einem der Ansprüche 1 bis 3, wobei in der Formel (2) zwei R³ Alkylgruppen sind, die optional einen Substituenten aufweisen.

5. Metallkomplex nach einem der Ansprüche 1 bis 4, wobei in der Formel (2) weder R³ und R⁴, noch R³ und R⁸ zusammen mit den Kohlenstoffatomen, an die sie gebunden sind, einen Ring bilden.

6. Zusammensetzung, umfassend mindestens eine Verbindung, ausgewählt aus der Gruppe, bestehend aus einer Verbindung, dargestellt durch die Formel (H-1), und einer Polymerverbindung, enthaltend eine konstitutionelle Einheit, dargestellt durch die Formel (Y), und den Metallkomplex, wie in einem der Ansprüche 1 bis 5 beschrieben: 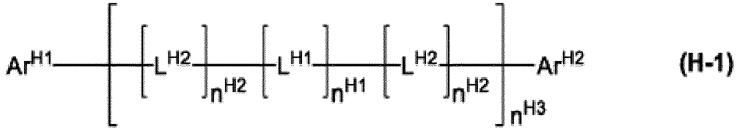 wobei
Ar^{H1} und Ar^{H2} jeweils unabhängig voneinander eine Arylgruppe oder eine einwertige Heteroringgruppe darstellen und diese Gruppen optional einen Substituenten aufweisen,
n^{H1} und n^{H2} jeweils unabhängig voneinander 0 oder 1 darstellen, wenn eine Vielzahl von n^{H1} vorhanden ist, sie gleich oder verschieden sein können, eine Vielzahl von n^{H2} gleich oder verschieden sein kann,
n^{H3} eine ganze Zahl von 0 oder mehr darstellt,
L^{H1} eine Arylengruppe, eine zweiwertige Heteroringgruppe oder eine durch - [C(R^{H11})₂]n^{H11}- dargestellte Gruppe darstellt, und diese Gruppen optional einen Substituenten aufweisen, wenn eine Vielzahl von L^{H1} vorhanden ist, sie gleich oder verschieden sein können, n^{H11} eine ganze Zahl von 1 oder mehr und oder weniger darstellt, R^{H11} ein Wasserstoffatom, eine Alkylgruppe, eine Cycloalkylgruppe, eine Alkoxygruppe, eine Cycloalkoxygruppe, eine Arylgruppe oder eine einwertige Heteroringgruppe darstellt, und diese Gruppen optional einen Substituenten aufweisen, eine Vielzahl von R^{H11} gleich oder verschieden sein kann und zusammen mit Kohlenstoffatomen, an die sie gebunden sind, zu einem Ring kombiniert werden kann,
L^{H2} eine Gruppe darstellt, die durch -N(-L^{H21}-R^{H21})- dargestellt wird, wenn eine Vielzahl von L^{H2} vorhanden ist, sie gleich oder verschieden sein können, L^{H21} eine Einfachbindung, eine Arylengruppe oder eine zweiwertige Heteroringgruppe darstellt, und diese Gruppen optional einen Substituenten aufweisen, R^{H21} ein Wasserstoffatom, eine Alkylgruppe, eine Cycloalkylgruppe, eine Arylgruppe oder eine einwertige Heteroringgruppe darstellt, und diese Gruppen optional einen Substituenten aufweisen, 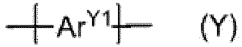
wobei Ar^{Y1} eine Arylengruppe, eine zweiwertige Heteroringgruppe oder eine zweiwertige Gruppe darstellt, in der eine Arylengruppe und eine zweiwertige Heteroringgruppe direkt gebunden sind, und diese Gruppen optional einen Substituenten aufweisen.

7. Zusammensetzung, die Folgendes umfasst: mindestens ein Material, das aus der Gruppe ausgewählt ist, die aus einem Lochtransportmaterial, einem Lochinjektionsmaterial, einem Elektronentransportmaterial, einem Elektroneninjektionsmaterial, einem lichtemittierenden Material, einem Antioxidationsmittel und einem Lösungsmittel besteht, und den Metallkomplex, wie in einem der Ansprüche 1 bis 5 beschrieben.

8. Lichtemittierende Vorrichtung, die den Metallkomplex nach einem der Ansprüche 1 bis 5 oder die Zusammensetzung nach Anspruch 6 umfasst.

## Revendications

1. Complexe métallique représenté par la formule (1-A) : 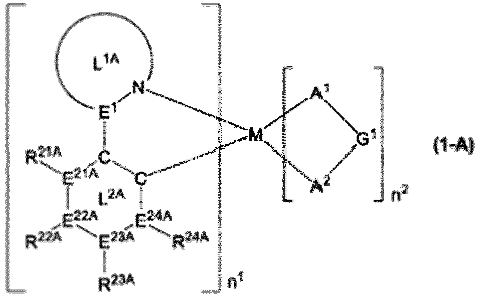 dans laquelle
M représente un atome de ruthénium, un atome de rhodium, un atome de palladium, un atome d'iridium ou un atome de platine,
n¹ représente un nombre entier valant 1 ou plus, et n² représente un nombre entier valant 0 ou plus, n¹+n² vaut 3 lorsque M est un atome de ruthénium, un atome de rhodium ou un atome d'iridium, tandis que n¹+n² vaut 2 lorsque M est un atome de palladium ou un atome de platine,
E¹ représente un atome d'azote ou un atome de carbone ; lorsqu'une pluralité d'E¹ sont présents, ils peuvent être identiques ou différents à chaque occurrence,
le cycle L^{1A} représente un cycle pyridine, un cycle diazabenzène, un cycle azanaphtalène, un cycle diazanaphtalène, un cycle triazole ou un cycle diazole, et ces cycles ont facultativement un substituant ; lorsqu'une pluralité de substituants sont présents, ils peuvent être combinés ensemble pour former un cycle avec les atomes auxquels ils sont attachés ; lorsqu'une pluralité de cycles L^{1A} sont présents, ils peuvent être identiques ou différents,
E^{21A}, E^{22A}, E^{23A} et E^{24A} représentent chacun indépendamment un atome d'azote ou un atome de carbone ; au moins deux atomes parmi E^{21A}, E^{22A}, E^{23A} et E^{24A} sont des atomes de carbone ; lorsqu'une pluralité d'E^{21A}, E^{22A}, E^{23A} et E^{24A} sont présents, ils peuvent être identiques ou différents à chaque occurrence, lorsqu'E^{21A} est un atome d'azote, R^{21A} n'est pas présent, lorsqu'E^{22A} est un atome d'azote, R^{22A} n'est pas présent, lorsqu'E^{23A} est un atome d'azote, R^{23A} n'est pas présent, lorsqu'E^{24A} est un atome d'azote, R^{24A} n'est pas présent,
R^{21A}, R^{22A}, R^{23A} et R^{24A} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué, un atome d'halogène ou ledit groupe représenté par la formule (2), et ces groupes ont facultativement un substituant ; lorsqu'une pluralité de R^{21A}, R^{22A}, R^{21A} et R^{24A} sont présents, ils peuvent être identiques ou différents à chaque occurrence, R^{21A} et R^{22A}, R^{22A} et R^{23A}, et R^{23A} et R^{24A} peuvent respectivement être combinés ensemble pour former un cycle avec les atomes auxquels ils sont attachés,
le cycle L^{1A} a, comme substituant, ledit groupe représenté par la formule (2), ou au moins un des R^{21A}, R^{22A}, R^{23A} et R^{24A} est ledit groupe représenté par la formule (2),
A¹-G¹-A² représente un ligand bidenté anionique, A¹ et A² représentent chacun indépendamment un atome de carbone, un atome d'oxygène ou un atome d'azote, et ces atomes peuvent être des atomes constitutifs du cycle, G¹ représente une liaison simple, ou un groupe atomique constituant un ligand bidenté avec A¹ et A² ; lorsqu'une pluralité de A¹-G¹-A² sont présents, ils peuvent être identiques ou différents, 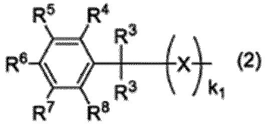 dans laquelle
R³ représente un groupe alkyle ou un groupe aryle, et ces groupes ont facultativement un substituant, une pluralité de R³ peuvent être identiques ou différents, R³ et R⁴, et R³ et R⁸ peuvent respectivement former un cycle avec les atomes de carbone auxquels ils sont attachés,
R⁴, R⁵, R⁶, R⁷ et R⁸ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué ou un atome d'halogène, et ces groupes ont facultativement un substituant ; lorsqu'une pluralité de R⁴, R⁵, R⁶, R⁷ et R⁸ sont présents, ils peuvent être identiques ou différents à chaque occurrence, R⁴ et R⁵, R⁵ et R⁶, R⁶ et R⁷, et R⁷ et R⁸ peuvent respectivement être combinés ensemble pour former un cycle avec les atomes de carbone auxquels ils sont attachés,
X représente -C(R⁹)₂-, un groupe arylène ou un groupe hétérocyclique divalent, et ces groupes ont facultativement un substituant, R⁹ représente un groupe alkyle ou un groupe aryle, et ces groupes ont facultativement un substituant, une pluralité de R⁹ peuvent être identiques ou différents ; lorsqu'une pluralité de X sont présents, ils peuvent être identiques ou différents,
k₁ représente un nombre entier valant 0 à 3,
lorsque ledit complexe métallique représenté par la formule (1-A) n'a qu'un seul type dudit groupe représenté par la formule (2), la condition (i) est satisfaite,
(i) le fait que l'un des R³ soit un groupe phényle ayant facultativement un substituant, que le R⁴ soit un atome d'hydrogène et que le R³ et le R⁴ soient combinés pour former un cycle fluorène n'est pas satisfait ; et au moins l'un des R³ est un groupe alkyle ayant facultativement un substituant.

2. Complexe métallique selon la revendication 1, dans lequel ledit complexe métallique représenté par la formule (1-A) est un complexe métallique représenté par la formule (1-A1), la formule (1-A2), la formule (1-A3), la formule (1-A4), la formule (1-A5), la formule (1-A6), la formule (1- A7), la formule (1-A8), la formule (1-A9) ou la formule (1-A10) : 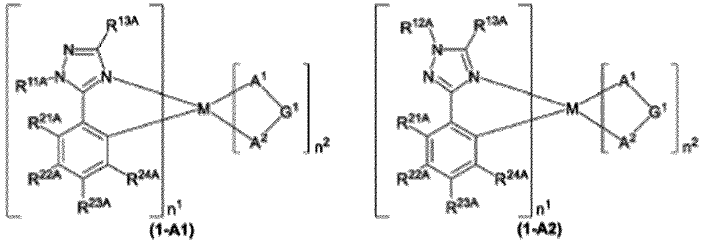 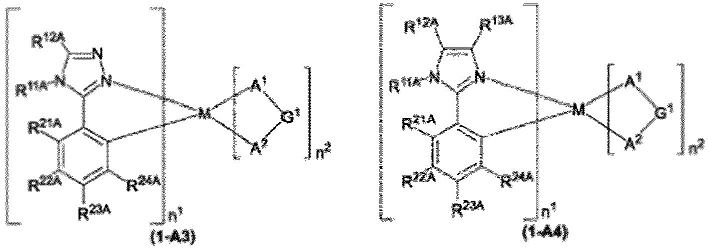 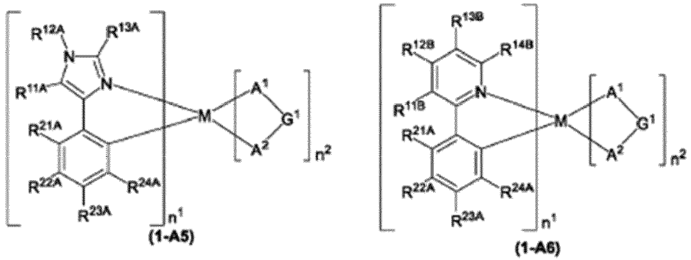 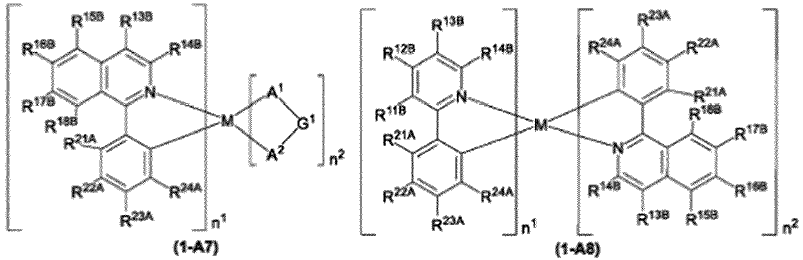 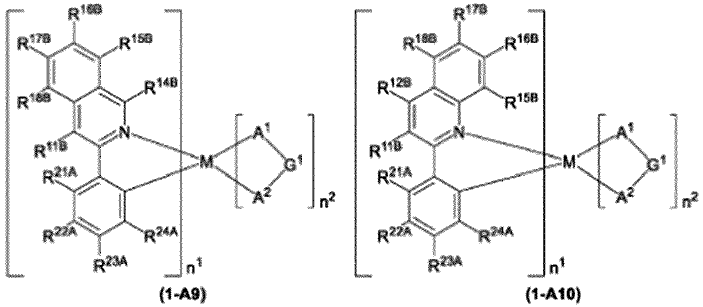 dans lesquelles M, n¹, n², R^{21A}, R^{22A}, R^{23A}, R^{24A} et A¹ -G¹-A² ont la même définition que celle donnée ci-dessus,
R^{11A}, R^{12A}, R^{13A}, R^{11B}, R^{12B}, R^{13B}, R^{14B}, R^{15B}, R^{16B}, R^{17B} et R^{18B} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un groupe amino substitué, un atome d'halogène ou ledit groupe représenté par la formule (2), et ces groupes ont facultativement un substituant ; lorsqu'une pluralité de R^{11A}, R^{12A}, R^{13A}, R^{11B}, R^{12B}, R^{13B}, R^{14B}, R^{15B}, R^{16B}, R^{17B} et R^{18B} sont présents, ils peuvent être identiques ou différents à chaque occurrence, R^{11A} et R^{12A}, R^{12A} et R^{13A}, R^{11B} et R^{12B}, R^{12B} et R^{13B}, R^{13B} et R^{14B}, R^{13B} et R^{15B}, R^{15B} et R^{16B}, R^{16B} et R^{17B}, R^{17B} et R^{18B}, R^{11B} et R^{18B}, R^{14B} et R^{15B}, et R^{12B} et R^{18B} peuvent respectivement être combinés ensemble pour former un cycle avec les atomes auxquels ils sont attachés,
le ligand dont le numéro est défini par le suffixe n¹ possède ledit groupe représenté par la formule (2) ; lorsque ledit complexe métallique représenté par la formule (1-A) ne possède qu'un seul type dudit groupe représenté par la formule (2), la condition (i) est satisfaite.

3. Complexe métallique selon la revendication 1 ou 2, dans lequel, dans ladite formule (2), X est un groupe arylène comportant facultativement un substituant ou un groupe hétérocyclique divalent comportant facultativement un substituant.

4. Complexe métallique selon l'une quelconque des revendications 1 à 3, dans lequel, dans ladite formule (2), deux R³ sont des groupes alkyle comportant facultativement un substituant.

5. Complexe métallique selon l'une quelconque des revendications 1 à 4, dans lequel, dans ladite formule (2), ni R³ et R⁴, ni R³ et R⁸ ne forment un cycle avec les atomes de carbone auxquels ils sont attachés.

6. Composition comprenant au moins un composé choisi dans le groupe constitué par un composé représenté par la formule (H-1) et un composé polymère contenant une unité constitutionnelle représentée par la formule (Y), et le complexe métallique décrit dans l'une quelconque des revendications 1 à 5 : 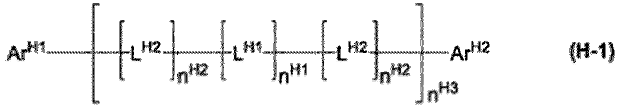 dans laquelle
Ar^{H1} et Ar^{H2} représentent chacun indépendamment un groupe aryle ou un groupe hétérocyclique monovalent, et ces groupes ont facultativement un substituant,
n^{H1} et n^{H2} représentent chacun indépendamment 0 ou 1 ; lorsqu'une pluralité de n^{H1} sont présents, ils peuvent être identiques ou différents, une pluralité de n^{H2} peuvent être identiques ou différents,
n^{H3} représente un nombre entier valant 0 ou plus,
L^{H1} représente un groupe arylène, un groupe hétérocyclique divalent, ou un groupe représenté par -[C(R^{H11})₂]n^{H11}-, et ces groupes ont facultativement un substituant ; lorsque plusieurs L^{H1} sont présents, ils peuvent être identiques ou différents, n^{H11} représente un nombre entier valant 1 ou plus et 10 ou moins, R^{H11} représente un atome d'hydrogène, un groupe alkyle, un groupe cycloalkyle, un groupe alcoxy, un groupe cycloalcoxy, un groupe aryle ou un groupe hétérocyclique monovalent, et ces groupes ont facultativement un substituant, une pluralité de R^{H11} peuvent être identiques ou différents et peuvent être combinés ensemble pour former un cycle conjointement avec les atomes de carbone auxquels ils sont attachés,
L^{H2} représente un groupe représenté par -N(-L^{H21}-R^{H21})- ; lorsqu'une pluralité de L^{H2} sont présents, ils peuvent être identiques ou différents, L^{H21} représente une liaison simple, un groupe arylène ou un groupe hétérocyclique divalent, et ces groupes ont facultativement un substituant, R^{H21} représente un atome d'hydrogène, un groupe alkyle, un groupe cycloalkyle, un groupe aryle ou un groupe hétérocyclique monovalent, et ces groupes ont facultativement un substituant, 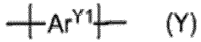
dans laquelle Ar^{Y1} représente un groupe arylène, un groupe hétérocyclique divalent ou un groupe divalent dans lequel un groupe arylène et un groupe hétérocyclique divalent sont liés directement, et ces groupes ont facultativement un substituant.

7. Composition comprenant au moins un matériau choisi dans le groupe constitué d'un matériau de transport de trous, d'un matériau d'injection de trous, d'un matériau de transport d'électrons, d'un matériau d'injection d'électrons, d'un matériau émettant de la lumière, d'un antioxydant et d'un solvant, et le complexe métallique décrit dans l'une quelconque des revendications 1 à 5.

8. Dispositif émetteur de lumière comprenant le complexe métallique décrit dans l'une quelconque des revendications 1 à 5, ou la composition décrite dans la revendication 6.
